(19) Europäisches Patentamt
European Patent Office
Office européen des brevets

(11) EP 4 026 839 A1

(12) EUROPEAN PATENT APPLICATION

(43) Date of publication:
**13.07.2022 Bulletin 2022/28**

(21) Application number: **22150507.6**

(22) Date of filing: **07.01.2022**

(51) International Patent Classification (IPC):
***C07F 15/00*** *(2006.01)* ***C09K 11/00*** *(2006.01)*
***H01L 51/50*** *(2006.01)*

(52) Cooperative Patent Classification (CPC):
**C07F 15/0086; C09K 11/00; H01L 51/0087;**
H01L 51/5016

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **11.01.2021 KR 20210003568**

(71) Applicant: **Samsung Electronics Co., Ltd.**
**Gyeonggi-do 16677 (KR)**

(72) Inventors:
- **YI, Jeoungin**
  **16678 Suwon-si (KR)**
- **KANG, Byungjoon**
  **16678 Suwon-si (KR)**
- **KWAK, Seungyeon**
  **16678 Suwon-si (KR)**
- **PARK, Sangho**
  **16678 Suwon-si (KR)**
- **SIM, Myungsun**
  **16678 Suwon-si (KR)**
- **LEE, Kum Hee**
  **16678 Suwon-si (KR)**
- **CHOI, Byoungki**
  **16678 Suwon-si (KR)**

(74) Representative: **Elkington and Fife LLP**
**Prospect House**
**8 Pembroke Road**
**Sevenoaks, Kent TN13 1XR (GB)**

(54) **ORGANOMETALLIC COMPOUND, ORGANIC LIGHT-EMITTING DEVICE INCLUDING THE SAME, AND ELECTRONIC APPARATUS INCLUDING THE ORGANIC LIGHT-EMITTING DEVICE**

(57) An organometallic compound represented by Formula 1:

Formula 1

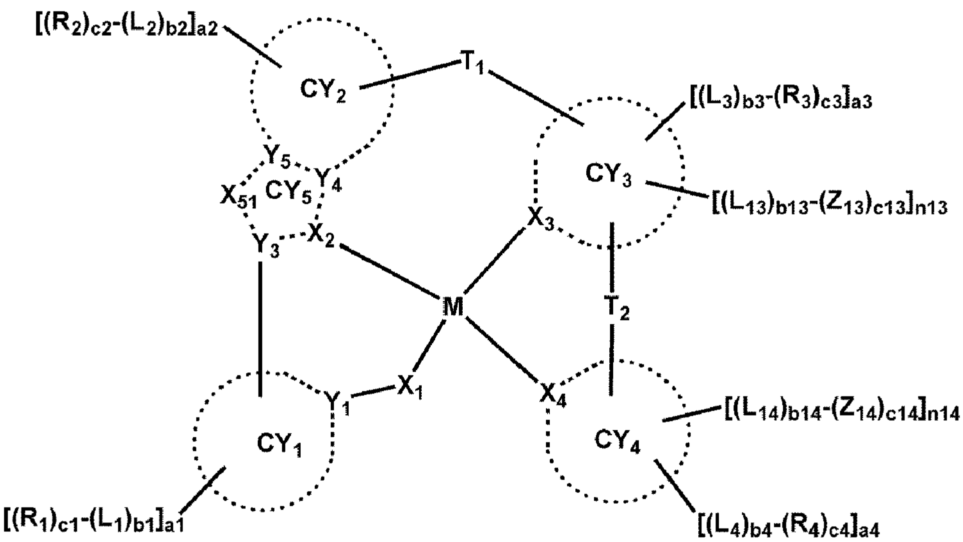

wherein M is beryllium (Be), magnesium (Mg), aluminum (Al), calcium (Ca), titanium (Ti), manganese (Mn), cobalt (Co), copper (Cu), zinc (Zn), gallium (Ga), germanium (Ge), zirconium (Zr), ruthenium (Ru), rhodium (Rh), palladium (Pd), silver (Ag), rhenium (Re), platinum (Pt), or gold (Au); and wherein ring $CY_1$ to ring $CY_5$, $X_1$ to $X_4$, $X_{51}$, $Y_1$ to $Y_5$, $R_1$ to $R_4$, $L_1$ to $L_4$, $L_7$, $L_{13}$, $L_{14}$, $T_1$, $T_2$, $Z_{13}$, $Z_{14}$, b1 to b4, b7, b13, b14, c1 to c4, c7, c13, c14, n13, and n14 are as defined herein.

EP 4 026 839 A1

# FIGURE

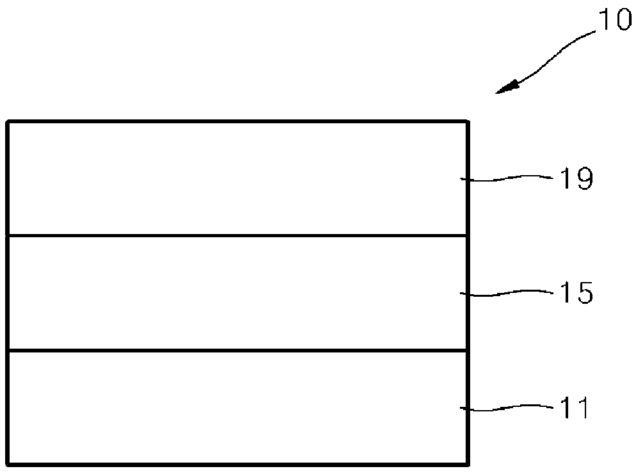

## Description

FIELD OF THE INVENTION

One or more embodiments described herein relate to an organometallic compound, an organic light-emitting device including the same, and an electronic apparatus including the organic light-emitting device.

BACKGROUND OF THE INVENTION

Organic light-emitting devices (OLEDs) are self-emissive devices, which have improved characteristics in terms of viewing angles, response time, brightness, driving voltage, and response speed. In addition, OLEDs can produce full-color images.

In an example, an organic light-emitting device includes an anode, a cathode, and an organic layer located between the anode and the cathode, wherein the organic layer includes an emission layer. A hole transport region may be located between the anode and the emission layer, and an electron transport region may be located between the emission layer and the cathode. Holes provided from the anode may move toward the emission layer through the hole transport region, and electrons provided from the cathode may move toward the emission layer through the electron transport region. The holes and the electrons may then recombine in the emission layer to produce excitons. These excitons transition from an excited state to a ground state to thereby generate light, for example visible light.

SUMMARY OF THE INVENTION

One or more embodiments described herein relate to an organometallic compound, an organic light-emitting device including the same, and an electronic apparatus including the organic light-emitting device.

Additional aspects will be set forth in part in the description, which follows and, in part, will be apparent from the description, or may be learned by practice of the presented embodiments of the disclosure.

According to one or more embodiments, provided is an organometallic compound represented by Formula 1.

Formula 1

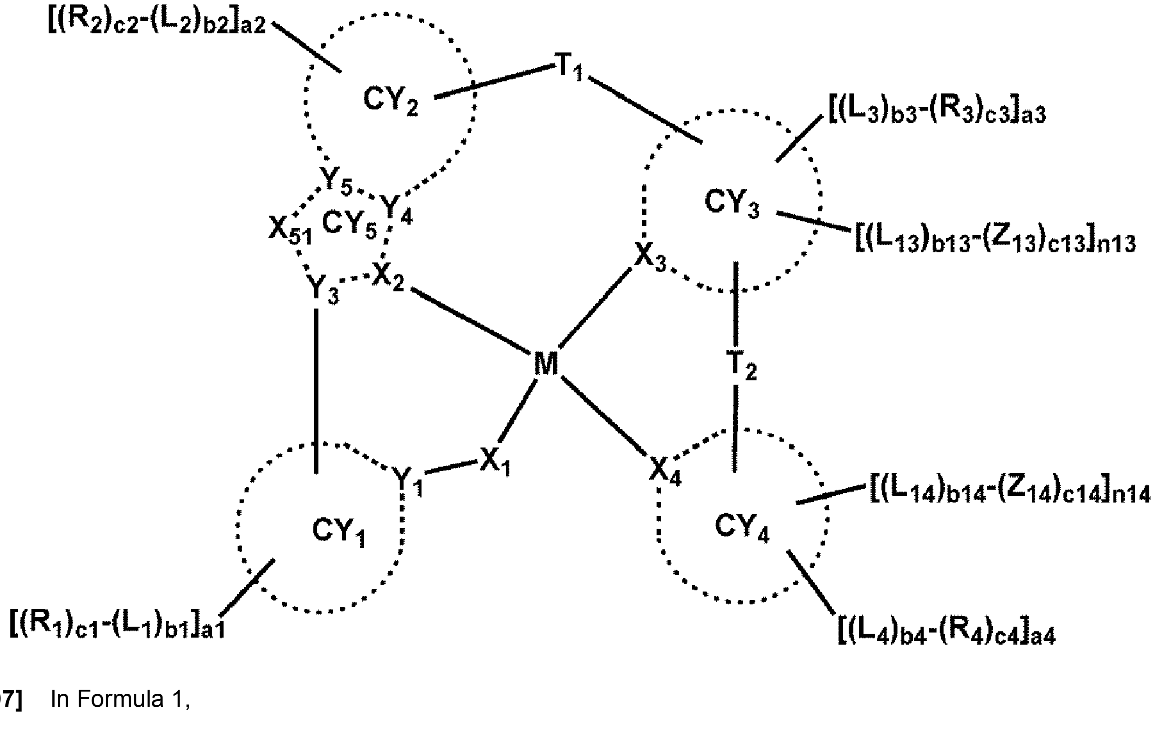

In Formula 1,

M is beryllium (Be), magnesium (Mg), aluminum (Al), calcium (Ca), titanium (Ti), manganese (Mn), cobalt (Co), copper (Cu), zinc (Zn), gallium (Ga), germanium (Ge), zirconium (Zr), ruthenium (Ru), rhodium (Rh), palladium (Pd), silver (Ag), rhenium (Re), platinum (Pt), or gold (Au),

$X_1$ is a single bond, O, S, N(R'), P(R'), B(R'), C(R')(R"), or Si(R')(R"), and when $X_1$ is a single bond, $Y_1$ is directly

bonded to M,

$X_2$ to $X_4$ are each independently C or N,

a bond between $X_1$ or $Y_1$ and M is a covalent bond,

one of a bond between $X_2$ and M, a bond between $X_3$ and M, and a bond between $X_4$ and M is a covalent bond, and the others of a bond between $X_2$ and M, a bond between $X_3$ and M, and a bond between $X_4$ and M are coordinate bonds,

$Y_1$ and $Y_3$ to $Y_5$ are each independently C or N,

$X_2$ and $Y_3$, $X_2$ and $Y_4$, $Y_4$ and $Y_5$, $X_{51}$ and $Y_3$, and $X_{51}$ and $Y_5$ are each linked through a chemical bond,

ring $CY_1$ to ring $CY_4$ may each independently be a $C_5$-$C_{30}$ carbocyclic group or a $C_1$-$C_{30}$ heterocyclic group, provided that ring $CY_1$, ring $CY_3$, and ring $CY_4$ are not a benzimidazole group,

ring $CY_5$ may be a 5-membered ring condensed with ring $CY_2$,

a cyclometalated ring group formed by ring $CY_5$, ring $CY_2$, ring $CY_3$, and M is a 6-membered ring,

$X_{51}$ is O, S, N-$[(L_7)_{b7}$-$(R_7)_{c7}]$, $C(R_7)(R_8)$, $Si(R_7)(R_8)$, $Ge(R_7)(R_8)$, C(=O), N, $C(R_7)$, $Si(R_7)$, or $Ge(R_7)$,

$R_7$ and $R_8$ may optionally be linked via a single bond, a double bond, or a first linking group to form a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$,

$T_1$ and $T_2$ are each independently a single bond, a double bond, *-N($R_9$)-*', *-B($R_9$)-*', *-P($R_9$)-*', *-C($R_{9a}$)($R_{9b}$)-*', *-Si($R_{9a}$)($R_{9b}$)-*', *-Ge($R_{9a}$)($R_{9b}$)-*', *-S-*', *-Se-*', *-O-*', *-C(=O)-*', *-S(=O)-*', *-S(=O)$_2$-*', *-C($R_9$)=*', *=C($R_9$)-*', *-C($R_{9a}$)=C($R_{9b}$)-*', *-C(=S)-*', or *-C=C-*', wherein * and *' each represent a bond to a neighboring atom,

$Z_{13}$ and $Z_{14}$ are each independently a group represented by Formula 2,

n13 and n14 may each independently be an integer from 0 to 20, and the sum of n13 and n14 may be 1 or greater,

$L_1$ to $L_4$, $L_7$, $L_{13}$, and $L_{14}$ are each independently a single bond, a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$,

b1 to b4, b7, b13, and b14 are each independently an integer from 1 to 5,

$R_1$ to $R_4$, $R_7$ to $R_9$, $R_{9a}$, $R_{9b}$, R', and R" are each independently hydrogen, deuterium, -F, -Cl, -Br, -I, -$SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, -N($Q_1$)($Q_2$), -Si($Q_3$)($Q_4$)($Q_5$), -Ge($Q_3$)($Q_4$)($Q_5$), - B($Q_6$)($Q_7$), -P(=O)($Q_6$)($Q_9$), or -P($Q_6$)($Q_9$),

c1 to c4, c7, c13, and c14 are each independently an integer from 1 to 5,

a1 to a4 are each independently an integer from 0 to 20,

two or more of a plurality of $R_1$(s) are optionally linked to form a $C_5$-$C_{30}$ carbocyclic group unsubstituted or substituted with at least one $R_{10a}$, or a C1-$C_{30}$ heterocyclic group unsubstituted or substituted with at least one $R_{10a}$,

two or more of a plurality of $R_2$(s) are optionally linked to form a $C_5$-$C_{30}$ carbocyclic group unsubstituted or substituted with at least one $R_{10a}$, or a C1-$C_{30}$ heterocyclic group unsubstituted or substituted with at least one $R_{10a}$,

two or more of a plurality of $R_3$(s) are optionally linked to form a $C_5$-$C_{30}$ carbocyclic group unsubstituted or substituted with at least one $R_{10a}$, or a C1-$C_{30}$ heterocyclic group unsubstituted or substituted with at least one $R_{10a}$,

two or more of a plurality of $R_4$(s) are optionally linked to form a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$,

two or more groups of $R_1$ to $R_4$, $R_7$ to $R_9$, $R_{9a}$, $R_{9b}$, R', and R" are optionally linked to form a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$,

$R_{10a}$ is as defined in connection with $R_1$,

Formula 2

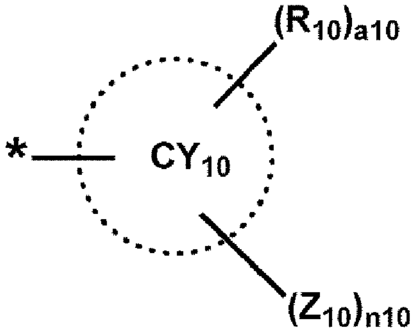

wherein, in Formula 2,

ring $CY_{10}$ is an unsaturated $C_5$-$C_{30}$ carbocyclic group or an unsaturated C1-C30 heterocyclic group,

$R_{10}$ is as defined in connection with $R_1$,

a10 is an integer from 0 to 20,

$Z_{10}$ is -F or a fluorinated group,

n10 is an integer from 1 to 20,

a substituent of the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_7$-$C_{60}$ aryl alkyl group, the substituted $C_6$-$C_{60}$ aryloxy group, the substituted $C_6$-$C_{60}$ arylthio group, the substituted $C_1$-$C_{60}$ heteroaryl group, the substituted $C_2$-$C_{60}$ alkyl heteroaryl group, the substituted $C_2$-$C_{60}$ heteroaryl alkyl group, the substituted $C_1$-$C_{60}$ heteroaryloxy group, the substituted $C_1$-$C_{60}$ heteroarylthio group, the substituted monovalent non-aromatic condensed polycyclic group, and the substituted monovalent non-aromatic condensed heteropolycyclic group is:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group;

a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group, each substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a C1-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-N(Q_{11})(Q_{12})$, $-Si(Q_{13})(Q_{14})(Q_{15})$, $-Ge(Q_{13})(Q_{14})(Q_{15})$, -$B(Q_{16})(Q_{17})$, $-P(=O)(Q_{16})(Q_{19})$, $-P(Q_{16})(Q_{19})$, or a combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a C1-$C_{60}$ heteroaryloxy group, a $C_1$-$C_{60}$ heteroarylthio group, a monovalent non-aromatic condensed polycyclic group or a monovalent non-aromatic condensed heteropolycyclic group, each unsubstituted or substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, - $Ge(Q_{23})(Q_{24})(Q_{25})$, $-B(Q_{26})(Q_{27})$, $-P(=O)(Q_{26})(Q_{29})$, $-P(Q_{28})(Q_{29})$, or a combination thereof;

$-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$, - $P(=O)(Q_{36})(Q_{39})$, or $-P(Q_{38})(Q_{39})$; or

a combination thereof,

wherein $Q_1$ to $Q_9$, $Q_{11}$ to $Q_{19}$, $Q_{21}$ to $Q_{29}$, and $Q_{31}$ to $Q_{39}$ may each independently be hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a $C_1$-$C_{60}$ alkyl group unsubstituted or substituted with deuterium, a $C_1$-$C_{60}$ alkyl group, a $C_6$-$C_{60}$ aryl group, or a combination thereof; a $C_2$-$C_{60}$ alkenyl group; a $C_2$-$C_{60}$ alkynyl group; a $C_1$-$C_{60}$ alkoxy group; a $C_1$-$C_{60}$ alkylthio group; a $C_3$-$C_{10}$ cycloalkyl group; a $C_1$-$C_{10}$ heterocycloalkyl group; a $C_3$-$C_{10}$ cycloalkenyl group; a $C_1$-$C_{10}$ heterocycloalkenyl group; a $C_6$-$C_{60}$ aryl group unsubstituted or substituted with deuterium, a $C_1$-$C_{60}$ alkyl group, a $C_6$-$C_{60}$ aryl group, or a combination thereof; a $C_6$-$C_{60}$ aryloxy group; a $C_6$-$C_{60}$ arylthio group; a $C_1$-$C_{60}$ heteroaryl group; a $C_1$-$C_{60}$ heteroaryloxy group; a $C_1$-$C_{60}$ heteroarylthio group; a monovalent non-aromatic condensed polycyclic group; or a monovalent non-aromatic condensed heteropolycyclic group.

According to one or more embodiments, provided is an organic light-emitting device including a first electrode, a second electrode, and an organic layer located between the first electrode and the second electrode, wherein the organic layer comprises an emission layer, and wherein the organic layer includes at least one organometallic compound represented by Formula 1.

The organometallic compound may be included in the emission layer of the organic layer, and the organometallic compound included in the emission layer may act as a dopant.

According to one or more embodiments, an electronic apparatus may include the organic light-emitting device.

BRIEF DESCRIPTION OF THE DRAWING

The above and other aspects, features, and advantages of certain embodiments of the disclosure will be more apparent from the following description taken in conjunction with the accompanying drawing, in which

FIGURE is a schematic cross-sectional view of an organic light-emitting device according to one or more embodiments.

DETAILED DESCRIPTION OF THE EMBODIMENTS

Reference will now be made in detail to embodiments, examples of which are illustrated in the accompanying drawings, wherein like reference numerals refer to like elements throughout the specification. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

The terminology used herein is for the purpose of describing one or more exemplary embodiments only and is not intended to be limiting. As used herein, the singular forms "a," "an," and "the" are intended to include the plural forms as well, unless the context clearly indicates otherwise. The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that when an element is referred to as being "on" another element, it can be directly in contact with the other element or intervening elements may be present therebetween. In contrast, when an element is

referred to as being "directly on" another element, there are no intervening elements present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

According to an aspect, one or more embodiments describe an organometallic compound represented by Formula 1:

Formula 1

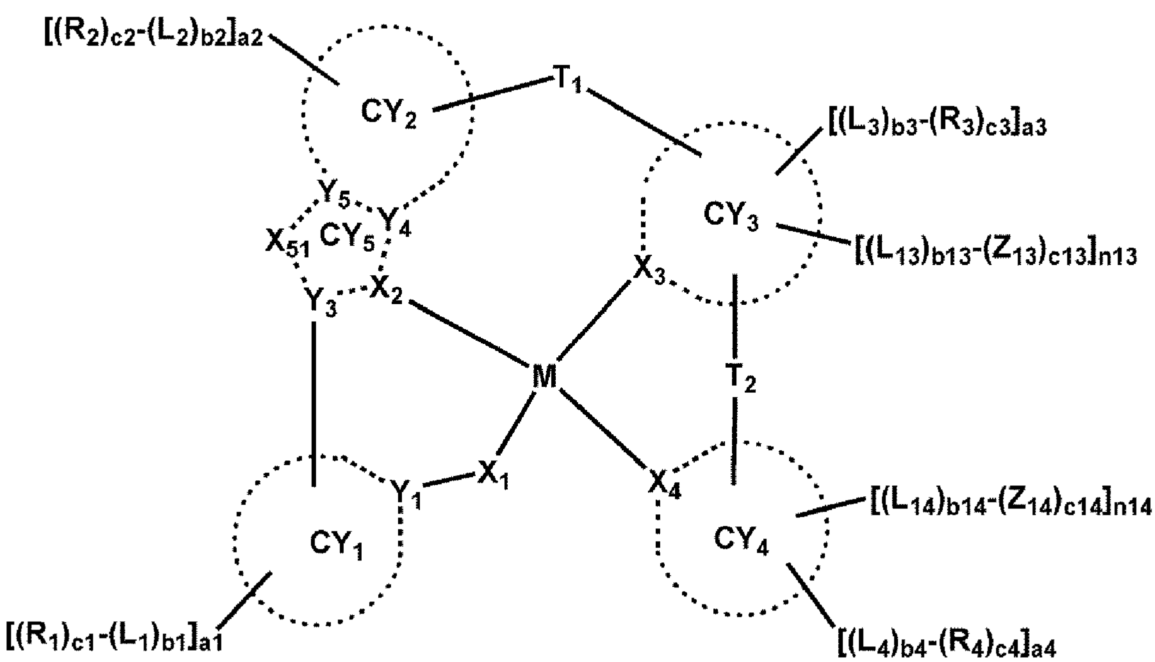

M in Formula 1 is beryllium (Be), magnesium (Mg), aluminum (Al), calcium (Ca), titanium (Ti), manganese (Mn), cobalt (Co), copper (Cu), zinc (Zn), gallium (Ga), germanium (Ge), zirconium (Zr), ruthenium (Ru), rhodium (Rh), palladium (Pd), silver (Ag), rhenium (Re), platinum (Pt), or gold (Au).

For example, M may be Pt, Pd, or Au.

$X_1$ in Formula 1 is a single bond (for example, a covalent bond), O, S, N(R'), P(R'), B(R'), C(R')(R"), or Si(R')(R"). R' and R" are each as defined above. When $X_1$ is a single bond, $Y_1$ and M are directly linked to each other.

In one or more embodiments, $X_1$ in Formula 1 may be O or S.

$X_2$ to $X_4$ in Formula 1 are each independently C or N.

For example, two of $X_2$ to $X_4$ may be N, and one may be C.

In one or more embodiments, in Formula 1, $X_2$ and $X_4$ may be N, and $X_3$ may be C.

A bond between $X_1$ or $Y_1$ and M in Formula 1 is a covalent bond. One of a bond between $X_2$ and M, a bond between $X_3$ and M, and a bond between $X_4$ and M is a covalent bond, and others of a bond between $X_2$ and M, a bond between $X_3$ and M, and a bond between $X_4$ and M are coordinate bonds. Thus, the organometallic compound represented by Formula 1 is electrically neutral.

In one or more embodiments, in Formula 1, a bond between $X_1$ or $Y_1$ and M and a bond between $X_3$ and M may each be a covalent bond, and a bond between $X_2$ and M and a bond between $X_4$ and M may be a coordinate bond.

In one or more embodiments, in Formula 1,

i) $X_2$ and $X_4$ may each be N, $X_3$ may be C, a bond between $X_2$ and M and a bond between $X_4$ and M may each be a coordinate bond, and a bond between $X_3$ and M may be a covalent bond,

ii) $X_2$ and $X_3$ may each be N, $X_4$ may be C, a bond between $X_2$ and M and a bond between $X_3$ and M may each be a coordinate bond, and a bond between $X_4$ and M may be a covalent bond, or

iii) $X_3$ and $X_4$ may be N, $X_2$ may be C, a bond between $X_3$ and M and a bond between $X_4$ and M may be a coordinate bond, and a bond between $X_2$ and M may be a covalent bond.

In Formula 1, $Y_1$ and $Y_3$ to $Y_5$ are each independently C or N.

For example, in one or more embodiments, in Formula 1, $Y_1$ and $Y_3$ to $Y_5$ may each be C.

In Formula 1, $X_2$ and $Y_3$, $X_2$ and $Y_4$, $Y_4$ and $Y_5$, $X_{51}$ and $Y_3$, and $X_{51}$ and $Y_5$ are each linked through chemical bonds. Accordingly, ring $CY_5$ in Formula 1 may be a 5-membered ring condensed with ring $CY_2$.

In Formula 1, ring $CY_1$ to ring $CY_4$ are each independently a $C_5$-$C_{30}$ carbocyclic group or a $C_1$-$C_{30}$ heterocyclic group, provided that each of ring $CY_1$, ring $CY_3$, and ring $CY_4$ is not a benzimidazole group. In addition, in formula 1, ring $CY_2$ is not a benzimidazole group. In other words, in Formula 1, each of ring $CY_1$ to ring $CY_4$ is not a benzimidazole group.

In one or more embodiments, in Formula 1, ring $CY_1$ to ring $CY_4$ may each independently be i) a first ring, ii) a second ring, iii) a condensed ring in which two or more of the first rings are condensed with each other, iv) a condensed ring in which two or more of the second rings are condensed with each other, or v) a condensed ring in which one or more of the first rings and one or more of the second rings are condensed with each other,

wherein the first ring may be a cyclopentane group, a cyclopentadiene group, a furan group, a thiophene group, a pyrrole group, a silole group, an oxazole group, an isoxazole group, an oxadiazole group, an isoxadiazole group, an oxatriazole group, an isoxatriazole group, a thiazole group, an isothiazole group, a thiadiazole group, an isothiadiazole group, a thiatriazole group, an isothiatriazole group, a pyrazole group, an imidazole group, a triazole group, a tetrazole group, an azasilole group, a diazasilole group, or a triazasilole group, and

the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

In one or more embodiments, in Formula 1, ring $CY_1$ to ring $CY_4$ may each independently be a benzene group, a naphthalene group, an anthracene group, a phenanthrene group, a triphenylene group, a pyrene group, a chrysene group, a 1,2,3,4-tetrahydronaphthalene group, a furan group, a thiophene group, a pyrrole group, a cyclopentadiene group, a silole group, a benzofuran group, a benzothiophene group, an indole group, an indene group, a benzosilole group, a dibenzofuran group, a dibenzothiophene group, a carbazole group, a fluorene group, a dibenzosilole group, an azasilole group, an azabenzofuran group, an azabenzothiophene group, an azabenzosilole group, an azadibenzofuran group, an azadibenzothiophene group, an azacarbazole group, an azafluorene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a 5,6,7,8-tetrahydroisoquinoline group, a 5,6,7,8-tetrahydroquinoline group, a benzene group condensed with norbornane, or a pyridine group condensed with norbornane.

A cyclometalated ring formed by ring $CY_5$, ring $CY_2$, ring $CY_3$, and M in Formula 1 is a 6-membered ring.

In Formula 1, $X_{51}$ is O, S, N-[$(L_7)_{b7}$-$(R_7)_{c7}$], $C(R_7)(R_8)$, $Si(R_7)(R_8)$, $Ge(R_7)(R_8)$, C(=O), N, $C(R_7)$, $Si(R_7)$, or $Ge(R_7)$. $R_7$ and $R_8$ are optionally linked via a single bond, a double bond, or a first linking group to form a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$ $L_7$, b7, $R_7$, $R_8$, and c7 are as defined herein.

The first linking group may be *-O-*', *-S-*', *-$C(R_5)(R_6)$-*', *-$C(R_5)$=*', *=$C(R_6)$-*', *-$C(R_5)$=$C(R_6)$-*', *-C(=O)-*', *-C(=S)-*', *-C=C-*', *-$N(R_5)$-*', *-$Si(R_5)(R_6)$-*', *-$P(R_5)$-*', or a combination thereof, wherein $R_5$ and $R_6$ are each as defined in connection with $R_1$, and each of * and *' indicates a binding site to a neighboring atom.

For example, in one or more embodiments, $X_{51}$ in Formula 1 may be O, S, N-[$(L_7)_{b7}$-$(R_7)_{c7}$], $C(R_7)(R_8)$, $Si(R_7)(R_8)$, $Ge(R_7)(R_8)$, or C(=O).

In one or more embodiments, $X_{51}$ in Formula 1 may be N-[$(L_7)_{b7}$-$(R_7)_{c7}$].

In one or more embodiments, in Formula 1, $X_{51}$ may be N-[$(L_7)_{b7}$-$(R_7)_{c7}$], $L_7$ may not be a single bond, c7 may be greater than or equal to 2, one of two or more $R_7$(s) may be a substituted or unsubstituted $C_4$-$C_{20}$ alkyl group (for example, a tert-butyl group, etc.), one of the remaining $R_7$ may be a substituted or unsubstituted phenyl group (for example, a phenyl group, a deuterated phenyl group, a ($C_1$-$C_{20}$ alkyl) phenyl group, etc.) or a substituted or unsubstituted biphenyl group (for example, a biphenyl group, a deuterated biphenyl group, or a ($C_1$-$C_{20}$ alkyl) biphenyl group, etc.).

In one or more embodiments, in Formula 1,

i) $Y_3$ to $Y_5$ may each be C, a bond between $X_{51}$ and $Y_3$ and a bond between $X_{51}$ and $Y_5$ may each be a single bond,

and $X_{51}$ may be O, S, N-[$(L_7)_{b7}$-$(R_7)_{c7}$], C($R_7$)($R_8$), Si($R_7$)($R_8$), Ge($R_7$)($R_8$), or C(=O),

ii) $Y_3$ and $Y_4$ may each be C, $Y_5$ may be N, a bond between $X_{51}$ and $Y_3$ may be a double bond, a bond between $X_{51}$ and $Y_5$ may be a single bond, and $X_{51}$ may be N, C($R_7$), Si($R_7$), or Ge($R_7$),

iii) $Y_3$ and $Y_5$ may each be C, $Y_4$ may be N, a bond between $X_{51}$ and $Y_3$ may be a single bond, a bond between $X_{51}$ and $Y_5$ may be a double bond, and $X_{51}$ may be N, C($R_7$), Si($R_7$), or Ge($R_7$),

iv) $Y_3$ may be N, $Y_4$ and $Y_5$ may each be C, a bond between $X_{51}$ and $Y_3$ may be a single bond, a bond between $X_{51}$ and $Y_5$ may be a double bond, and $X_{51}$ may be N, C($R_7$), Si($R_7$), or Ge($R_7$), or

v) $Y_3$ to $Y_5$ may be C, a bond between $X_{51}$ and $Y_3$ may be a double bond, a bond between $X_{51}$ and $Y_5$ may be a single bond, and $X_{51}$ may be N, C($R_7$), Si($R_7$), or Ge($R_7$).

In one or more embodiments, in Formula 1, $Y_3$ to $Y_5$ may be C; a bond between $X_{51}$ and $Y_3$ and a bond between $X_{51}$ and $Y_5$ each may be a single bond; and $X_{51}$ may be O, S, N-[$(L_7)_{b7}$-$(R_7)_{c7}$], C($R_7$)($R_8$), Si($R_7$)($R_8$), Ge($R_7$)($R_8$), or C(=O).

$T_1$ and $T_2$ in Formula 1 are each independently a single bond, a double bond, *-N($R_9$)-*', *-B($R_9$)-*', *-P($R_9$)-*', *-C($R_{9a}$)($R_{9b}$)-*', *-Si($R_{9a}$)($R_{9b}$)-*', *-Ge($R_{9a}$)($R_{9b}$)-*', *-S-*', *-Se-*', *-0-*1', *-C(=O)-*', *-S(=O)-*', *-S(=O)$_2$-*', *-C($R_9$)=*', *=C($R_9$)-*', *-C($R_{9a}$)=C($R_{9b}$)-*', *-C(=S)-*', or *-C=C-*', wherein * and *' each represent a bond to a neighboring atom. $R_{9a}$ and $R_{9b}$ are optionally linked via a single bond, a double bond, or a second linking group to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$ The second linking group is as defined in connection with the first linking group.

In one or more embodiments, $T_1$ and $T_2$ in Formula 1 may be a single bond.

In Formula 1, $Z_{13}$ and $Z_{14}$ are each independently a group represented by Formula 2:

Formula 2

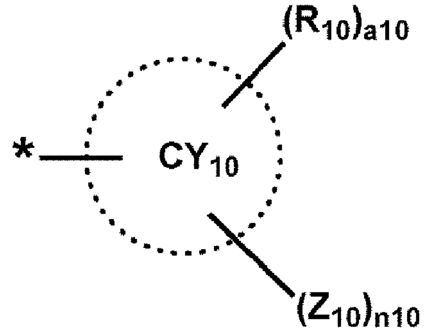

Ring $CY_{10}$ in Formula 2 is an unsaturated $C_5$-$C_{30}$ carbocyclic group or an unsaturated $C_1$-$C_{30}$ heterocyclic group.

In one or more embodiments, ring $CY_{10}$ in Formula 2 may be a benzene group, a naphthalene group, a fluorene group, a phenanthrene group, an anthracene group, a fluoranthene group, a triphenylene group, a pyrene group, a chrysene group, a pyrrole group, a thiophene group, a furan group, an imidazole group, a pyrazole group, a thiazole group, an isothiazole group, an oxazole group, an isoxazole group, a pyridine group, a pyrazine group, a pyrimidine group, a pyridazine group, an isoindole group, an indole group, an indazole group, a purine group, a quinoline group, an isoquinoline group, a benzoquinoline group, a quinoxaline group, a quinazoline group, a cinnoline group, a carbazole group, a phenanthroline group, a benzimidazole group, a benzofuran group, a benzothiophene group, a benzisothiazole group, a benzoxazole group, a benzoisoxazole group, a triazole group, a tetrazole group, an oxadiazole group, a triazine group, a dibenzofuran group, a dibenzothiophene group, a benzocarbazole group, a dibenzocarbazole group, an imidazopyridine group, an imidazopyrimidine group, an azacarbazole group, an azadibenzofuran group, or an azadibenzothiophene group.

In one or more embodiments, ring $CY_{10}$ in Formula 2 may be a benzene group, a naphthalene group, a dibenzofuran group, or a dibenzothiophene group.

$R_{10}$ in Formula 2 is as defined in connection with $R_1$

For example, in Formula 2, $R_{10}$ may be:

deuterium, -CN, -Si($Q_3$)($Q_4$)($Q_5$), or -Ge($Q_3$)($Q_4$)($Q_5$); or

a $C_1$-$C_{20}$ alkyl group or $C_3$-$C_{10}$ cycloalkyl group, each unsubstituted or substituted with deuterium, -CN, a $C_1$-$C_{20}$ alkyl group, a deuterated $C_1$-$C_{20}$ alkyl group, a $C_3$-$C_{10}$ cycloalkyl group, a deuterated $C_3$-$C_{10}$ cycloalkyl group, a ($C_1$-$C_{20}$ alkyl) $C_3$-$C_{10}$ cycloalkyl group, or a combination thereof.

In Formula 2, a10 indicates the number of $R_{10}$(s) and is an integer from 0 to 20. When a10 is 2 or greater, two or more of $R_{10}$(s) are identical to or different from each other. For example, a10 may be an integer from 0 to 5.

$Z_{10}$ in Formula 2 is a fluoro group (-F) or a fluorinated group. As used herein, the "fluorinated group" refers to a group that is substituted with at least one fluoro group (-F).

For example, in Formula 2, $Z_{10}$ may be

-F; or

a fluorinated $C_1$-$C_{20}$ alkyl group, a fluorinated phenyl group, or a fluorinated biphenyl group, each unsubstituted or substituted with deuterium, a $C_1$-$C_{20}$ alkyl group, a deuterated $C_1$-$C_{20}$ alkyl group, a phenyl group, a deuterated phenyl group, a ($C_1$-$C_{20}$ alkyl) phenyl group, a biphenyl group, a deuterated biphenyl group, a ($C_1$-$C_{20}$ alkyl) biphenyl group, or a combination thereof.

In Formula 2, n10 indicates the number of $Z_{10}$(s) and is an integer from 1 to 20. Thus, a group represented by Formula 2 may include at least one $Z_{10}$ as defined herein. When n10 is 2 or greater, two or more of $Z_{10}$(s) are identical to or different from each other. For example, n10 may be an integer from 1 to 5.

In one or more embodiments, a group represented by Formula 2 may be a group represented by one of Formulae 2-1 to 2-42:

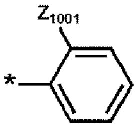
2-1

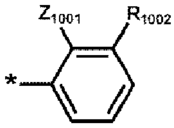
2-2

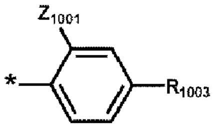
2-3

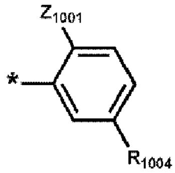
2-4

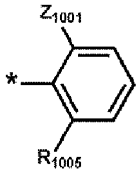
2-5

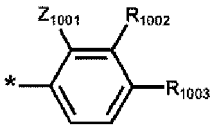
2-6

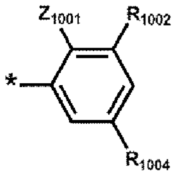
2-7

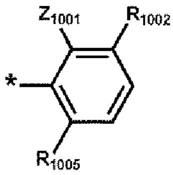
2-8

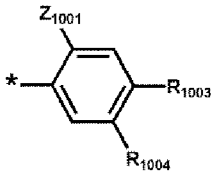
2-9

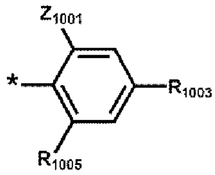
2-10

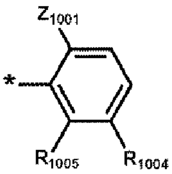
2-11

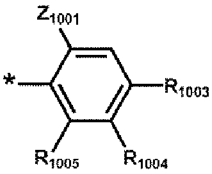
2-12

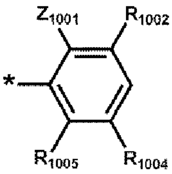
2-13

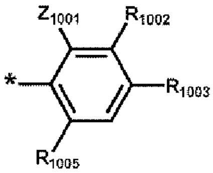
2-14

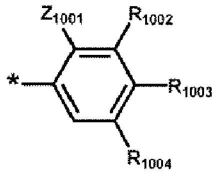
2-15

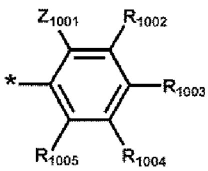
2-16

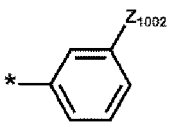
2-17

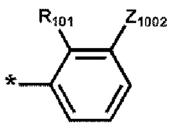
2-18

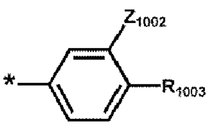
2-19

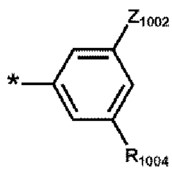
2-20

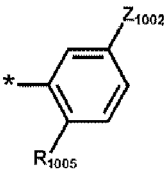
2-21

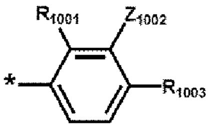
2-22

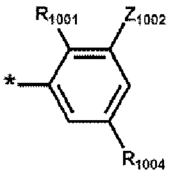
2-23

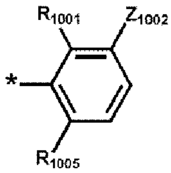
2-24

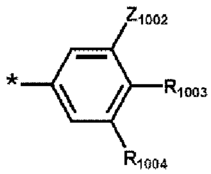
2-25

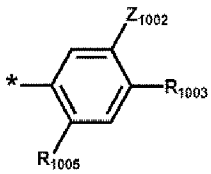
2-26

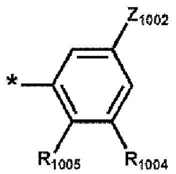
2-27

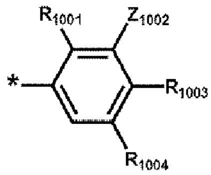
2-28

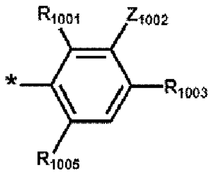
2-29

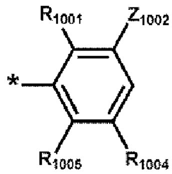
2-30

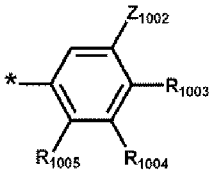
2-31

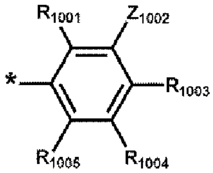
2-32

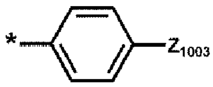
2-33

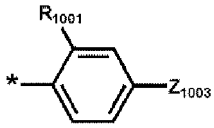
2-34

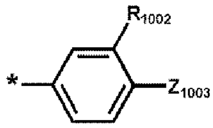
2-35

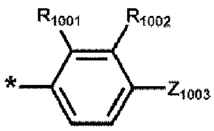
2-36

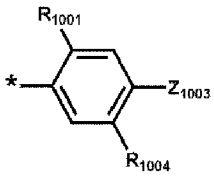
2-37

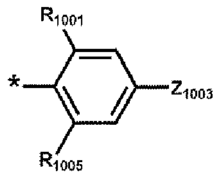
2-38

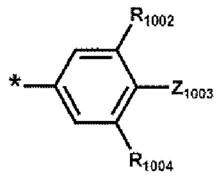
2-39

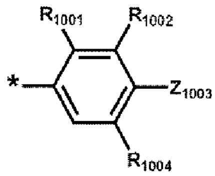
2-40

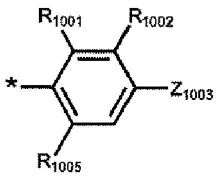
2-41

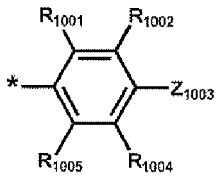
2-42

In Formulae 2-1 to 2-42,

$R_{1001}$ to $R_{1005}$ are each as defined in connection with $R_{10}$, provided that each of $R_{1001}$ to $R_{1005}$ is not hydrogen,
$Z_{1001}$ to $Z_{1003}$ are each as defined in connection with $Z_{10}$, and
* indicates a binding site to a neighboring atom.

In Formula 1, n13 and n14 are each independently an integer from 0 to 20, and the sum of n13 and n14 is 1 or greater. Thus, Formula 1 may include at least one of $Z_{13}$ and $Z_{14}$ as defined herein.
In one or more embodiments, in Formula 1, n13 and n14 may each independently be an integer from 0 to 5, and the sum of n13 and n14 may be 1 to 5.
In one or more embodiments, an organometallic compound represented by Formula 1 may satisfy at least one of Condition 3 and Condition 4:

Condition 3
n13 in Formula 1 is 1 or 2

Condition 4
n14 in Formula 1 is 1 or 2

$L_1$ to $L_4$, $L_7$, $L_{13}$, and $L_{14}$ in Formula 1 are each independently a single bond, a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$
For example, $L_1$ to $L_4$, $L_7$, $L_{13}$ and $L_{14}$ in Formula 1 may each independently be:

a single bond; or
a benzene group, a naphthalene group, an anthracene group, a phenanthrene group, a triphenylene group, a pyrene

group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, or a benzothiadiazole group, each unsubstituted or substituted with at least one $R_{10a}$.

In one or more embodiments, $L_1$ to $L_4$, $L_7$, $L_{13}$, and $L_{14}$ in Formula 1 may each independently be:

a single bond; or
a benzene group unsubstituted or substituted with at least one $R_{10a}$.

In Formula 1, b1 to b4, b7, b13, and b14 each indicate the number of $L_1$ to $L_4$, $L_7$, $L_{13}$, and $L_{14}$ and are each independently an integer from 1 to 5. When b1 is 2 or greater, two or more of $L_1$(s) are identical to or different from each other, when b2 is 2 or greater, two or more of $L_2$(s) are identical to or different from each other, when b3 is 2 or greater, two or more of $L_3$(s) are identical to or different from each other, when b4 is 2 or greater, two or more of $L_4$(s) are identical to or different from each other, when b7 is 2 or greater, two or more of $L_7$(s) are identical to or different from each other, when b13 is 2 or greater, two or more of $L_{13}$(s) are identical to or different from each other, and when b14 is 2 or greater, two or more of $L_{14}$(s) are identical to or different from each other.

In one or more embodiments, b1 to b4, b7, b13, and b14 in Formula 1 may each independently be 1, 2, or, 3.

In Formula 1, $R_1$ to $R_4$, $R_7$ to $R_9$, $R_{9a}$, $R_{9b}$, R', and R" are each independently hydrogen, deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, $-Ge(Q_3)(Q_4)(Q_5)$, $-B(Q_6)(Q_7)$, $-P(=O)(Q_8)(Q_9)$, or $-P(Q_8)(Q_9)$. $Q_1$ to $Q_9$ are each as defined herein.

For example, $R_1$ to $R_4$, $R_7$ to $R_9$, $R_{9a}$, $R_{9b}$, R', and R" may each independently be:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-SF_5$, a $C_1$-$C_{20}$ alkyl group, a $C_1$-$C_{20}$ alkoxy group, or a $C_1$-$C_{20}$ alkylthio group;

a $C_1$-$C_{20}$ alkyl group, a $C_1$-$C_{20}$ alkoxy group, or a $C_1$-$C_{20}$ alkylthio group, each substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a pyridinyl group, a pyrimidinyl group, or a combination thereof;

a cyclopentyl group, a cyclohexyl group, a cycloheptyl group, a cyclooctyl group, an adamantanyl group, a norbornanyl

group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a phenyl group, a ($C_1$-$C_{20}$ alkyl) phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or a combination thereof; or

$-N(Q_1)(Q_2)$, $-Si(Q_3)(Q_4)(Q_5)$, $-Ge(Q_3)(Q_4)(Q_5)$, $-B(Q_6)(Q_7)$, $-P(=O)(Q_6)(Q_9)$, or $-P(Q_6)(Q_9)$,

wherein $Q_1$ to $Q_9$ may each independently be:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, or $-CD_2CDH_2$; or

an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, a $C_1$-$C_{10}$ alkyl group, a phenyl group, or a combination thereof.

In Formula 1, c1 to c4, c7, c13, and c14 each indicate the number of $R_1$ to $R_4$, $R_7$, $Z_{13}$, and $Z_{14}$, and are each independently an integer from 1 to 5. When c1 is 2 or greater, two or more of $R_1$(s) are identical to or different from each other, when c2 is 2 or greater, two or more of $R_2$(s) are identical to or different from each other, when c3 is 2 or greater, two or more of $R_3$(s) are identical to or different from each other, when c4 is 2 or greater, two or more of $R_4$(s) are identical to or different from each other, when c7 is 2 or greater, two or more of $R_7$(s) are identical to or different from each other, when c13 is 2 or greater, two or more of $Z_{13}$(s) are identical to or different from each other, and when c14 is 2 or greater, two or more of $Z_{14}$(s) are identical to or different from each other.

In one or more embodiments, c1 to c4, c7, c13 and c14 in Formula 1 may each independently be 1 or 2.

a1 to a4 in Formula 1 each indicate the number of $*-[(L_1)_{b1}-(R_1)_{c1}]$, $*-[(L_2)_{b2}-(R2)c2]$, $*-[(L_3)_{b3}-(R_3)_{c3}]$, and $*-[(L_4)_{b4}-(R_4)_{c4}]$, respectively, and are each independently an integer from 0 to 20. When a1 is 2 or greater, two or more of $*-[(L_1)_{b1}-(R_1)_{c1}]$ are identical to or different from each other, when a2 is 2 or greater, two or more of $*-[(L_2)_{b2}-(R_2)_{c2}]$ are identical to or different from each other, when a3 is 2 or greater, two or more of $*-[(L_3)_{b3}-(R_3)_{c3}]$ are identical to or different from each other, and when a4 is 2 or greater, two or more of $*-[(L_4)_{b4}-(R_4)_{c4}]$ are identical to or different from each other.

In one or more embodiments, $R_1$ to $R_4$, $R_7$ to $R_9$, $R_{9a}$, $R_{9b}$, R' and R" in Formula 1 may each independently be hydrogen, deuterium, -F, a cyano group, a nitro group, $-SF_5$, $-CH_3$, $-CD_3$, $-CD_2H$, $-CDH_2$, $-CF_3$, $-CF_2H$, $-CFH_2$, $-OCH_3$,

$-OCDH_2$, $-OCD_2H$, - $OCD_3$, $-SCH_3$, $-SCDH_2$, $-SCD_2H$, $-SCD_3$, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-233, a group represented by one of Formulae 9-201 to 9-233 in which at least one hydrogen is substituted with deuterium, a group represented by one of Formulae 9-201 to 9-233 in which at least one hydrogen is substituted with -F, a group represented by one of Formulae 10-1 to 10-132, a group represented by one of Formulae 10-1 to 10-132 in which at least one hydrogen is substituted with deuterium, a group represented by one of Formulae 10-1 to 10-132 in which at least one hydrogen is substituted with -F, a group represented by one of Formulae 10-201 to 10-353, a group represented by one of Formulae 10-201 to 10-353 in which at least one hydrogen is substituted with deuterium, a group represented by one of Formulae 10-201 to 10-353 in which at least one hydrogen is substituted with -F, $-Si(Q_3)(Q_4)(Q_5)$, or $-Ge(Q_3)(Q_4)(Q_5)$ ($Q_3$ to $Q_5$ are each the same as defined herein).

In one or more embodiments, $Z_{10}$ in Formula 2 may be -F, $-CF_3$, $-CF_2H$, $-CFH_2$, a group represented by one of Formulae 9-1 to 9-39 wherein at least one hydrogen is substituted with -F, a group represented by one of Formulae 9-201 to 9-233 wherein at least one hydrogen is substituted with -F, a group represented by one of Formulae 10-1 to 10-132 wherein at least one hydrogen is substituted with -F, or a group represented by one of Formulae 10-201 to 10-353 wherein at least one hydrogen is substituted with -F.

In one or more embodiments, a group represented by Formula 2 may be a group represented by one of Formulae 10-12 to 10-132 wherein at least one hydrogen is substituted with -F, or a group represented by one of Formulae 10-201 to 10-353 wherein at least one hydrogen is substituted with -F:

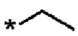
9-1

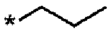
9-2

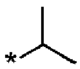
9-3

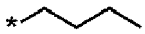
9-4

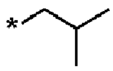
9-5

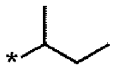
9-6

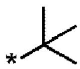
9-7

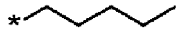
9-8

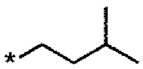
9-9

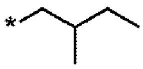
9-10

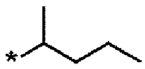
9-11

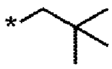
9-12

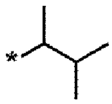
9-13

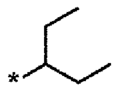
9-14

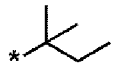
9-15

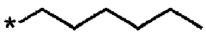
9-16

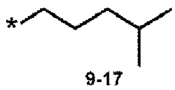
9-17

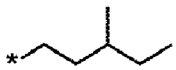
9-18

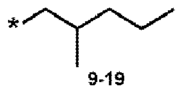
9-19

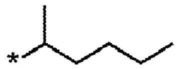
9-20

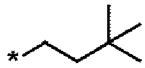
9-21

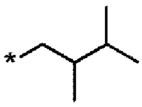
9-22

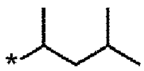
9-23

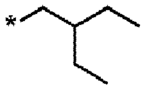
9-24

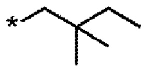
9-25

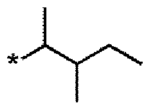
9-26

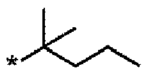
9-27

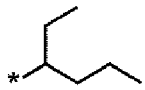
9-28

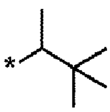
9-29

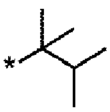
9-30

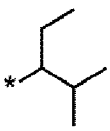
9-31

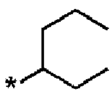
9-32

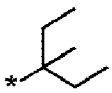
9-33

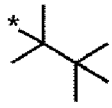
9-34

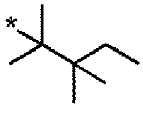
9-35

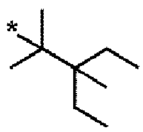
9-36

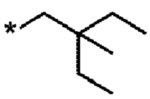
9-37

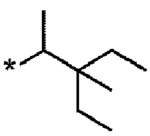
9-38

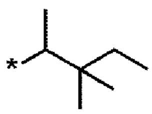
9-39

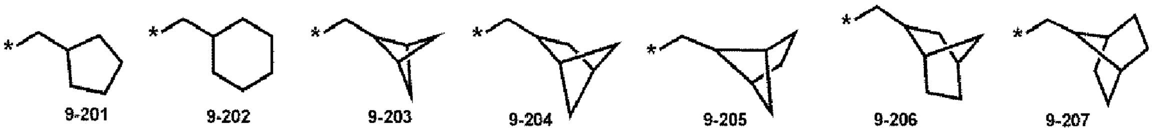
9-201 9-202 9-203 9-204 9-205 9-206 9-207

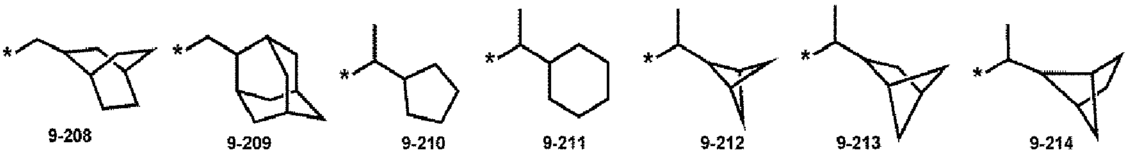
9-208 9-209 9-210 9-211 9-212 9-213 9-214

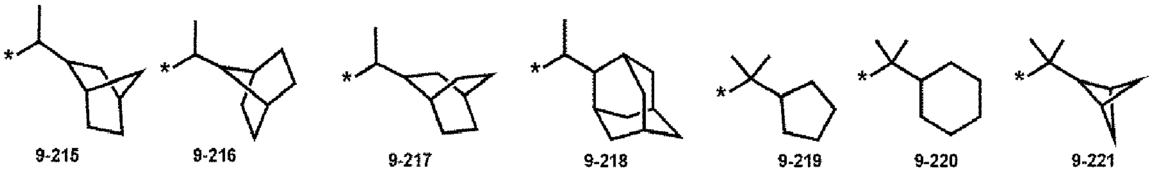
9-215 9-216 9-217 9-218 9-219 9-220 9-221

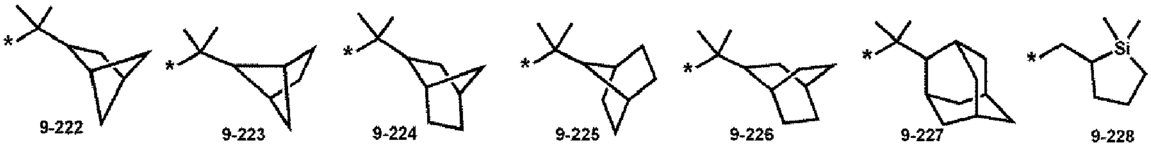
9-222 9-223 9-224 9-225 9-226 9-227 9-228

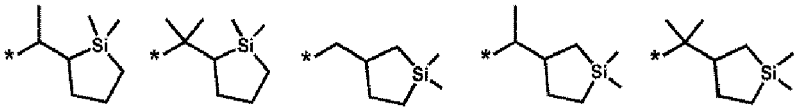
9-229 9-230 9-231 9-232 9-233

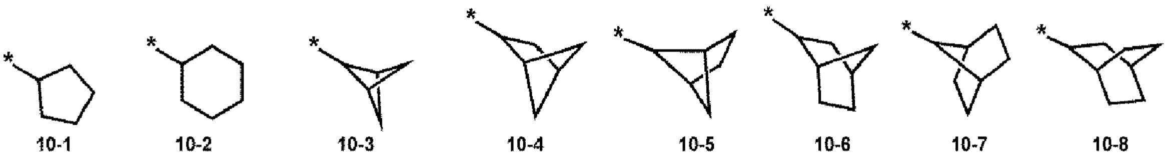
10-1 10-2 10-3 10-4 10-5 10-6 10-7 10-8

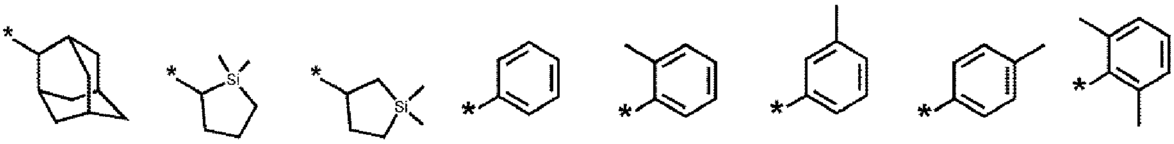
10-9 10-10 10-11 10-12 10-13 10-14 10-15 10-16

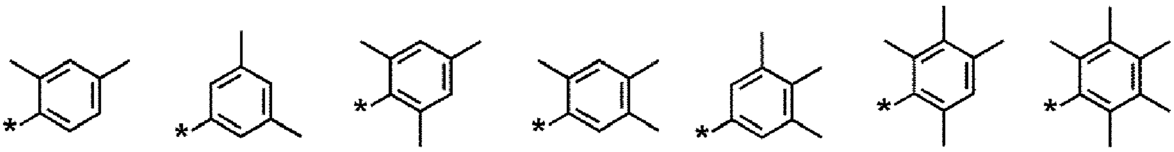
10-17 10-18 10-19 10-20 10-21 10-22 10-23

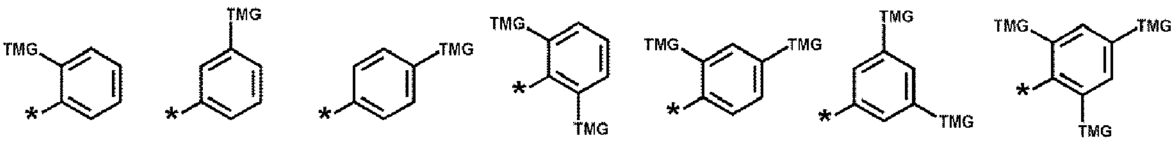
10-24 10-25 10-26 10-27 10-28 10-29 10-30

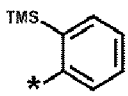 10-31
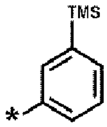 10-32
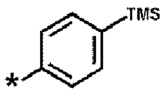 10-33
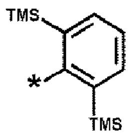 10-34
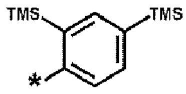 10-35
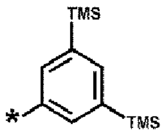 10-36
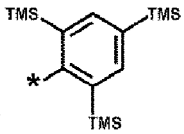 10-37

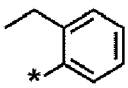 10-38
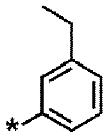 10-39
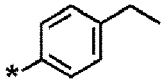 10-40
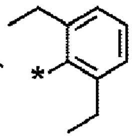 10-41
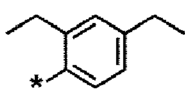 10-42
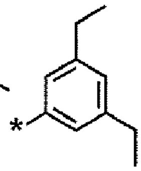 10-43
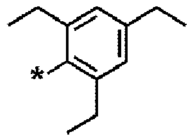 10-44

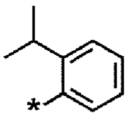 10-45
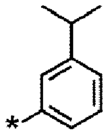 10-46
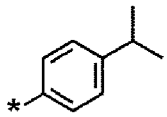 10-47
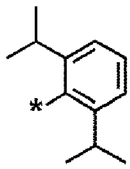 10-48
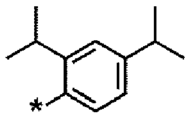 10-49
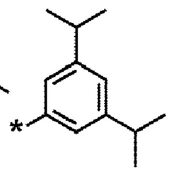 10-50
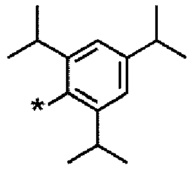 10-51

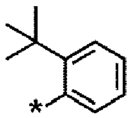 10-52
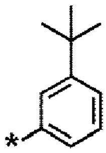 10-53
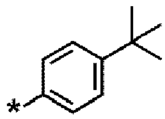 10-54
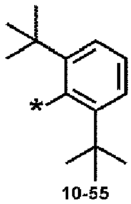 10-55
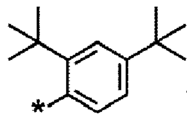 10-56
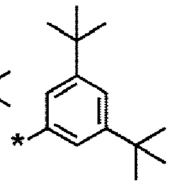 10-57
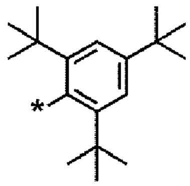 10-58

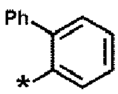 10-59
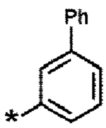 10-60
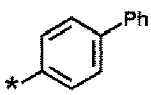 10-61
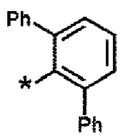 10-62
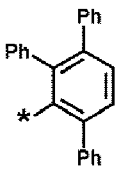 10-63
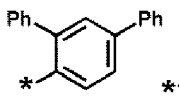 10-64
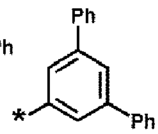 10-65
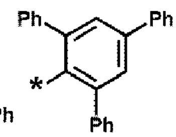 10-66

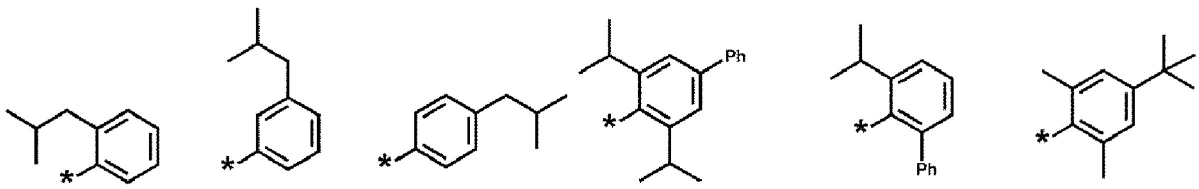

10-67 10-68 10-69 10-70 10-71 10-72

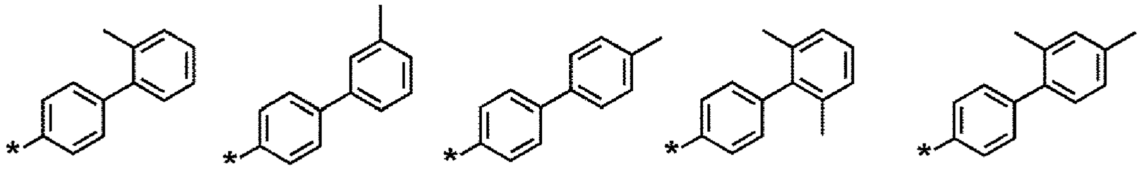

10-73 10-74 10-75 10-76 10-77

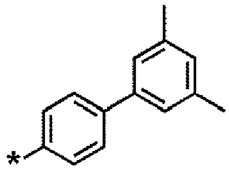 10-78
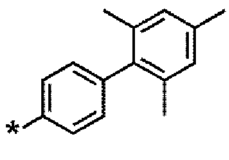 10-79
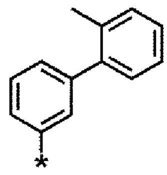 10-80
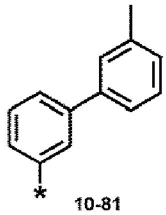 10-81
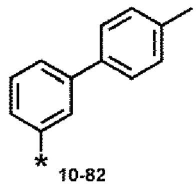 10-82

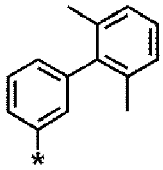 10-83
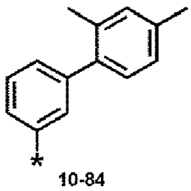 10-84
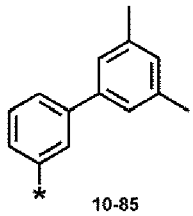 10-85
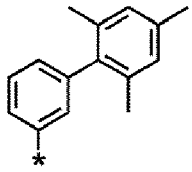 10-86
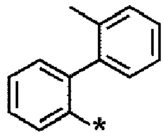 10-87
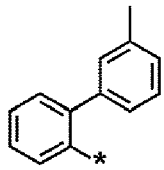 10-88

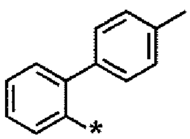 10-89
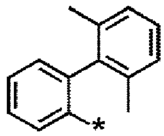 10-90
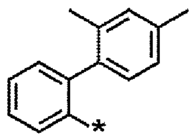 10-91
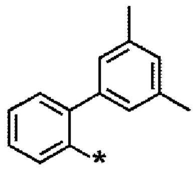 10-92
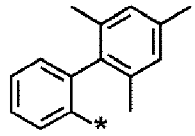 10-93
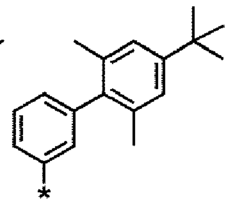 10-94

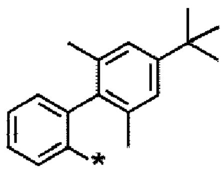 10-95
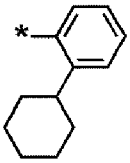 10-96
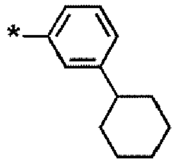 10-97
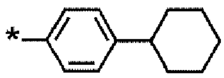 10-98
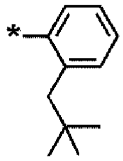 10-99
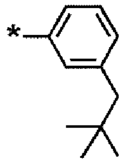 10-100

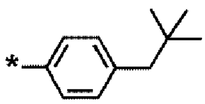 10-101
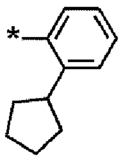 10-102
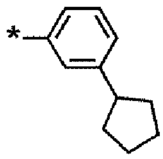 10-103
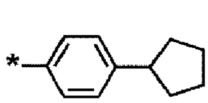 10-104
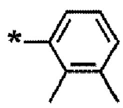 10-105
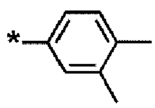 10-106

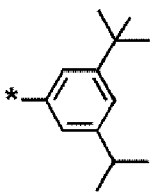 10-107
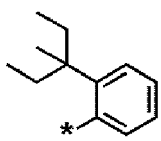 10-108
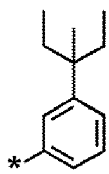 10-109
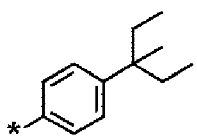 10-110
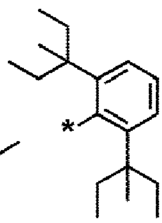 10-111
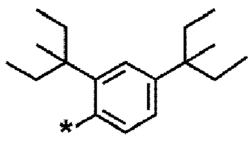 10-112

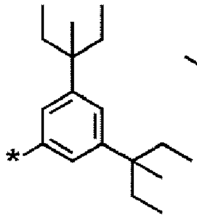
10-113

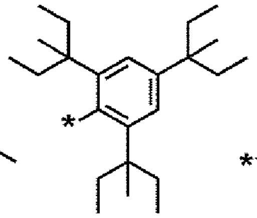
10-114

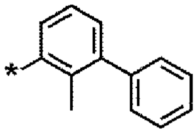
10-115

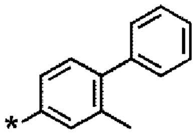
10-116

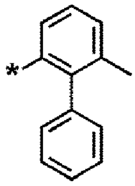
10-117

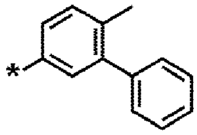
10-118

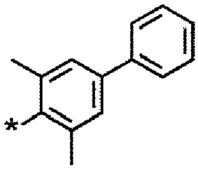
10-119

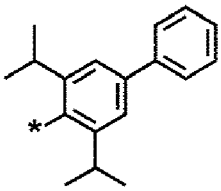
10-120

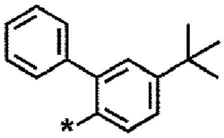
10-121

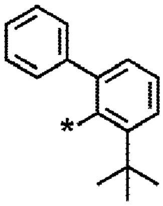
10-122

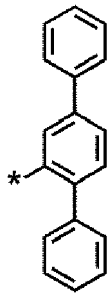
10-123

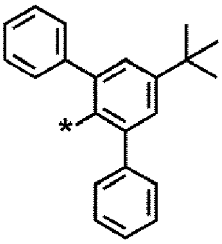
10-124

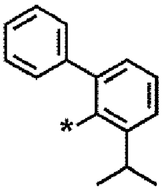
10-125

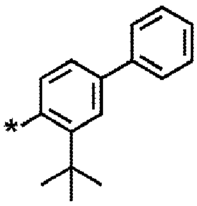
10-126

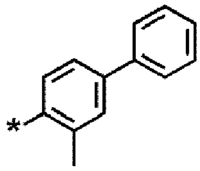
10-127

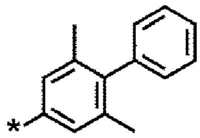
10-128

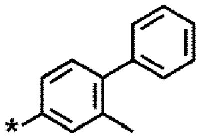
10-129

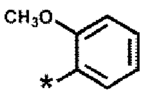
10-130

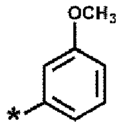
10-131

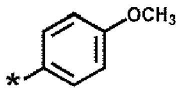
10-132

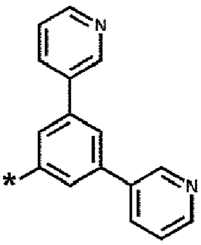
10-201

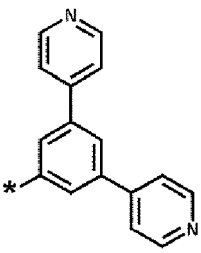
10-202

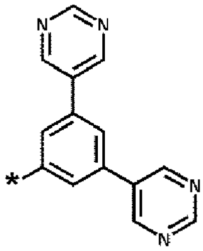
10-203

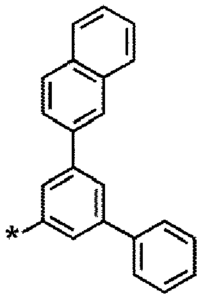
10-204

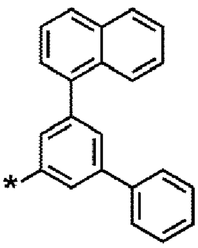
10-205

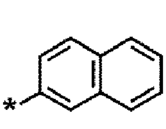
10-206

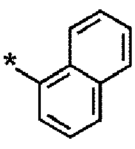
10-207

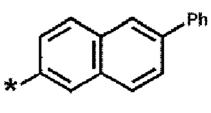
10-208

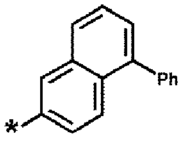
10-209

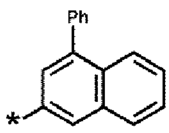
10-210

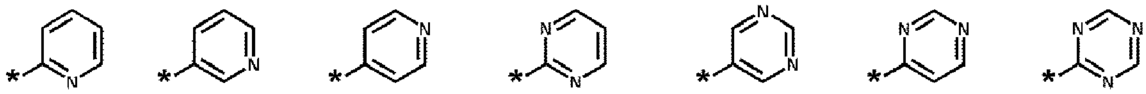

10-211 10-212 10-213 10-214 10-215 10-216 10-217

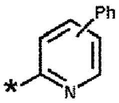 10-218 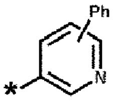 10-219 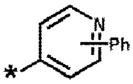 10-220 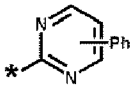 10-221 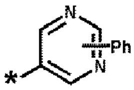 10-222 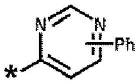 10-223 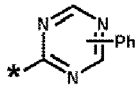 10-224

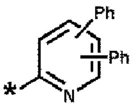 10-225 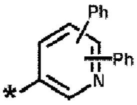 10-226 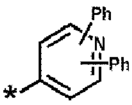 10-227 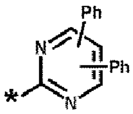 10-228 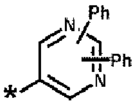 10-229 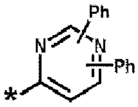 10-230 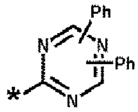 10-231

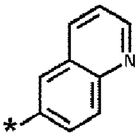 10-232 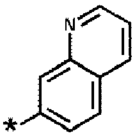 10-233 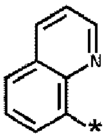 10-234 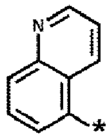 10-235 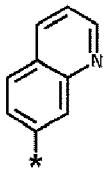 10-236 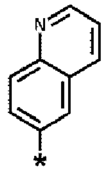 10-237

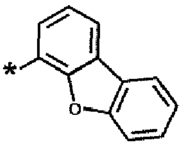 10-238 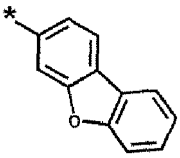 10-239 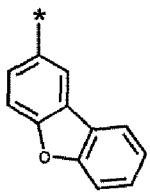 10-240 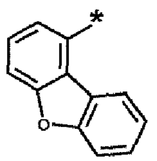 10-241 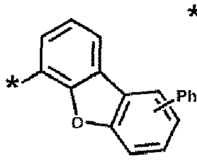 10-242 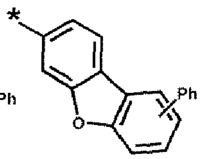 10-243

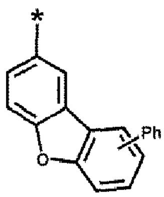 10-244 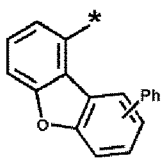 10-245 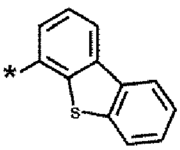 10-246 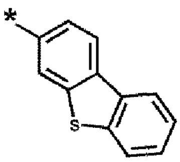 10-247 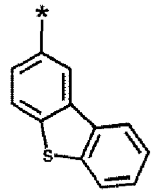 10-248 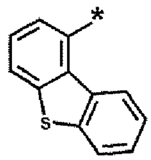 10-249

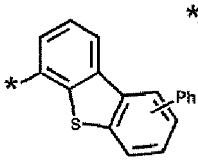 10-250 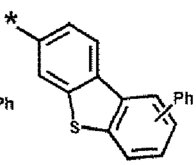 10-251 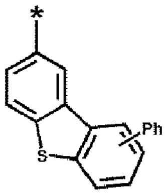 10-252 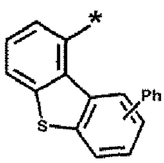 10-253 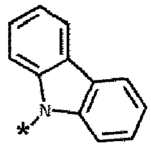 10-254 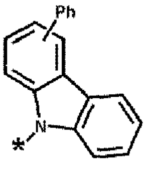 10-255

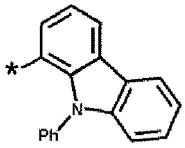
10-256

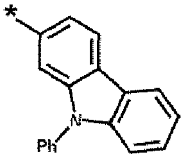
10-257

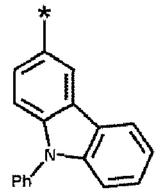
10-258

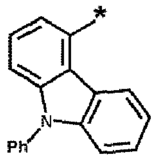
10-259

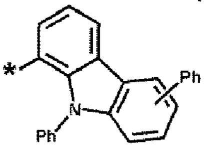
10-260

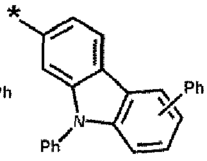
10-261

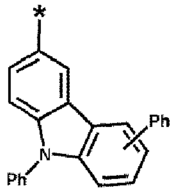
10-262

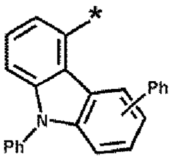
10-263

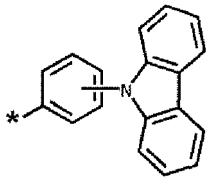
10-264

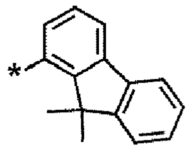
10-265

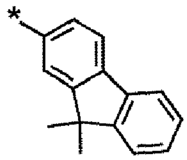
10-266

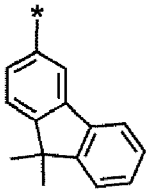
10-267

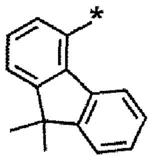
10-268

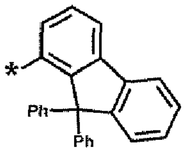
10-269

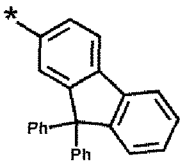
10-270

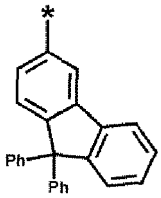
10-271

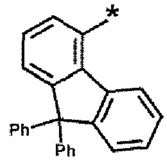
10-272

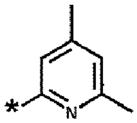
10-273

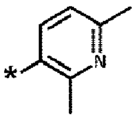
10-274

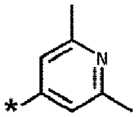
10-275

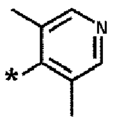
10-276

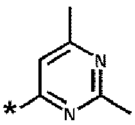
10-277

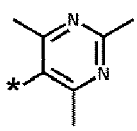
10-278

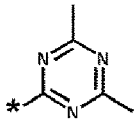
10-279

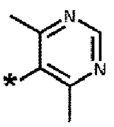
10-280

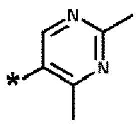
10-281

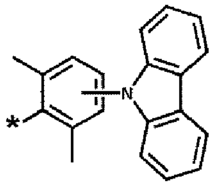
10-282

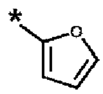
10-283

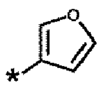
10-284

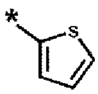
10-285

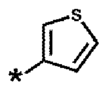
10-286

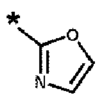
10-287

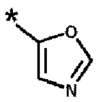
10-288

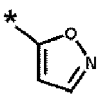
10-289

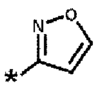
10-290

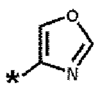
10-291

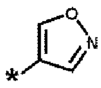
10-292

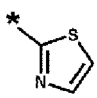
10-293

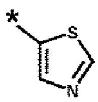
10-294

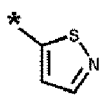
10-295

10-296

10-297

10-298

10-299

10-300

10-301

10-302

10-303

10-304

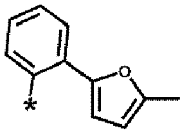
10-305

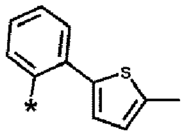
10-306

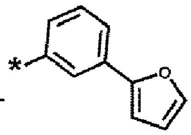
10-307

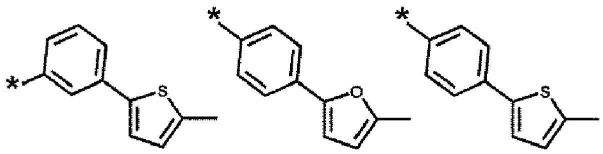
10-308 10-309 10-310

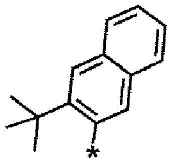
10-311

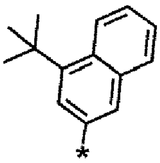
10-312

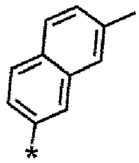
10-313

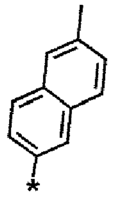
10-314

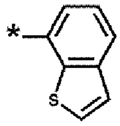
10-315

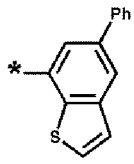
10-316

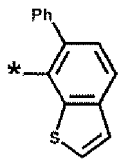
10-317

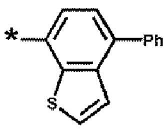
10-318

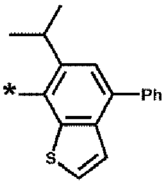
10-319

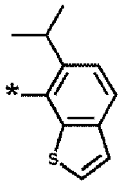
10-320

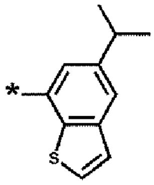
10-321

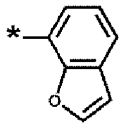
10-322

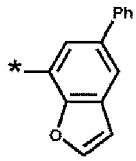
10-323

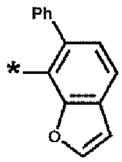
10-324

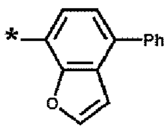
10-325

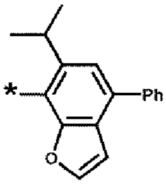
10-326

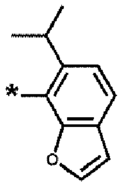
10-327

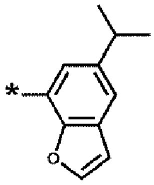
10-328

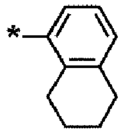
10-329

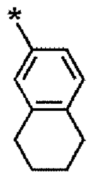
10-330

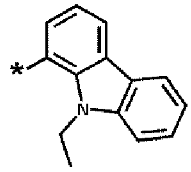
10-331

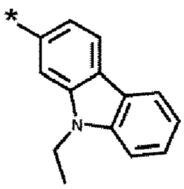
10-332

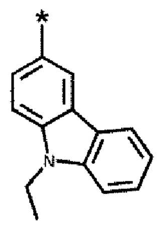
10-333

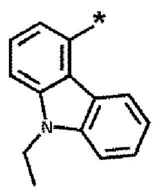
10-334

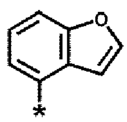
10-335

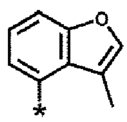
10-336

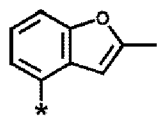
10-337

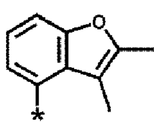
10-338

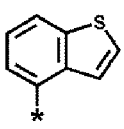
10-339

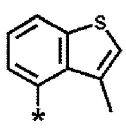
10-340

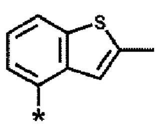
10-341

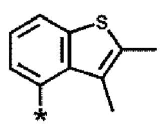
10-342

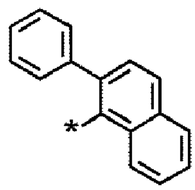
10-343

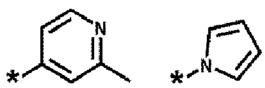
10-344 10-345

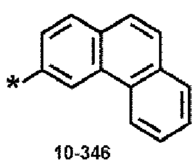
10-346

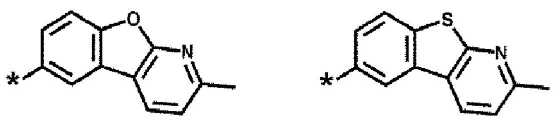
10-347 10-348

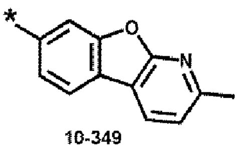 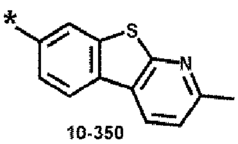 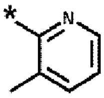 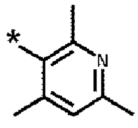 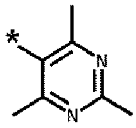

10-349 10-350 10-351 10-352 10-353

In Formulae 9-1 to 9-39, 9-201 to 9-233, 10-1 to 10-132, and 10-201 to 10-353, * indicates a binding site to a neighboring atom, Ph is a phenyl group, TMS is a trimethylsilyl group, TMG is a trimethylgermyl group, and OMe is a methoxy group.

As used herein, the "group represented by one of Formulae 9-1 to 9-39 in which at least one hydrogen is substituted with deuterium" and the "group represented by one of Formulae 9-201 to 9-233 in which at least one hydrogen is substituted with deuterium" may be, for example, a group represented by one of Formulae 9-501 to 9-514 and 9-601 to 9-635:

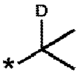 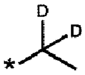 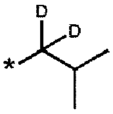 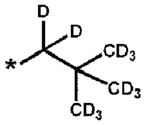 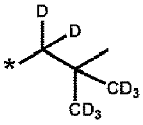 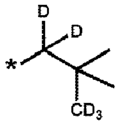 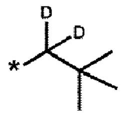

9-501 9-502 9-503 9-504 9-505 9-506 9-507

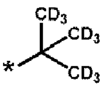 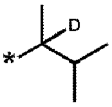 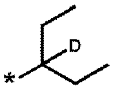 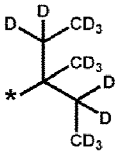 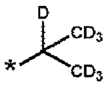 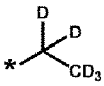 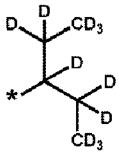

9-508 9-509 9-510 9-511 9-512 9-513 9-514

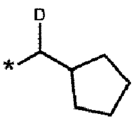 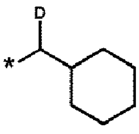 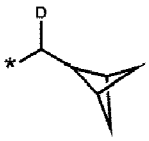 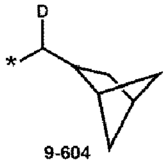 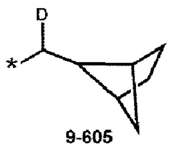 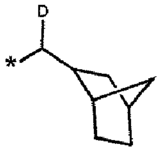 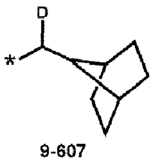

9-601 9-602 9-603 9-604 9-605 9-606 9-607

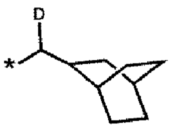 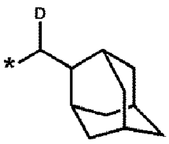 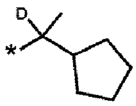 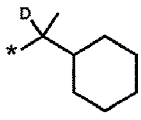 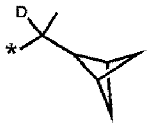 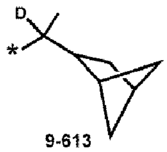

9-608 9-609 9-610 9-611 9-612 9-613

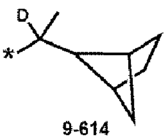 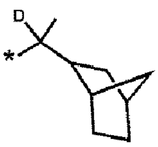 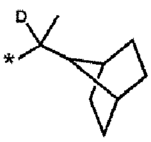 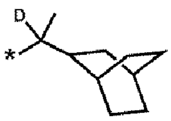 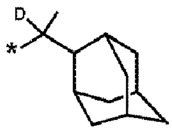 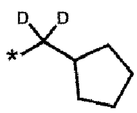

9-614 9-615 9-616 9-617 9-618 9-619

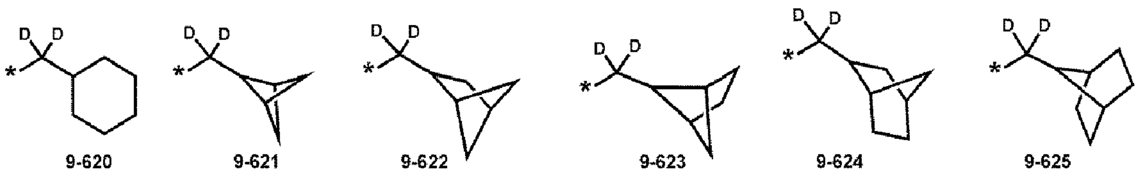

9-620 9-621 9-622 9-623 9-624 9-625

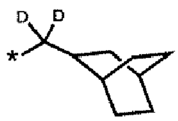 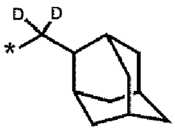 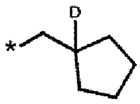 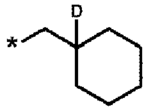 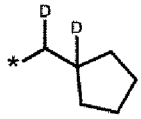 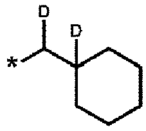

9-626 9-627 9-628 9-629 9-630 9-631

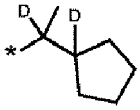 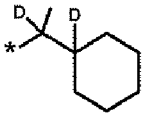 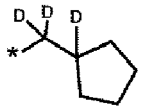 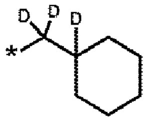

9-632 9-633 9-634 9-635

As used herein, the "group represented by one of Formulae 9-1 to 9-39 in which at least one hydrogen is substituted with -F" and the "group represented by one of Formulae 9-201 to 9-233 in which at least one hydrogen is substituted with -F" may be, for example, a group represented by one of Formulae 9-701 to 9-710:

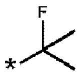 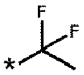 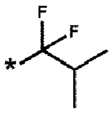 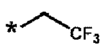 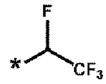 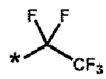 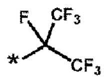

9-701 9-702 9-703 9-704 9-705 9-706 9-707

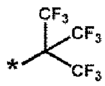 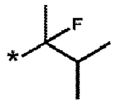 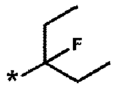

9-708 9-709 9-710

As used herein, the "group represented by one of Formulae 10-1 to 10-132 in which at least one hydrogen is substituted with deuterium" and the "group represented by one of Formulae 10-201 to 10-353 in which at least one hydrogen is substituted with deuterium" may be, for example, a group represented by one of Formulae 10-501 to 10-553:

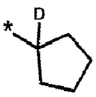 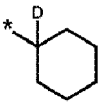 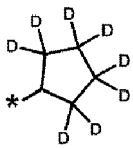 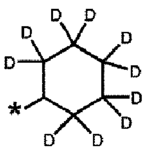 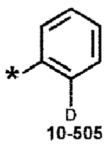 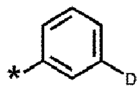 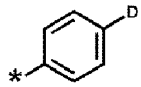 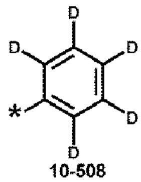

10-501 10-502 10-503 10-504 10-505 10-506 10-507 10-508

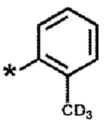 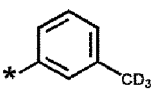 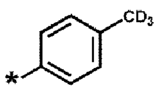 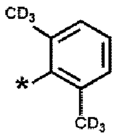 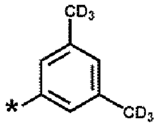 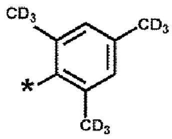 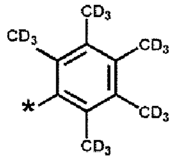

10-509 10-510 10-511 10-512 10-513 10-514 10-515

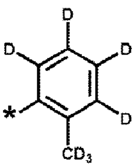 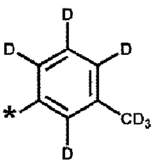 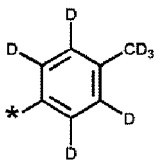 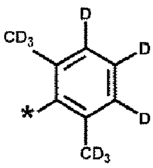 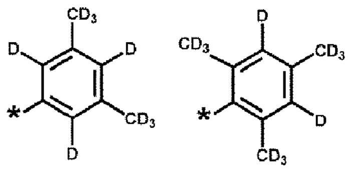

10-516 10-517 10-518 10-519 10-520 10-521

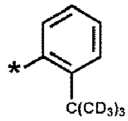 10-522
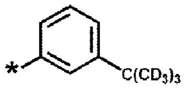 10-523
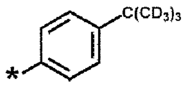 10-524
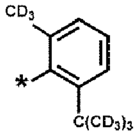 10-525
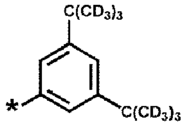 10-526
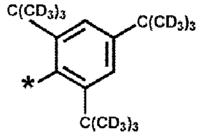 10-527

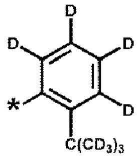 10-528
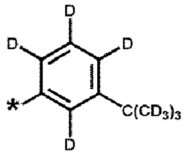 10-529
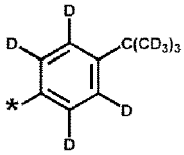 10-530
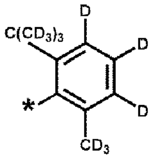 10-531
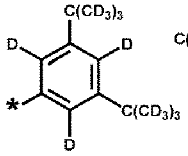 10-532
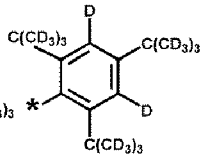 10-533

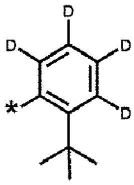 10-534
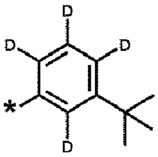 10-535
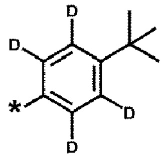 10-536
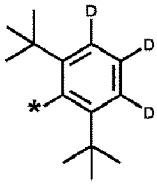 10-537
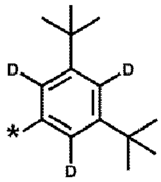 10-538
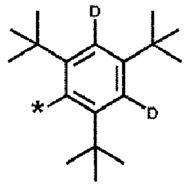 10-540

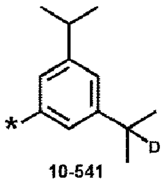 10-541
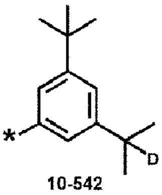 10-542
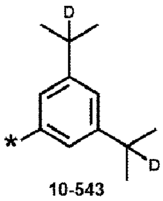 10-543
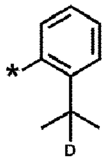 10-544
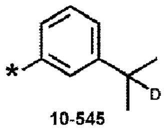 10-545
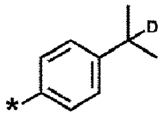 10-546

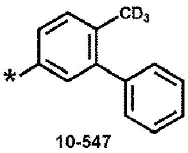 10-547
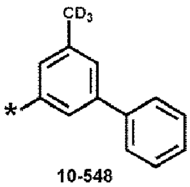 10-548
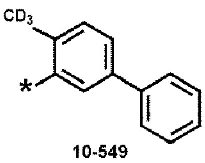 10-549
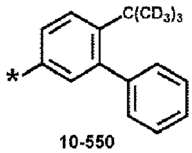 10-550
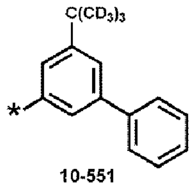 10-551

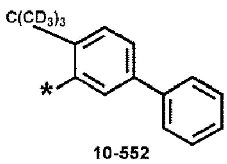 10-552
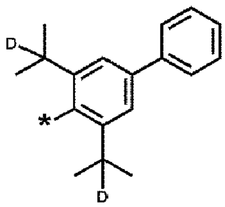 10-553

As used herein, the "group represented by one of Formulae 10-1 to 10-132 in which at least one hydrogen is substituted with -F" and the "group represented by one of Formulae 10-201 to 10-353 in which at least one hydrogen is substituted with -F" may be, for example, a group represented by one of Formulae 10-601 to 10-620:

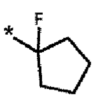 10-601
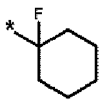 10-602
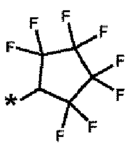 10-603
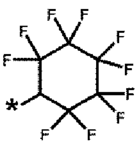 10-604
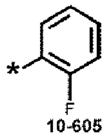 10-605
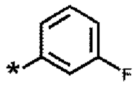 10-606
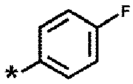 10-607
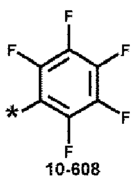 10-608

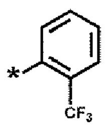
10-609

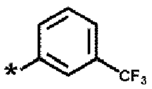
10-610

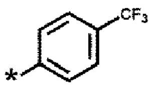
10-611

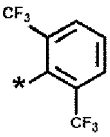
10-612

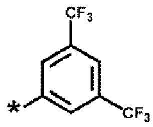
10-613

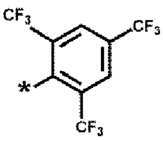
10-614

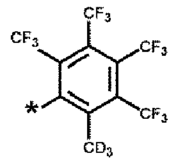
10-615

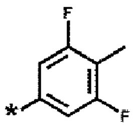
10-616

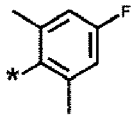
10-617

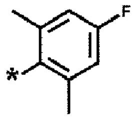
10-618

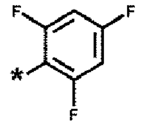
10-619

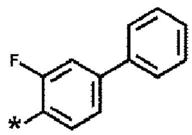
10-620

In Formula 1, i) two or more of a plurality of $R_1$(s) are optionally linked to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$, ii) two or more of a plurality of $R_2$(s) are optionally linked to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$, iii) two or more of a plurality of $R_3$(s) are optionally linked to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$, iv) two or more of a plurality of $R_4$(s) are optionally linked to form a $C_5$-$C_{30}$ carbocyclic group unsubstituted or substituted with at least one $R_{10a}$ or a C1-$C_{30}$ heterocyclic group unsubstituted or substituted with at least one $R_{10a}$, v) two or more of $R_1$ to $R_4$, $R_7$ to $R_9$, $R_{9a}$, $R_{9b}$, R', and R" are optionally linked to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$.

$R_{10a}$ is as defined in connection with $R_1$

In one or more embodiments, the group represented by

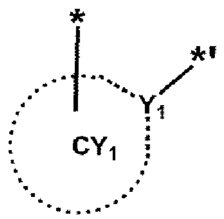

in Formula 1 may be a group represented by one of Formulae CY1-1 to CY1-40:

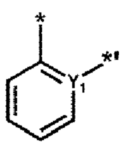
CY1-1

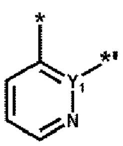
CY1-2

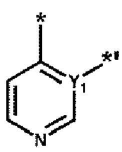
CY1-3

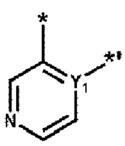
CY1-4

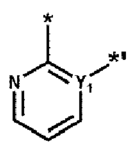
CY1-5

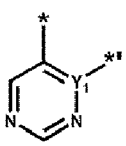
CY1-6

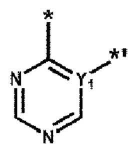
CY1-7

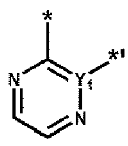
CY1-8

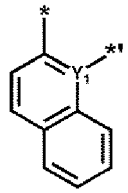
CY1-9

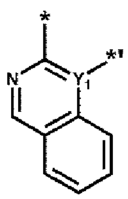
CY1-10

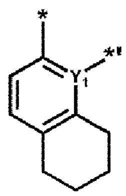
CY1-11

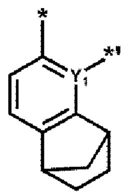
CY1-12

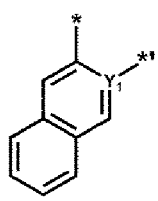
CY1-13

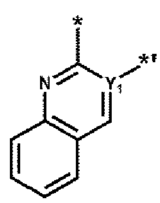
CY1-14

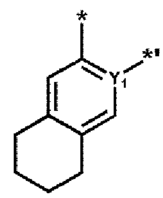
CY1-15

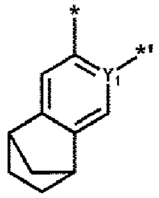
CY1-16
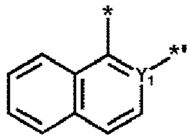
CY1-17
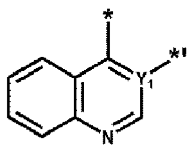
CY1-18
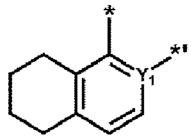
CY1-19
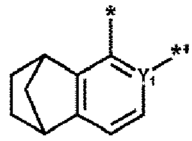
CY1-20
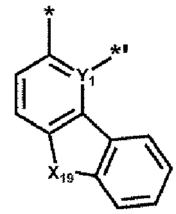
CY1-21

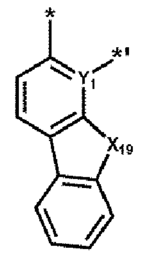
CY1-22
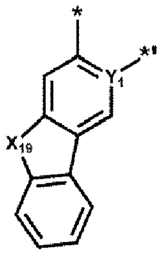
CY1-23
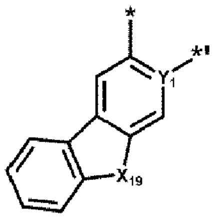
CY1-24
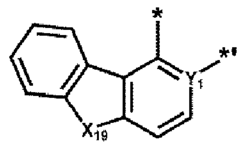
CY1-25
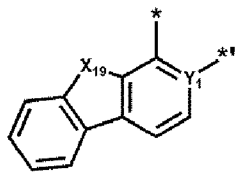
CY1-26

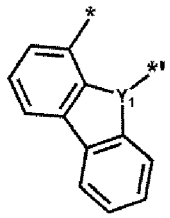
CY1-27
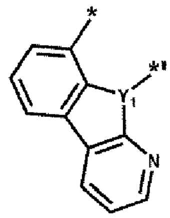
CY1-28
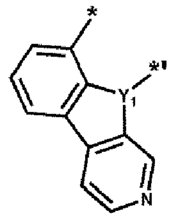
CY1-29
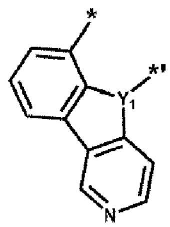
CY1-30
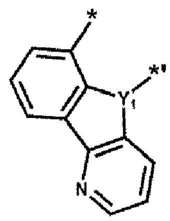
CY1-31
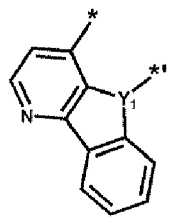
CY1-32

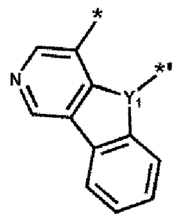
CY1-33
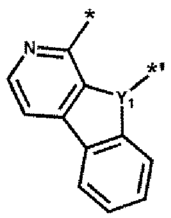
CY1-34
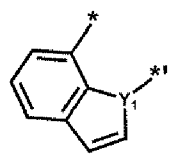
CY1-35
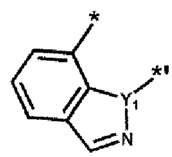
CY1-36
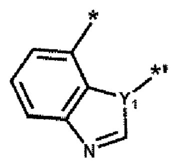
CY1-37
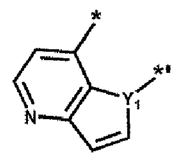
CY1-38

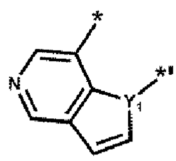
CY1-39
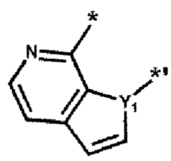
CY1-40

In Formulae CY1-1 to CY1-40,

$Y_1$ is as defined herein,
$X_{19}$ is $C(R_{19a})(R_{19b})$, $N[(L_{19})_{b19}-(R_{19})_{c19}]$, O, S, or $Si(R_{19a})(R_{19b})$,
$L_{19}$ may be as defined in connection with $L_1$;
b19 and c19 are each as defined in connection with b1 and c1,
$R_{19}$, $R_{19a}$, and $R_{19b}$ are each as defined in connection with $R_1$, and
*' indicates a binding site to $X_1$ or M in Formula 1, and
* indicates a binding site to ring $CY_5$ in Formula 1

In one or more embodiments, the group represented by

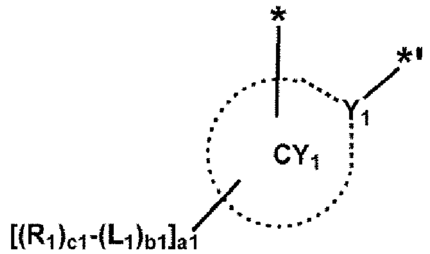

in Formula 1 may be a group represented by one of Formulae CY1(1) to CY1(22):

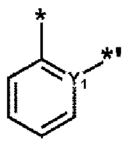
CY1(1)

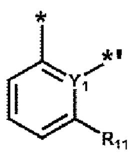
CY1(2)

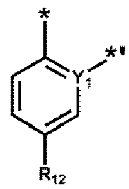
CY1(3)

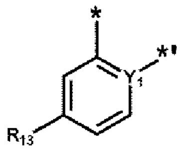
CY1(4)

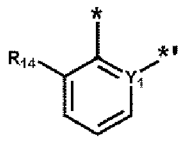
CY1(5)

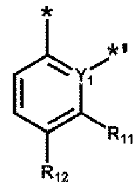
CY1(6)

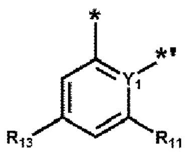
CY1(7)

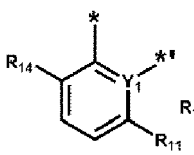
CY1(8)

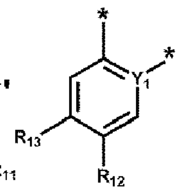
CY1(9)

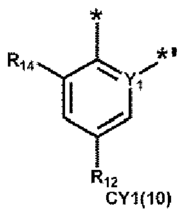
CY1(10)

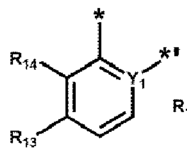
CY1(11)

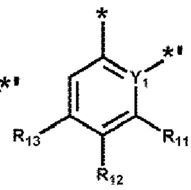
CY1(12)

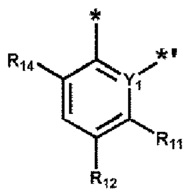
CY1(13)

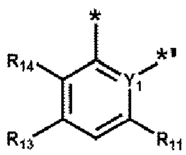
CY1(14)

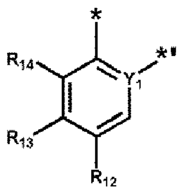
CY1(15)

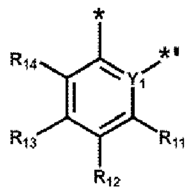
CY1(16)

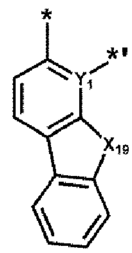
CY1(17)

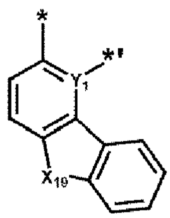
CY1(18)

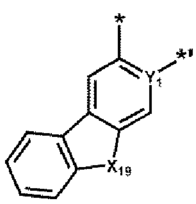
CY1(19)

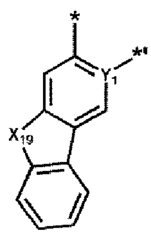
CY1(20)

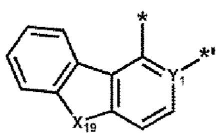
CY1(21)

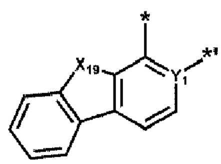
CY1(22)

In Formulae CY1(1) to CY1(22),

$Y_1$ is as defined herein,
$R_{11}$ to $R_{14}$ are each as defined in connection with $R_1$, provided that each of $R_{11}$ to $R_{14}$ is not hydrogen,
X19 may be $C(R_{19a})(R_{19b})$, $N[(L_{19})_{b19}\text{-}(R_{19})_{c19}]$, O, S, or $Si(R_{19a})(R_{19b})$,
$L_{19}$ may be the same as defined in connection with $L_1$;
b19 and c19 are each as defined in connection with b1 and c1,

$R_{19}$, $R_{19a}$, and $R_{19b}$ are each as defined in connection with $R_1$,
*' indicates a binding site to $X_1$ or M in Formula 1, and
* indicates a binding site to ring $CY_5$ in Formula 1

For example, $R_{11}$ to $R_{14}$ in Formula CY1(1) to CY1(22) may be a substituted or unsubstituted $C_4$-$C_{20}$ alkyl group.
In one or more embodiments, the group represented by

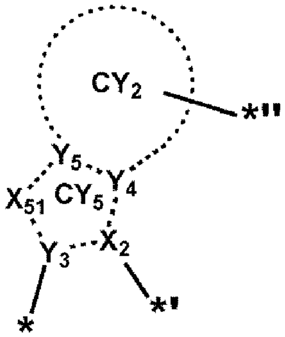

in Formula 1 may be a group represented by one of Formulae CY2-1 to CY2-20:

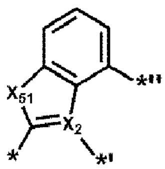
CY2-1
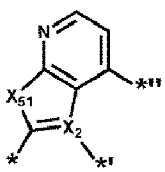
CY2-2
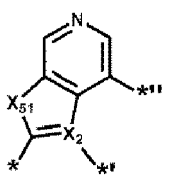
CY2-3
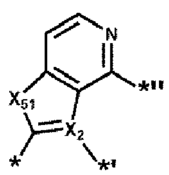
CY2-4
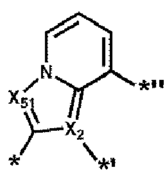
CY2-5
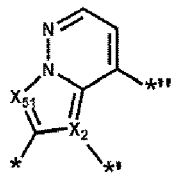
CY2-6

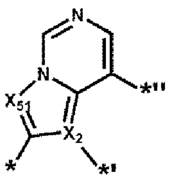
CY2-7
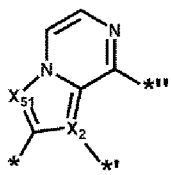
CY2-8
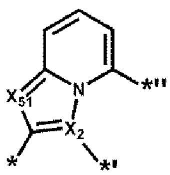
CY2-9
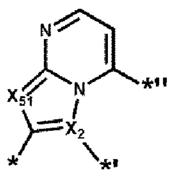
CY2-10
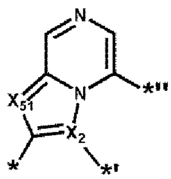
CY2-11
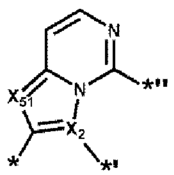
CY2-12

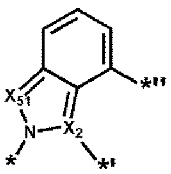
CY2-13
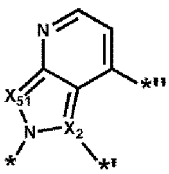
CY2-14
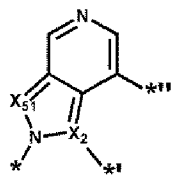
CY2-15
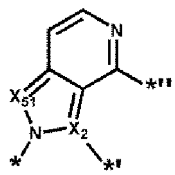
CY2-16
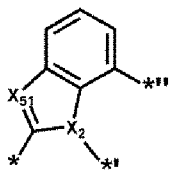
CY2-17
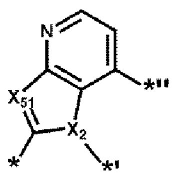
CY2-18

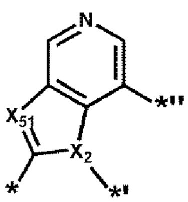
CY2-19
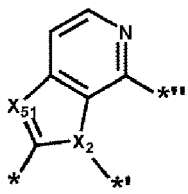
CY2-20

wherein, in Formulae CY2-1 to CY2-20,
$X_2$ and $X_{51}$ are each as defined herein,

* indicates a binding site to ring $CY_1$ in Formula 1,

*' indicates a binding site to M in Formula 1, and
*'' indicates a binding site to $T_1$ in Formula 1

In one or more embodiments, the group represented by

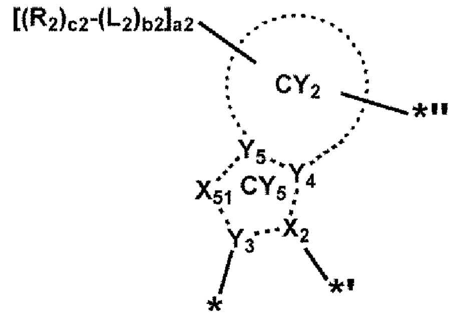

in Formula 1 may be a group represented by one of Formulae CY2(1) to CY2(20):

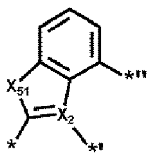 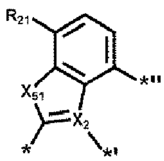 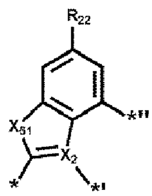 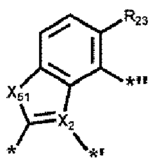 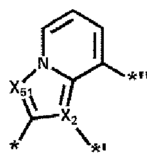 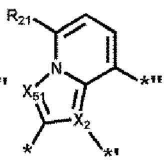 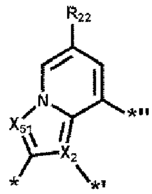

CY2(1) CY2(2) CY2(3) CY2(4) CY2(5) CY2(6) CY2(7)

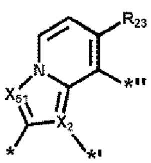 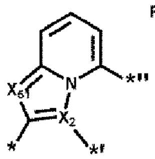 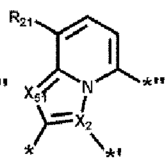 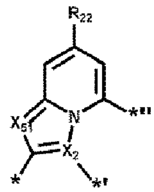 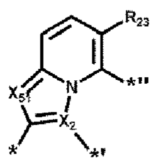 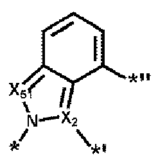 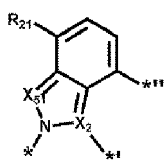

CY2(8) CY2(9) CY2(10) CY2(11) CY2(12) CY2(13) CY2(14)

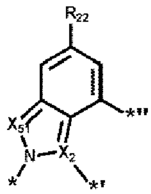 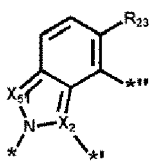 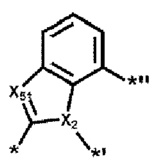 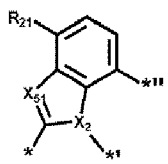 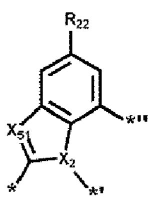 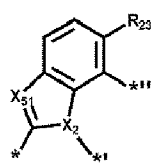

CY2(15) CY2(16) CY2(17) CY2(18) CY2(19) CY2(20)

In Formulae CY2(1) to CY2(20),

$X_2$ and $X_{51}$ are each as defined herein,
$R_{21}$ to $R_{23}$ are each as defined in connection with $R_2$, provided that each of $R_{21}$ to $R_{23}$ may not be hydrogen,

* indicates a binding site to ring $CY_1$ in Formula 1,
*' indicates a binding site to M in Formula 1, and
*'' indicates a binding site to $T_1$ in Formula 1

In one or more embodiments,

the group represented by

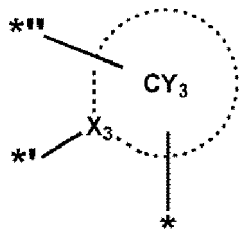

in Formula 1 may be a group represented by one of Formulae CY3-1 to CY3-14, and the group represented by

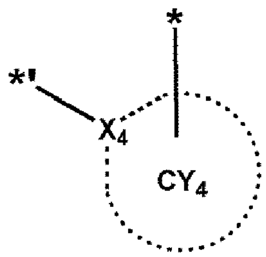

in Formula 1 may be a group represented by one of Formulae CY4-1 to CY4-26.

In one or more embodiments,

the group represented by

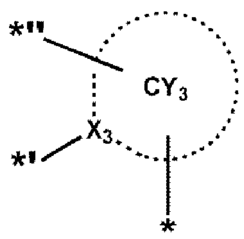

in Formula 1 may be a group represented by one of Formulae CY3-1 to CY3-14, or the group represented by

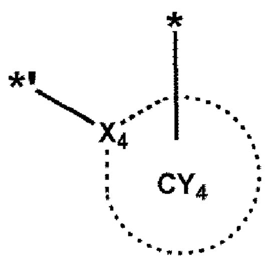

in Formula 1 may be a group represented by one of Formulae CY4-1 to CY4-26.

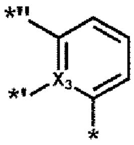
CY3-1
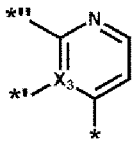
CY3-2
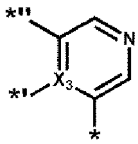
CY3-3
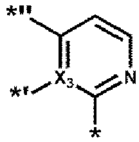
CY3-4
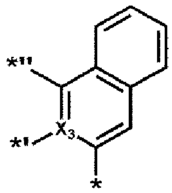
CY3-5
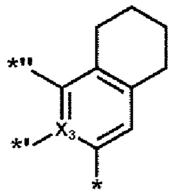
CY3-6
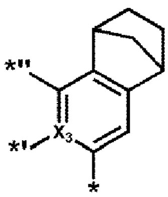
CY3-7
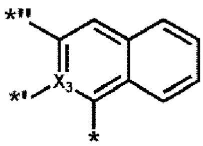
CY3-8
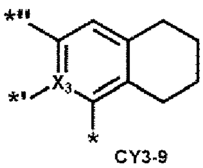
CY3-9
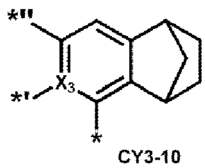
CY3-10
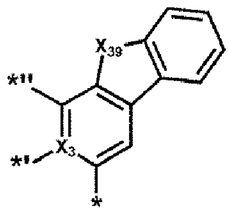
CY3-11
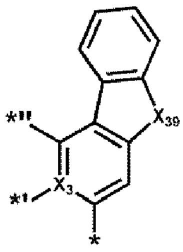
CY3-12
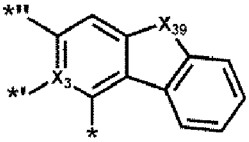
CY3-13
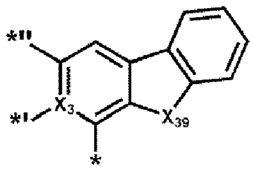
CY3-14

In Formulae CY3-1 to 3-14,

$X_3$ is as defined herein,
X39 may be C(R39a)(R39b), N[(L39)b39-(R39)c39], O, S, or Si(R39a)(R39b), $L_{39}$ is as defined in connection with $L_3$, b39 and c39 are each as defined in connection with b3 and c3,
$R_{39}$, $R_{39a}$, and $R_{39b}$ are each as defined in connection with $R_3$,
* indicates a binding site to $T_2$ in Formula 1,
*' indicates a binding site to M in Formula 1,
*" indicates a binding site to $T_1$ in Formula 1.

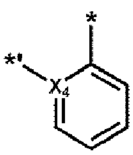
CY4-1
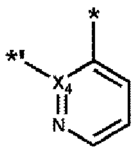
CY4-2
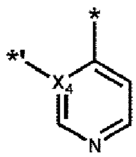
CY4-3
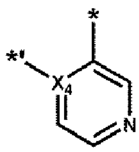
CY4-4
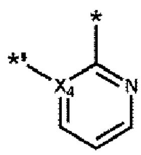
CY4-5
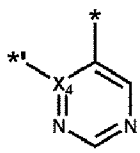
CY4-6
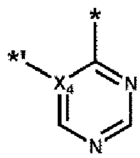
CY4-7
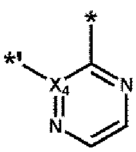
CY4-8
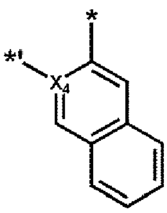
CY4-9
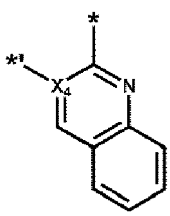
CY4-10
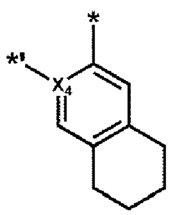
CY4-11
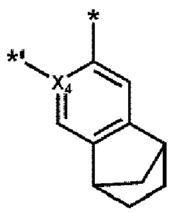
CY4-12
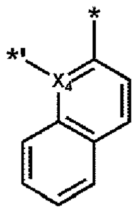
CY4-13
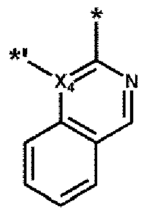
CY4-14

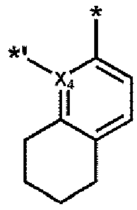
CY4-15

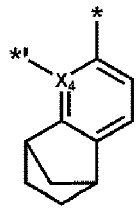
CY4-16

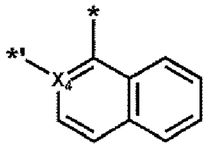
CY4-17

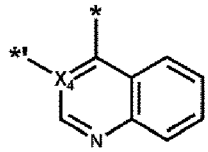
CY4-18

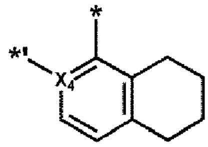
CY4-19

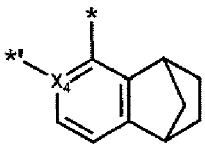
CY4-20

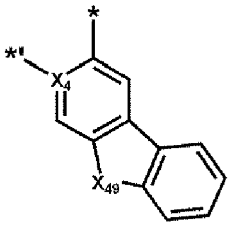
CY4-21

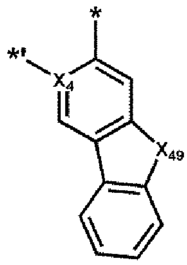
CY4-22

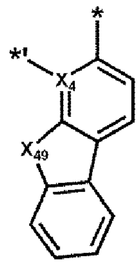
CY4-23

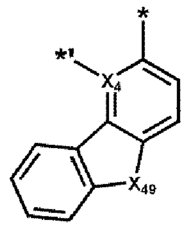
CY4-24

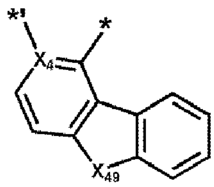
CY4-25

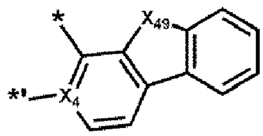
CY4-26

In Formulae CY4-1 to 4-26,

$X_4$ is as defined herein,
$X_{49}$ may be $C(R_{49a})(R_{49b})$, $N[(L_{49})_{b49}\text{-}(R_{49})_{c49}]$, O, S, or $Si(R_{49a})(R_{49b})$,
$L_{49}$ is as defined in connection with $L_4$,
b49 and c49 are each as defined in connection with b4 and c4,
$R_{49}$, $R_{49a}$, and $R_{49b}$ are each as defined in connection with $R_4$,
* indicates a binding site to $T_2$ in Formula 1, and
*' indicates a binding site to M in Formula 1.

In one or more embodiments,

the group represented by

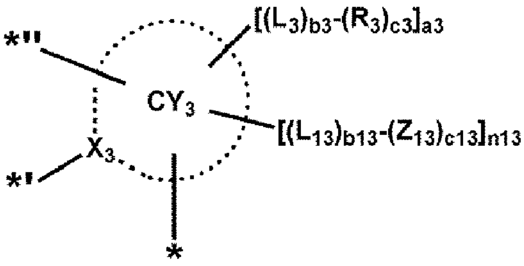

in Formula 1 may be a group represented by one of Formulae CY3(1) to CY3(12) or CY3(1)F to CY3(12)F, and the group represented by

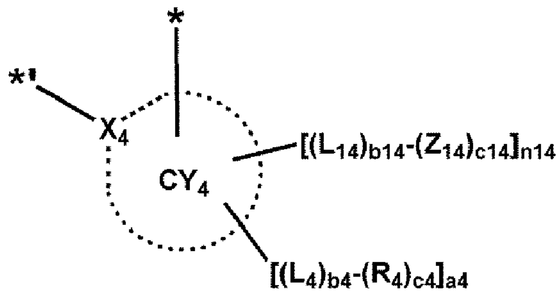

in Formula 1 may be a group represented by one of Formulae CY4(1) to CY4(16) or CY4(1)F to CY4(32)F.

In one or more embodiments,

the group represented by

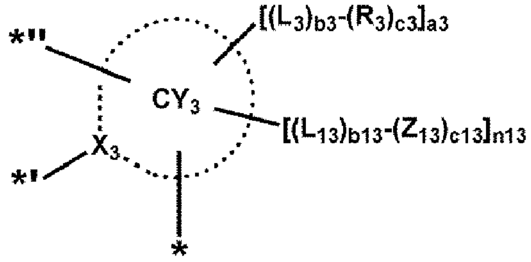

in Formula 1 may be a group represented by one of Formulae CY3(1) to CY3(12) or CY3(1)F to CY3(12)F, or the group represented by

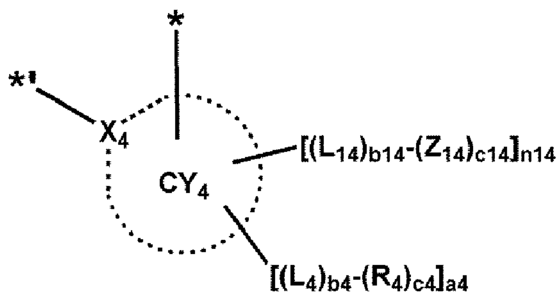

in Formula 1 may be a group represented by one of Formulae CY4(1) to CY4(16) or CY4(1)F to CY4(32)F.

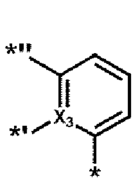
CY3(1)

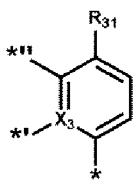
CY3(2)

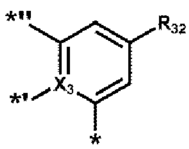
CY3(3)

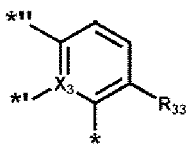
CY3(4)

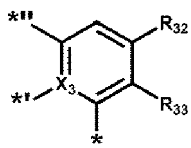
CY3(5)

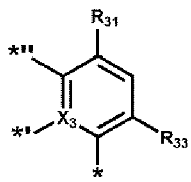
CY3(6)

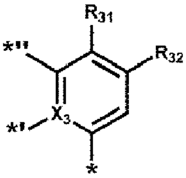
CY3(7)

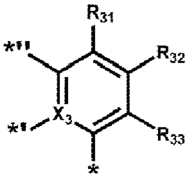
CY3(8)

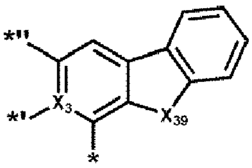
CY3(9)

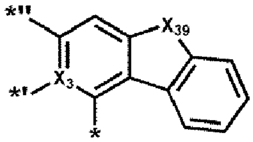
CY3(10)

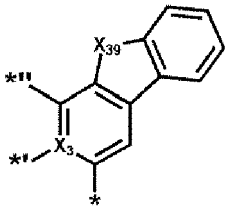
CY3(11)

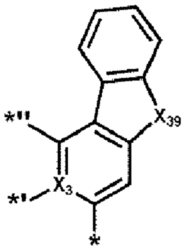
CY3(12)

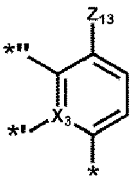
CY3(1)F

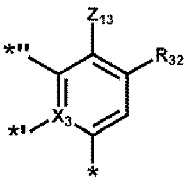
CY3(2)F

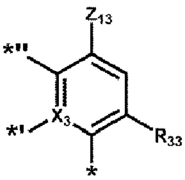
CY3(3)F

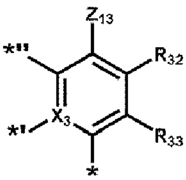
CY3(4)F

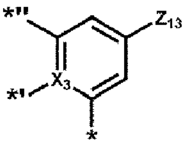
CY3(5)F

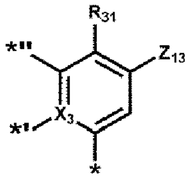
CY3(6)F

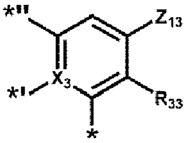
CY3(7)F

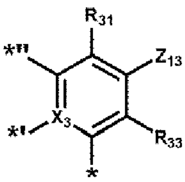
CY3(8)F

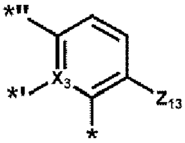
CY3(9)F

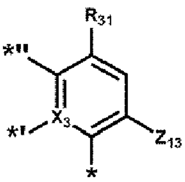
CY3(10)F

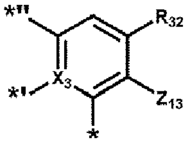
CY3(11)F

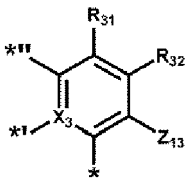
CY3(12)F

In Formulae CY3(1) to CY3(12) and CY3(1)F to CY3(12)F,

$X_3$ and $Z_{13}$ are each as defined herein,
$R_{31}$ to $R_{33}$ are each as defined in connection with $R_3$, provided that each of $R_{31}$ to $R_{33}$ may not be hydrogen,
$X_{39}$ may be $C(R_{39a})(R_{39b})$, $N[(L_{39})_{b39}\text{-}(R_{39})_{c39}]$, O, S, or $Si(R_{39a})(R_{39b})$,
$L_{39}$ is as defined in connection with $L_3$,
b39 and c39 are each as defined in connection with b3 and c3,
$R_{39}$, $R_{39a}$, and $R_{39b}$ are each as defined in connection with $R_3$,
* indicates a binding site to $T_2$ in Formula 1,
*' indicates a binding site to M in Formula 1, and
*" indicates a binding site to $T_1$ in Formula 1.

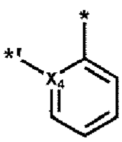
CY4(1)

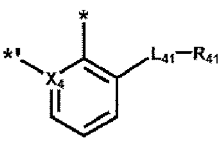
CY4(2)

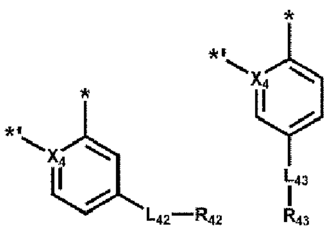
CY4(3) CY4(4)

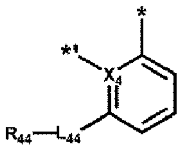
CY4(5)

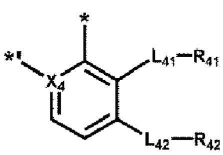
CY4(6)

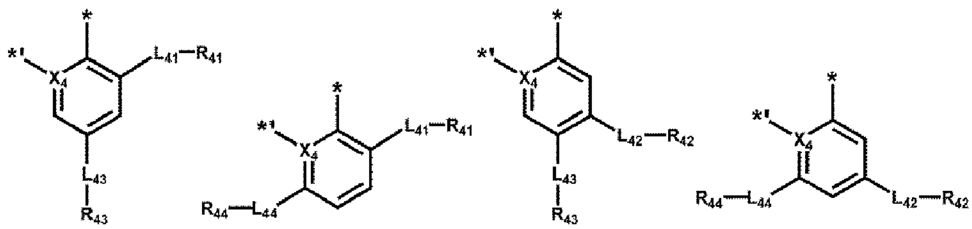

CY4(7) CY4(8) CY4(9) CY4(10)

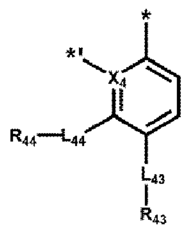

CY4(11)

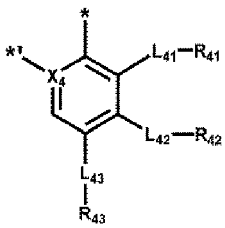

CY4(12)

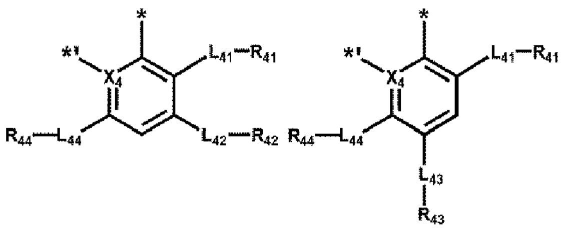

CY4(13) CY4(14)

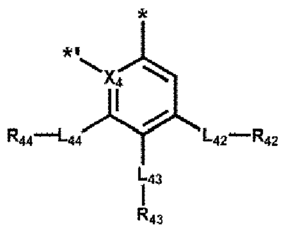

CY4(15)

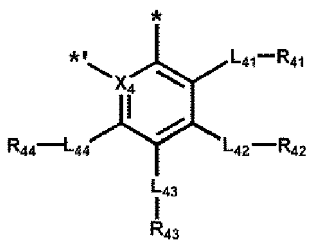

CY4(16)

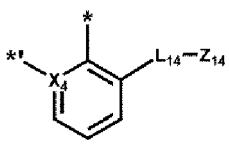

CY4(1)F

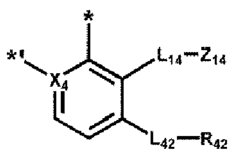

CY4(2)F

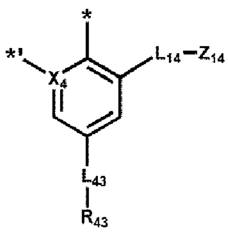

CY4(3)F

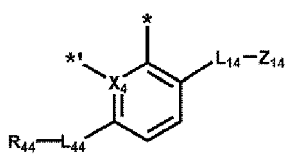

CY4(4)F

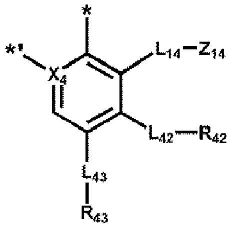

CY4(5)F

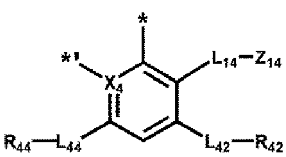

CY4(6)F

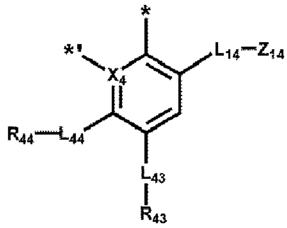

CY4(7)F

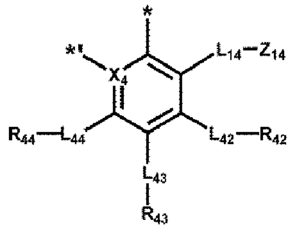

CY4(8)F

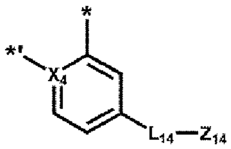
CY4(9)F

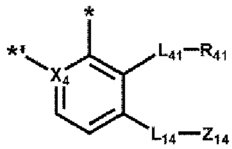
CY4(10)F

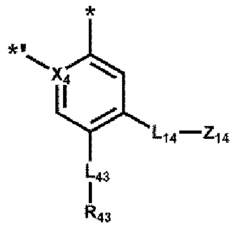
CY4(11)F

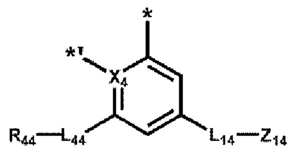
CY4(12)F

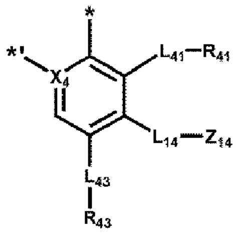
CY4(13)F

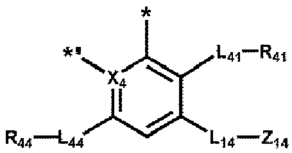
CY4(14)F

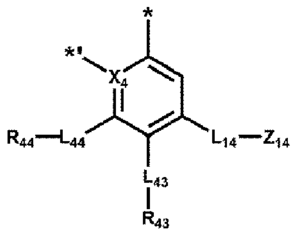
CY4(15)F

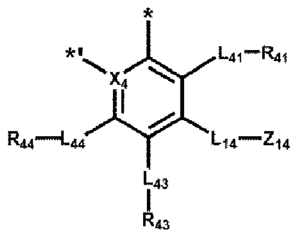
CY4(16)F

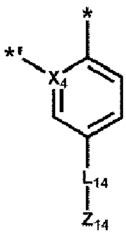
CY4(17)F

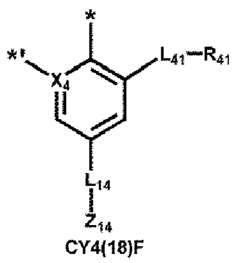
CY4(18)F

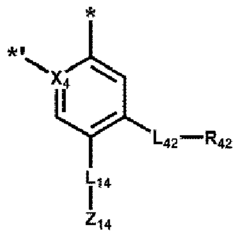
CY4(19)F

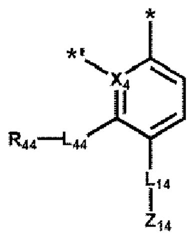
CY4(20)F

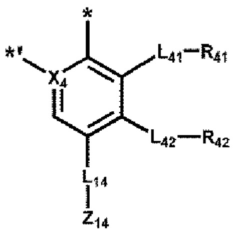
CY4(21)F

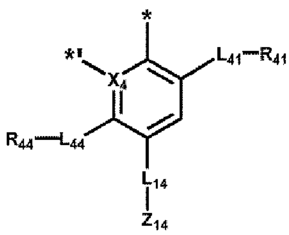
CY4(22)F

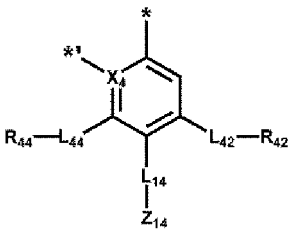
CY4(23)F

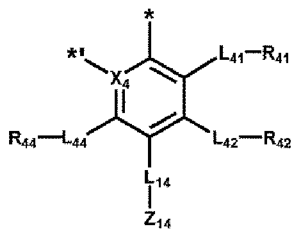
CY4(24)F

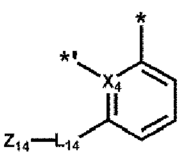
CY4(25)F

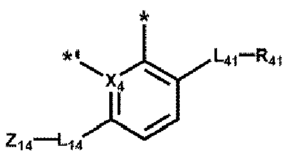
CY4(26)F

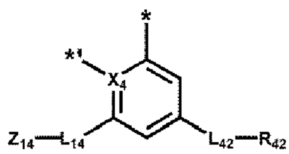
CY4(27)F

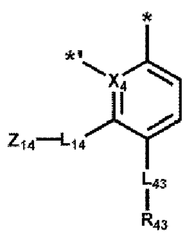
CY4(28)F

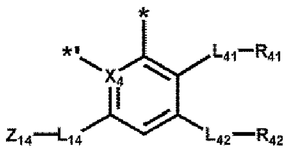
CY4(29)F

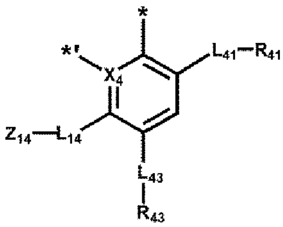
CY4(30)F

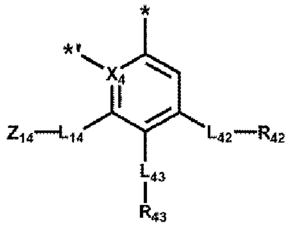
CY4(31)F

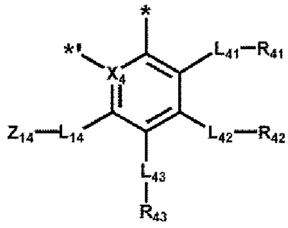
CY4(32)F

In Formulae CY4(1) to CY4(16) and CY4(1)F to CY4(32)F,

$X_4$, $L_{14}$, and $Z_{14}$ are each as defined herein,
$L_{41}$ to $L_{44}$ are each as defined in connection with $L_4$,
$R_{41}$ to $R_{44}$ are each as defined in connection with $R_4$, provided that each of $R_{41}$ to $R_{44}$ may not be hydrogen,
* indicates a binding site to $T_2$ in Formula 1, and
*' indicates a binding site to M in Formula 1.

In one or more embodiments, the organometallic compound represented by Formula 1 may satisfy at least one of Condition 3-1 and Condition 4-1:

Condition 3-1
the group represented by

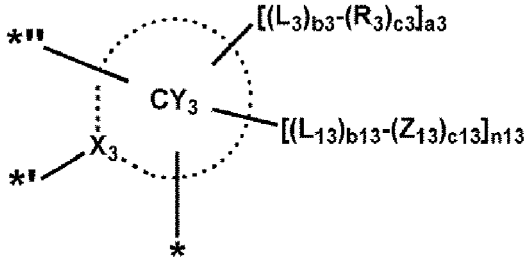

in Formula 1 is a group represented by one of Formulae CY3(1)F to CY3(12)F
Condition 4-1
the group represented by

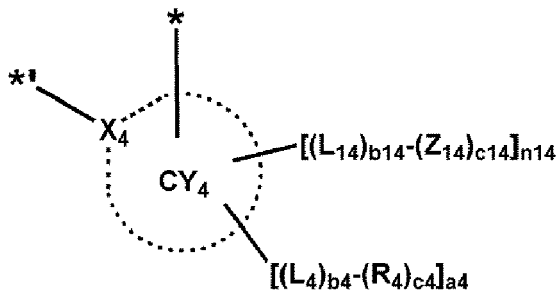

in Formula 1 is a group represented by one of Formulae CY4(1)F to CY4(32)F

The organometallic compound represented by Formula 1 may be represented by Formula 1A:

Formula 1A

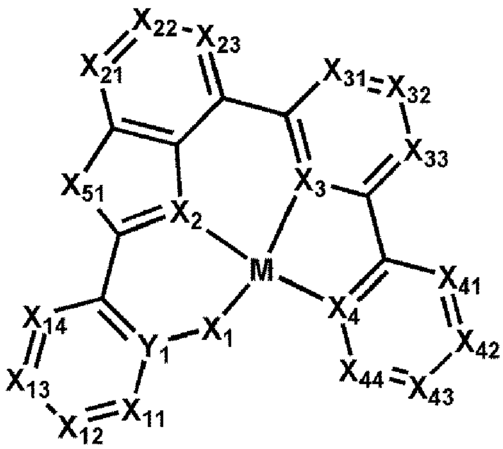

In Formula 1A,

M, $X_1$ to $X_4$, $Y_1$, and $X_{51}$ are each as defined herein,
$X_{11}$ may be $C(R_{11})$ or N, $X_{12}$ may be $C(R_{12})$ or N, $X_{13}$ may be $C(R_{13})$ or N, $X_{14}$ may be $C(R_{14})$ or N, $R_{11}$ to $R_{14}$ are each as defined in connection with $R_1$,
$X_{21}$ may be $C(R_{21})$ or N, $X_{22}$ may be $C(R_{22})$ or N, $X_{23}$ may be $C(R_{23})$ or N, $R_{21}$ to $R_{23}$ are each as defined in connection with $R_2$,
$X_{31}$ may be $C(R_{31})$, $C(Z_{13})$ or N, $X_{32}$ may be $C(R_{32})$, $C(Z_{13})$, or N, $X_{33}$ may be $C(R_{33})$, $C(Z_{13})$ or N, $R_{31}$ to $R_{33}$ are each as defined in connection with $R_3$, $Z_{13}$ is as defined herein,
$X_{41}$ may be $C-[(L_{41})-(R_{41})]$, $C-[(L_{14})-(Z_{14})]$, or N, $X_{42}$ may be $C-[(L_{42})-(R_{42})]$, $C-[(L_{14})-(Z_{14})]$, or N, $X_{43}$ may be $C-[(L_{43})-(R_{43})]$, $C-[(L_{14})-(Z_{14})]$, or N, $X_{44}$ may be $C-[(L_{44})-(R_{44})]$, $C-[(L_{14})-(Z_{14})]$, or N, $L_{41}$ to $L_{44}$ are each as defined in connection with $L_4$, $R_{41}$ to $R_{44}$ are each as defined in connection with $R_4$, and $L_{14}$ and $Z_{14}$ are each as defined herein,
two or more of $R_{11}$ to $R_{14}$ may optionally be linked to form a $C_5$-$C_{30}$ carbocyclic group unsubstituted or substituted with at least one $R_{10a}$, or a C1-$C_{30}$ heterocyclic group unsubstituted or substituted with at least one $R_{10a}$,
two or more of $R_{21}$ to $R_{23}$ may optionally be linked to form a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$,
two or more of $R_{31}$ to $R_{33}$ may optionally be linked to form a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$, and
two or more of $R_{41}$ to $R_{44}$ may optionally be linked to form a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$. $R_{10a}$ may be as defined in connection with $R_1$.

The organometallic compound represented by Formula 1A may satisfy at least one of Condition (1) to Condition (7):

Condition (1)
$X_{31}$ is $C(Z_{13})$

Condition (2)
$X_{32}$ is $C(Z_{13})$

Condition (3)
$X_{33}$ is $C(Z_{13})$

Condition (4)
$X_{41}$ is $C-[(L_{14})-(Z_{14})]$

Condition (5)
$X_{42}$ is $C-[(L_{14})-(Z_{14})]$

Condition (6)
$X_{43}$ is C-[($L_{14}$)-($Z_{14}$)]

Condition (7)
$X_{44}$ is C-[($L_{14}$)-($Z_{14}$)]

In one or more embodiments, $X_{51}$ in Formula 1A may be O, S, N-[$(L_7)_{b7}$-$(R_7)_{c7}$], C($R_7$)($R_8$), Si($R_7$)($R_8$), Ge($R_7$)($R_8$), or C(=O).

In one or more embodiments, $X_{51}$ in Formula 1A may be N-[$(L_7)_{b7}$-$(R_7)_{c7}$].

In one or more embodiments, in Formula 1A, $X_{51}$ may be N-[$(L_7)_{b7}$-$(R_7)_{c7}$], $L_7$ may not be a single bond, c7 may be greater than or equal to 2, one of two or more $R_7$(s) may be a substituted or unsubstituted $C_4$-$C_{20}$ alkyl group (for example, a tert-butyl group, etc.), one of the remaining $R_7$ may be a substituted or unsubstituted phenyl group (for example, a phenyl group, a deuterated phenyl group, a ($C_1$-$C_{20}$ alkyl) phenyl group, etc.) or a substituted or unsubstituted biphenyl group (for example, a biphenyl group, a deuterated biphenyl group, or a ($C_1$-$C_{20}$ alkyl) biphenyl group, etc.)

In one or more embodiments, in Formula 1A, $X_{11}$ may be C($R_{11}$), $X_{13}$ may be C($R_{13}$), and $R_{11}$ and $R_{13}$ may each independently be a substituted or unsubstituted $C_4$-$C_{20}$ alkyl group.

In one or more embodiments, the organometallic compound represented by Formula 1A may satisfy at least one of Condition (1) to Condition (3).

In one or more embodiments, the organometallic compound represented by Formula 1A may satisfy at least one of Condition (4) to Condition (7).

The additional description regarding Formula 1A is the same as the description in connection with Formula 1.

In one or more embodiments, the group represented by

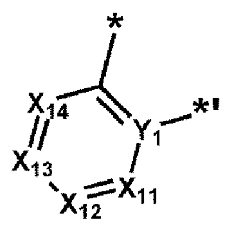

in Formula 1A may be a group represented by one of Formulae CY1(1) to CY1(22).

In one or more embodiments, the group represented by

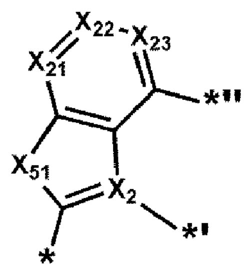

in Formula 1A may be a group represented by one of Formulae CY2(1) to CY2(20).

In one or more embodiments, the group represented by

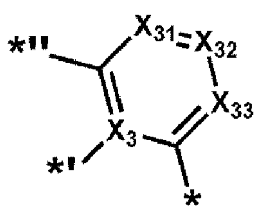

in Formula 1A may be a group represented by one of Formulae CY3(1) to CY3(12) or CY3(1)F to CY3(12)F.

In one or more embodiments, the group represented by

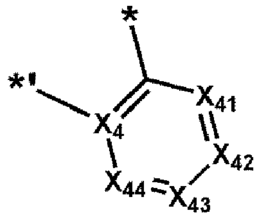

in Formula 1A may be a group represented by one of Formulae CY4(1) to CY4(16) or CY4(1)F to CY4(32)F.

In one or more embodiments, Formulae 1 and 1A may each include at least one deuterium.

In one or more embodiments, each of $L_1$, $L_2$, $R_1$, $R_2$, and $X_{51}$ in Formula 1 may not include a fluoro group (-F).

In one or more embodiments, each of $R_{11}$ to $R_{14}$, $R_{21}$ to $R_{23}$, and $X_{51}$ in Formula 1A may not include a fluoro group (-F).

In one or more embodiments, the organometallic compound may be one of Compounds 1 to 3:

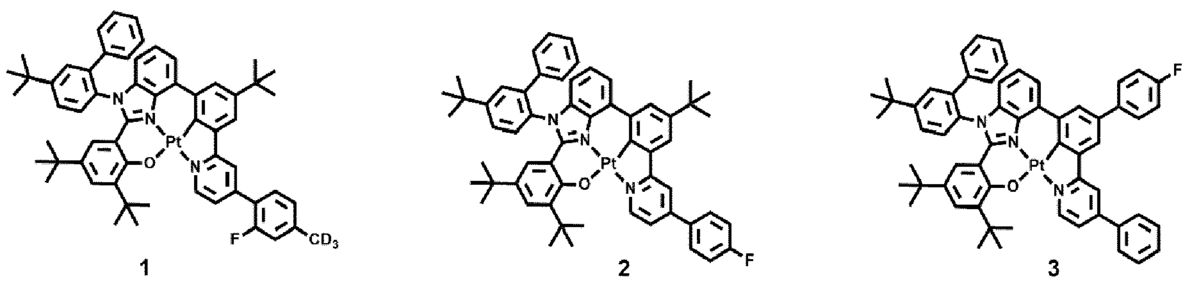

1 2 3

In Formula 1, $Z_{13}$ and $Z_{14}$ may each independently be a group represented by Formula 2, n13 and n14 may each independently be an integer from 0 to 20, and the sum of n13 and n14 may be 1 or greater. Thus, at least one of ring $CY_3$ and ring $CY_4$ in the organometallic compounds represented by Formula 1 may include a group represented by Formula 2. Furthermore, a group represented by Formula 2 may include ring $CY_{10}$ as defined in the present specification. Accordingly, as the organometallic compound represented by Formula 1 may maintain excellent electric characteristics and have a low Ts temperature or a low sublimation temperature at the same time, the electronic device, for example, an organic light-emitting device, using the organometallic compound may have excellent emission efficiency and lifespan characteristics at the same time.

Furthermore, each of ring $CY_1$, ring $CY_3$, and ring $CY_4$ in Formula 1 may not be a benzimidazole group. Accordingly, since the steric hindrance of a ligand surrounding the center metal M is improved, an electronic device, for example, an organic light-emitting device, including the organometallic compound may have an improved lifespan characteristic and a sharp electroluminescence peak.

For example, the highest occupied molecular orbital (HOMO) energy level, the lowest unoccupied molecular orbital (LUMO) energy level, the energy gap (eV), the lowest excitation singlet ($S_1$) energy level, and the lowest excited state triplet ($T_1$) energy level of Compounds 1 to 3 were calculated using a density functional theory (DFT) method of the Gaussian 09 program (structurally optimized at a level of B3LYP, 6-31G(d,p)). Evaluation results are shown in Table 1 below.

Table 1

| Compound No. | HOMO (eV) | LUMO (eV) | Energy gap (eV) | $S_1$ energy level (eV) | $T_1$ energy level (eV) |
|---|---|---|---|---|---|
| 1 | -4.602 | -1.688 | 2.914 | 2.444 | 2.293 |
| 2 | -4.656 | -1.734 | 2.921 | 2.443 | 2.302 |
| 3 | -4.746 | -1.791 | 2.954 | 2.474 | 2.326 |

From Table 1, it is confirmed that the organometallic compound represented by Formula 1 has such electric characteristics that are suitable for use as a dopant for an electronic device, for example, an organic light-emitting device.

Synthesis methods of the organometallic compound represented by Formula 1 may be recognizable by one of ordinary skill in the art by referring to Synthesis Examples provided below.

Accordingly, the organometallic compound represented by Formula 1 is suitable for use as a material for an organic layer of organic light-emitting device, for example, a dopant in an emission layer of the organic layer. Thus,

another aspect provides an organic light-emitting device including: a first electrode; a second electrode; and an organic layer between the first electrode and the second electrode and including an emission layer, and the organic layer includes at least one organometallic compound represented by Formula 1.

The organic light-emitting device may have, due to the inclusion of an organic layer including the organometallic compound represented by Formula 1, a low driving voltage, a high external quantum efficiency, a low roll-off ratio, and long lifespan.

The organometallic compound of Formula 1 may be used between a pair of electrodes of an organic light-emitting device. For example, the organometallic compound represented by Formula 1 may be included in the emission layer. In this regard, the organometallic compound may act as a dopant, and the emission layer may further include a host (that is, an amount of the organometallic compound represented by Formula 1 is smaller than an amount of the host). The emission layer may emit, for example, green light or blue light.

As used herein, the expression "(an organic layer) includes at least one of organometallic compounds" used herein may include a case in which "(an organic layer) includes identical organometallic compounds represented by Formula 1" and a case in which "(an organic layer) includes two or more different organometallic compounds represented by Formula 1".

For example, the organic layer may include, as the organometallic compound, only Compound 1. In this embodiment, Compound 1 may be included in the emission layer of the organic light-emitting device. In one or more embodiments, the organic layer may include, as the organometallic compound, Compound 1 and Compound 2. In this regard, Compound 1 and Compound 2 may be in an identical layer (for example, Compound 1 and Compound 2 both may be in an emission layer).

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

In one or more embodiments, in the organic light-emitting device, the first electrode is an anode, and the second electrode is a cathode, and the organic layer may further include a hole transport region located between the first electrode and the emission layer and an electron transport region located between the emission layer and the second electrode, and the hole transport region may include a hole injection layer, a hole transport layer, an electron blocking layer, a buffer layer, or a combination thereof, and the electron transport region may include a hole blocking layer, an electron transport layer, an electron injection layer, or a combination thereof.

The term "organic layer" as used herein refers to a single layer and/or a plurality of layers between the first electrode and the second electrode of the organic light-emitting device. The "organic layer" may include, in addition to an organic compound, an organometallic complex including a metal.

The FIGURE is a schematic cross-sectional view of an organic light-emitting device 10 according to one or more embodiments. Hereinafter, the structure of an organic light-emitting device according to one or more embodiments and a method of manufacturing an organic light-emitting device according to one or more embodiments of the present disclosure will be described in connection with the FIGURE. The organic light-emitting device 10 includes a first electrode 11, an organic layer 15, and a second electrode 19, which are sequentially stacked.

A substrate may be additionally located under the first electrode 11 or above the second electrode 19. For use as the substrate, any substrate that is used in organic light-emitting devices available in the art may be used, and the substrate may be a glass substrate or a transparent plastic substrate, each having excellent mechanical strength, thermal stability, transparency, surface smoothness, ease of handling, and water resistance.

In one or more embodiments, the first electrode 11 may be formed by depositing or sputtering a material for forming the first electrode 11 on the substrate. The first electrode 11 may be an anode. The material for forming the first electrode 11 may include materials with a high work function to facilitate hole injection. The first electrode 11 may be a reflective electrode, a semi-transmissive electrode, or a transmissive electrode. The material for forming the first electrode 11 may be indium tin oxide (ITO), indium zinc oxide (IZO), tin oxide ($SnO_2$), or zinc oxide (ZnO). In one or more embodiments, the material for forming the first electrode 11 may be metal, such as magnesium (Mg), silver (Ag), aluminum (Al), aluminum-lithium (Al-Li), calcium (Ca), magnesium-indium (Mg-In), or magnesium-silver (Mg-Ag).

The first electrode 11 may have a single-layered structure or a multi-layered structure including two or more layers. For example, the first electrode 11 may have a three-layered structure of ITO/Ag/ITO.

The organic layer 15 is located on the first electrode 11.

The organic layer 15 may include a hole transport region, an emission layer, and an electron transport region.

The hole transport region may be located between the first electrode 11 and the emission layer.

The hole transport region may include a hole injection layer, a hole transport layer, an electron blocking layer, a buffer layer, or a combination thereof.

The hole transport region may include only either a hole injection layer or a hole transport layer. In one or more embodiments, the hole transport region may have a hole injection layer/hole transport layer structure or a hole injection layer/hole transport layer/electron blocking layer structure, wherein, for each structure, each layer is sequentially stacked

in this stated order from the first electrode 11.

When the hole transport region includes a hole injection layer, the hole injection layer may be formed on the first electrode 11 by using one or more suitable methods, for example, vacuum deposition, spin coating, casting, and/or Langmuir-Blodgett (LB) deposition.

When a hole injection layer is formed by vacuum deposition, the deposition conditions may vary depending on a material that is used to form the hole injection layer, and the structure and thermal characteristics of the hole injection layer. For example, the deposition conditions may include a deposition temperature of about 100 °C to about 500 °C, a vacuum pressure of about $10^{-8}$ torr to about $10^{-3}$ torr, and a deposition rate of about 0.01 Å/sec to about 100 Å/sec.

When the hole injection layer is formed using spin coating, coating conditions may vary according to the material used to form the hole injection layer, and the structure and thermal properties of the hole injection layer. For example, a coating speed may be from about 2,000 revolutions per minute (rpm) to about 5,000 rpm, and a temperature at which a heat treatment is performed to remove a solvent after coating may be from about 80 °C to about 200 °C.

The conditions for forming the hole transport layer and the electron-blocking layer may be the same as the conditions for forming the hole injection layer.

The hole transport region may include 4,4',4"-tris(3-methylphenylphenylamino)triphenylamine (m-MTDATA), 4,4',4"-tris(N,N-diphenylamino)triphenylamine (TDATA), 4,4',4"-tris{N-(2-naphthyl)-N-phenylamino}-triphenylamine (2-TNATA), N,N'-di(naphthalene-1-yl)-N,N'-diphenyl-benzidine (NPB), β-NPB, N,N'-bis(3-methylphenyl)-N,N'-diphenyl-[1,1-biphenyl]-4,4'-diamine (TPD), spiro-TPD, spiro-NPB, methylated NPB, 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201 below, a compound represented by Formula 202 below, or a combination thereof:

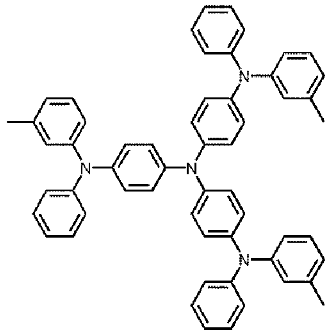

m-MTDATA

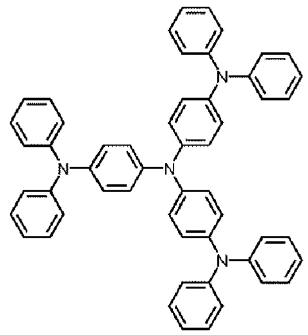

TDATA

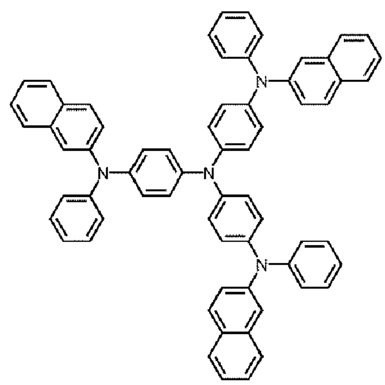

2-TNATA

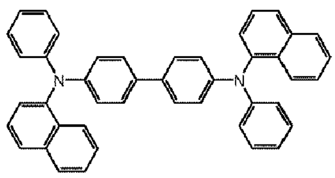

NPB

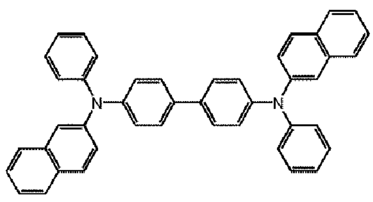

β-NPB

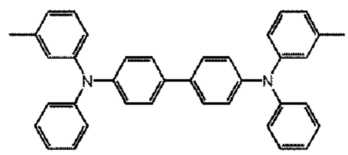

TPD

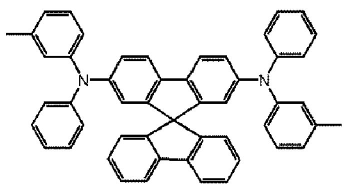

Spiro-TPD

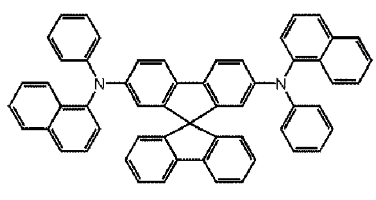

Spiro-NPB

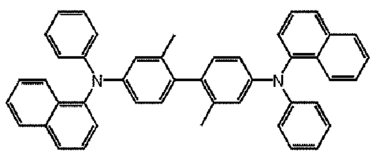

methylated NPB

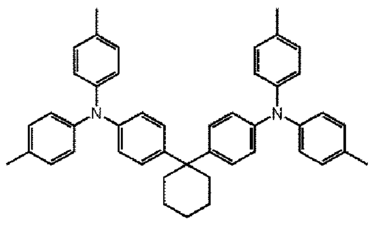

TAPC

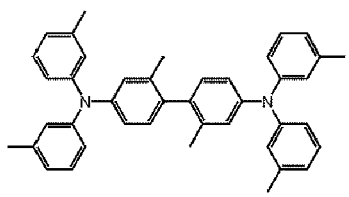

HMTPD

Formula 201

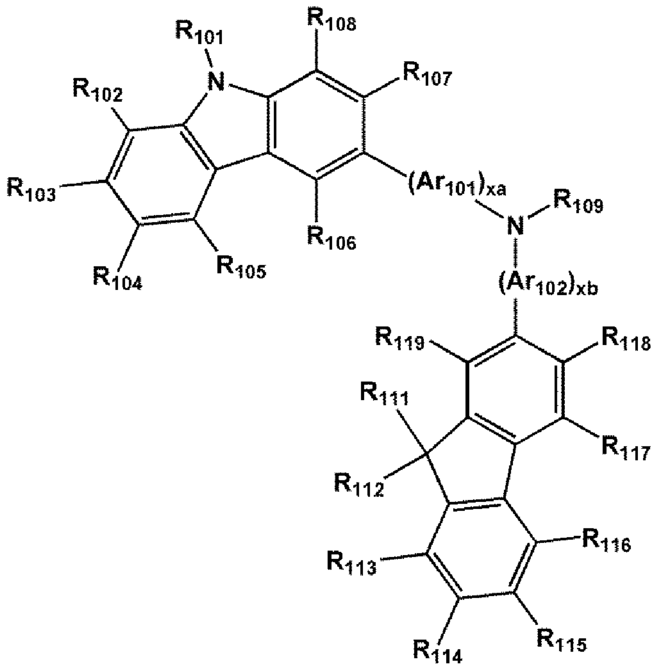

Formula 202

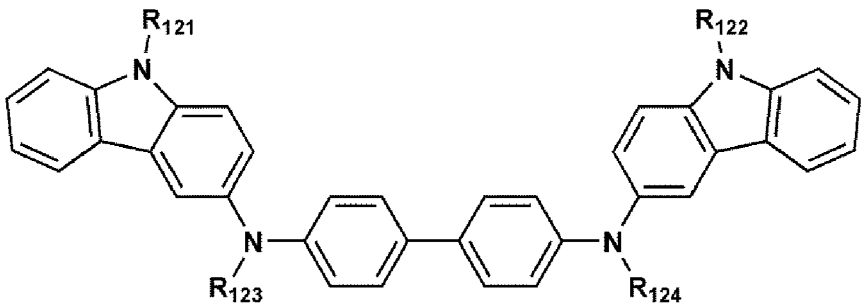

$Ar_{101}$ and $Ar_{102}$ in Formula 201 may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a C1-$C_{10}$ heterocycloalkyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a

$C_1$-$C_{60}$ heteroarylthio group, a monovalent non-aromatic condensed polycyclic group, a monovalent non-aromatic condensed heteropolycyclic group, or a combination thereof.

xa and xb in Formula 201 may each independently be an integer from 0 to 5, or xa and xb in Formula 201 may each independently be 0, 1, or 2. For example, in one or more embodiments, xa may be 1 and xb may be 0.
$R_{101}$ to $R_{108}$, $R_{111}$ to $R_{119}$, and $R_{121}$ to $R_{124}$ in Formulae 201 and 202 may each independently be:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group (for example, a methyl group, an ethyl group, a propyl group, a butyl group, pentyl group, a hexyl group, etc.), or a $C_1$-$C_{10}$ alkoxy group (for example, a methoxy group, an ethoxy group, a propoxy group, a butoxy group, a pentoxy group, etc.);
a $C_1$-$C_{10}$ alkyl group or a $C_1$-$C_{10}$ alkoxy group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof; or

a phenyl group, a naphthyl group, an anthracenyl group, a fluorenyl group, or a pyrenyl group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group or a $C_1$-$C_{10}$ alkoxy group, or a combination thereof.
$R_{109}$ in Formula 201 may be a phenyl group, a naphthyl group, an anthracenyl group, or a pyridinyl group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, an anthracenyl group, a pyridinyl group, or a combination thereof.

In one embodiment, the compound represented by Formula 201 may be represented by Formula 201A:

Formula 201A

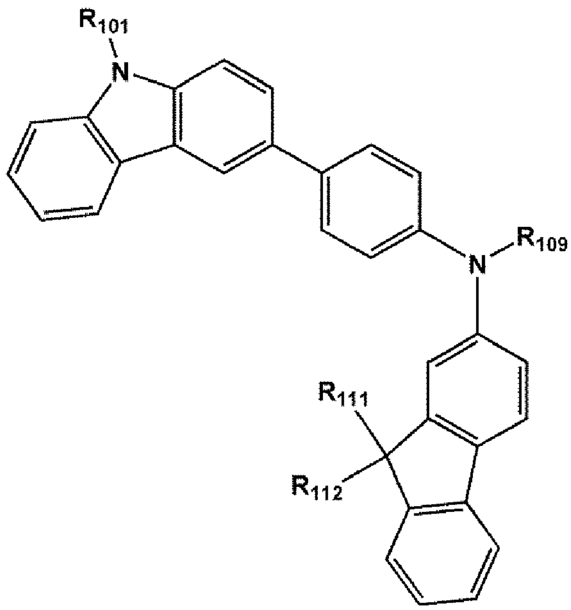

$R_{101}$, $R_{111}$, $R_{112}$, and $R_{109}$ in Formula 201A may be understood by referring to the description provided herein.
For example, the hole transport region may include one of Compounds HT1 to HT20 or a combination thereof:

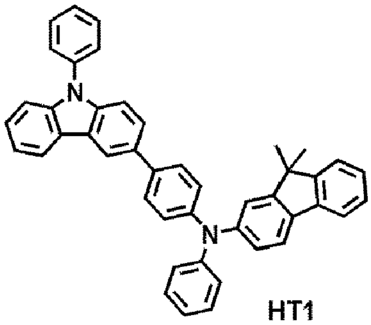
HT1

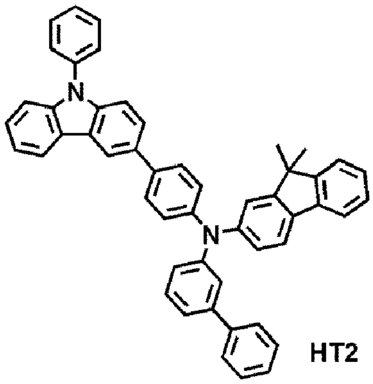
HT2

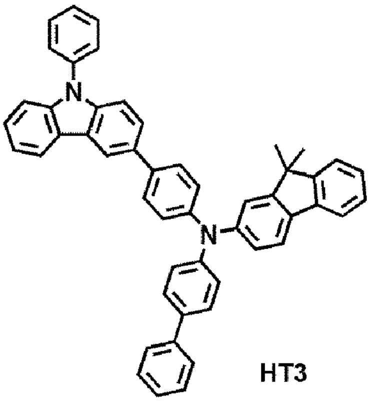
HT3

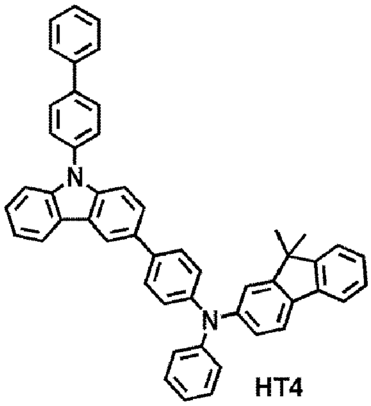
HT4

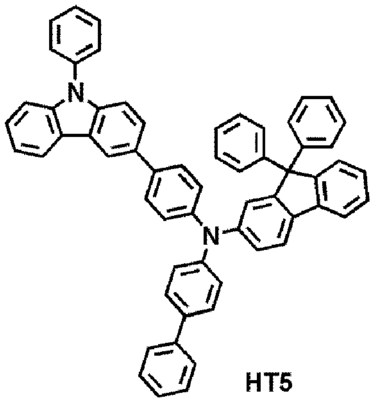
HT5

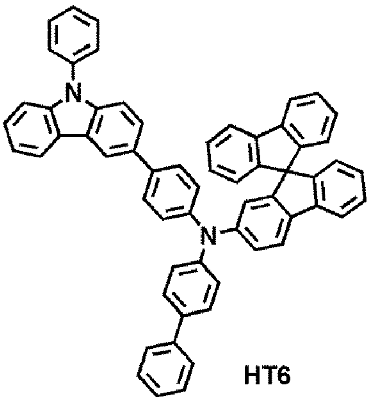
HT6

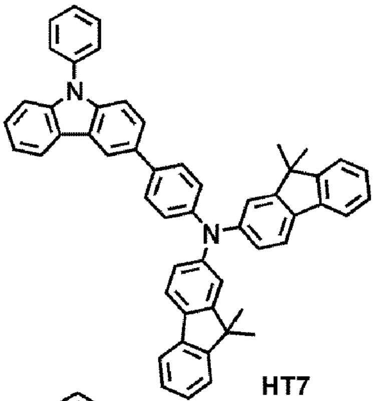
HT7

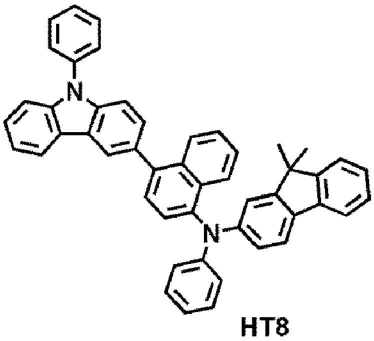
HT8

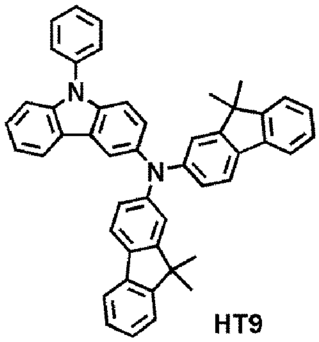
HT9

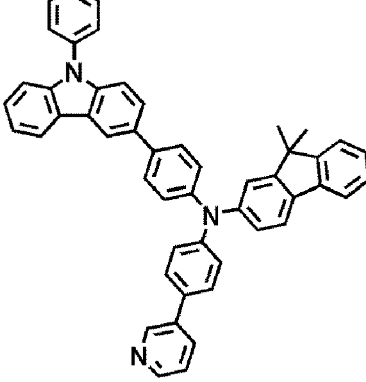
HT10

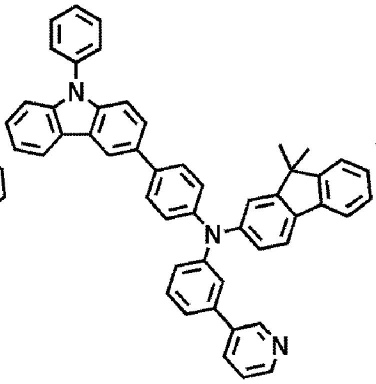
HT11

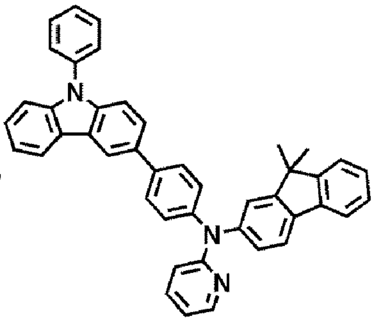
HT12

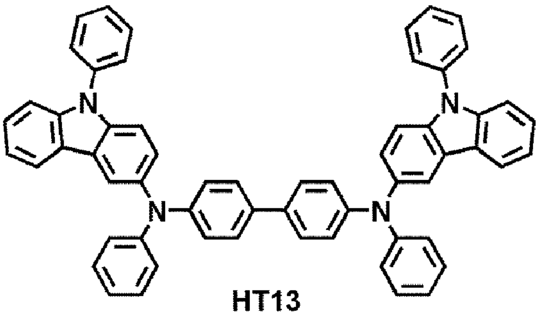

HT13

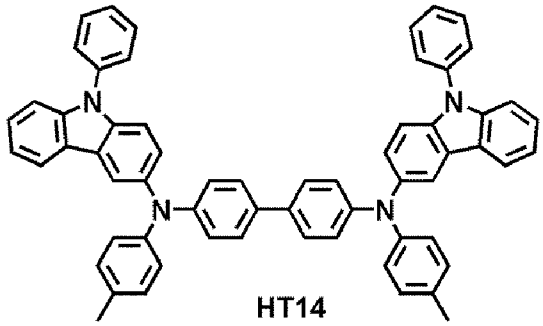

HT14

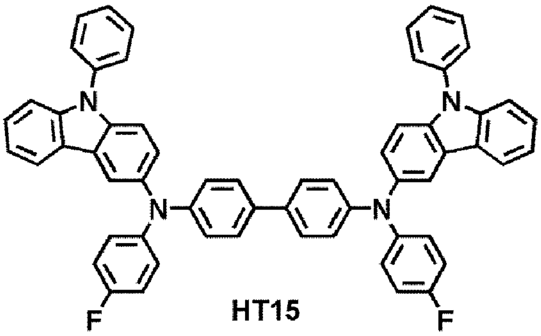

HT15

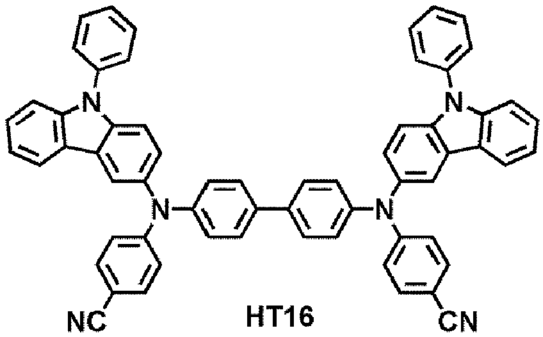

HT16

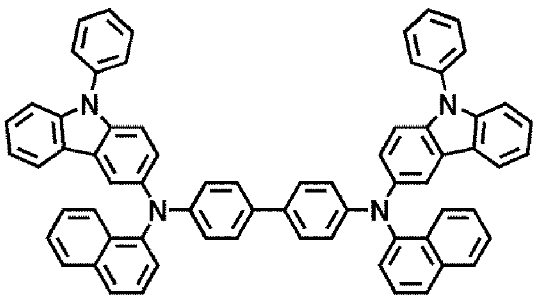

HT17

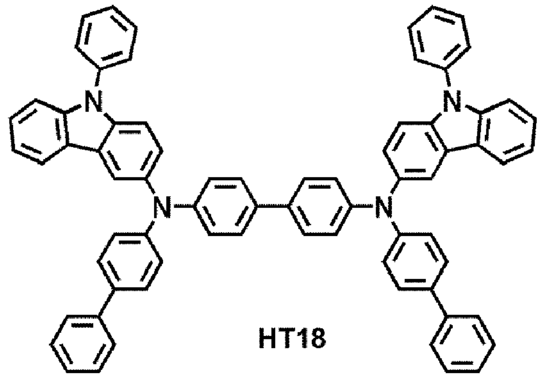

HT18

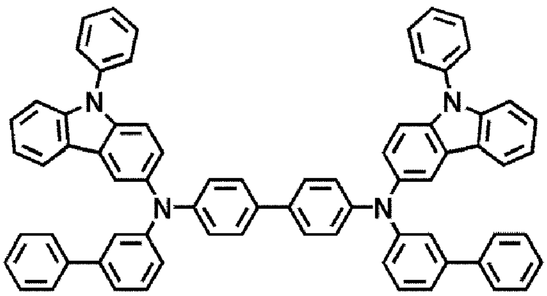

HT19

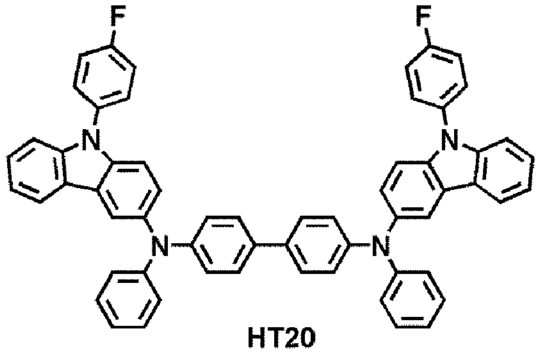

HT20

A thickness of the hole transport region may be in the range of about 100 Å to about 10,000 Å, for example, about 100 Å to about 1,000 Å. When the hole transport region includes at least one of a hole injection layer and a hole transport layer, a thickness of the hole injection layer may be in a range of about 100 Å to about 10,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection layer and the hole transport layer are within these ranges, satisfactory hole-transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may include a quinone derivative, a metal oxide, a cyano group-containing compound, or a combination thereof. For example, the p-dopant may be: a quinone derivative such as tetracyanoquinodimethane (TCNQ), 2,3,5,6-tetrafluoro-tetracyano-1,4-benzoquinodimethane (F4-TCNQ), or F6-TCNNQ; metal oxide, such as tungsten oxide and molybdenum oxide; a cyano group-containing compound, such as Compound HT-D1; or a combination thereof.

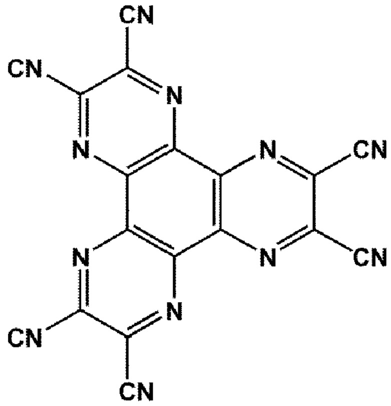
HT-D1

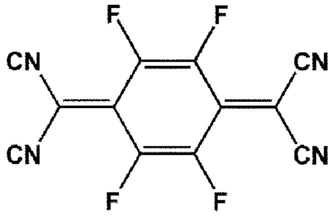
F4-TCNQ

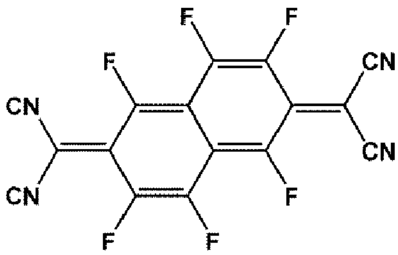
F6-TCNNQ

The hole transport region may include a buffer layer.

Also, the buffer layer may compensate for an optical resonance distance according to a wavelength of light emitted from the emission layer, and thus, the efficiency of a formed organic light-emitting device may be improved.

Meanwhile, when the hole transport region includes an electron blocking layer, a material for forming the electron blocking layer may include a material that is used in the hole transport region as described above, a host material described below, or a combination thereof. For example, when the hole transport region includes an electron blocking layer, mCP described below or a combination may be used as the material for forming the electron blocking layer.

Then, an emission layer may be formed on the hole transport region by vacuum deposition, spin coating, casting, LB deposition, or the like. When the emission layer is formed by vacuum deposition or spin coating, the deposition or coating conditions may be similar to those applied in forming the hole injection layer although the deposition or coating conditions may vary according to a material that is used to form the emission layer.

The emission layer may include a host and a dopant, and the dopant may include the organometallic compound represented by Formula 1 as described herein.

The host may include 1,3,5-tris(N-phenylbenzimidazole-2-yl)benzene (TPBi), 3-tert-butyl-9,10-di-2-naphthylanthracene (TBADN), 9,10-di(naphthalene-2-yl)anthracene (ADN) (also referred to as "DNA"), 4,4'-bis(N-carbazolyl)-1,1'-biphenyl (CBP), 4,4'-bis(9-carbazolyl)-2,2'-dimethyl-biphenyl (CDBP), 1,3,5-tris(carbazol-9-yl) benzene (TCP), 1,3-bis(carbazol-9-yl)benzene (mCP), Compound H50, Compound H51, Compound H52, or a combination thereof:

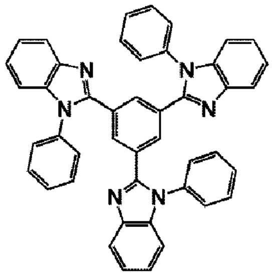

TPBi

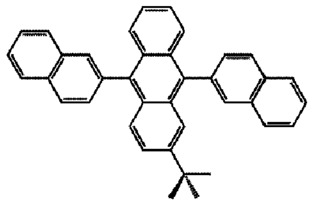

TBADN

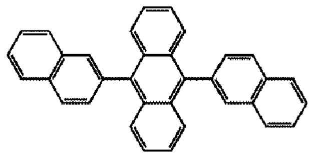

ADN

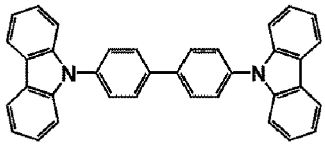

CBP

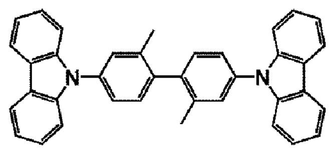

CDBP

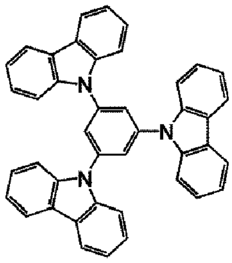

TCP

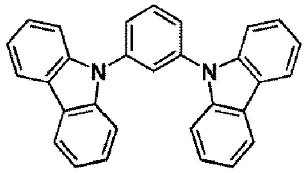

mCP

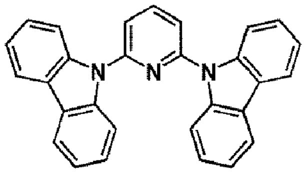

H50

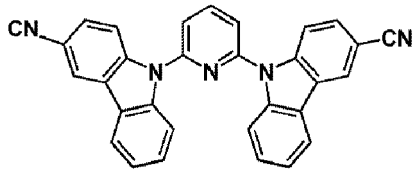

H51

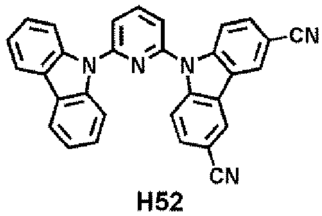

H52

When the organic light-emitting device is a full-color organic light-emitting device, the emission layer may be patterned into a red emission layer, a green emission layer, and/or a blue emission layer. In one or more embodiments, due to a stacked structure including a red emission layer, a green emission layer, and/or a blue emission layer, the emission layer may emit white light.

When the emission layer includes a host and a dopant, an amount of the dopant may be in a range of about 0.01 parts by weight to about 15 parts by weight based on 100 parts by weight of the host.

A thickness of the emission layer may be in a range of about 100 Å to about 1,000 Å, for example, about 200 Å to about 600 Å. When the thickness of the emission layer is within these ranges, excellent light-emission characteristics may be obtained without a substantial increase in driving voltage.

Then, an electron transport region may be located on the emission layer.

The electron transport region may include a hole blocking layer, an electron transport layer, an electron injection layer, or a combination thereof.

For example, the electron transport region may have a hole blocking layer/electron transport layer/electron injection layer structure or an electron transport layer/electron injection layer structure. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer.

When the electron transport region includes a hole blocking layer, the hole blocking layer may include, for

example, 2,9-dimethyl-4,7-diphenyl-1,10-phenanthroline (BCP), 4,7-diphenyl-1,10-phenanthroline (Bphen), bis(2-methyl-8-quinolinolato-N1,O8)-(1,1'-biphenyl-4-olato)aluminum (BAlq), or a combination thereof:

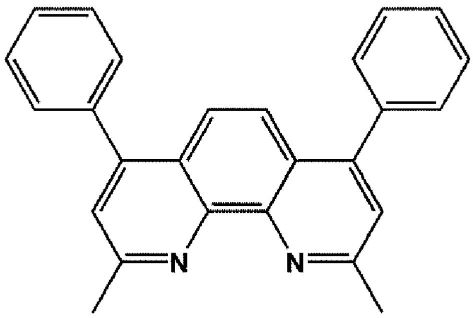

BCP

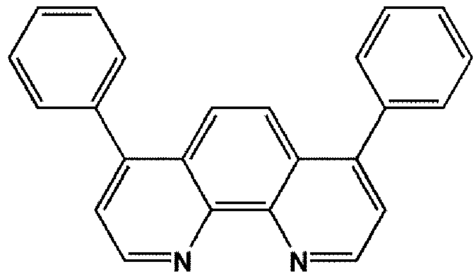

Bphen

A thickness of the hole blocking layer may be in a range of about 20 Å to about 1,000 Å, for example, about 30 Å to about 600 Å. When the thickness of the hole-blocking layer is within these ranges, excellent hole-blocking characteristics may be obtained without a substantial increase in driving voltage.

The electron transport layer may include BCP, Bphen, TPBi, $Alq_3$, Balq, TAZ, NTAZ, or a combination thereof:

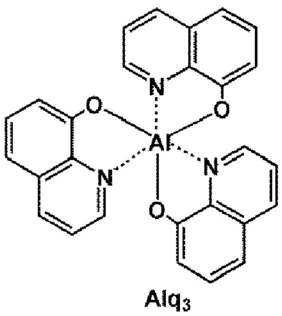

$Alq_3$

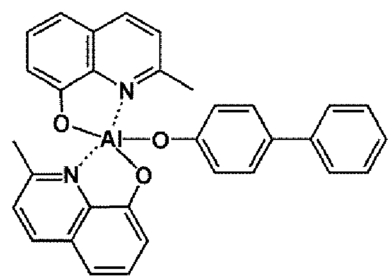

BAlq

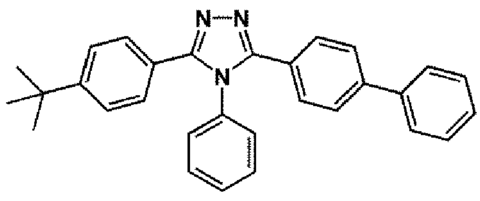

TAZ

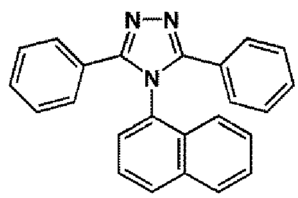

NTAZ

In one or more embodiments, the electron transport layer may include one of Compounds ET1 to ET25 or a combination thereof:

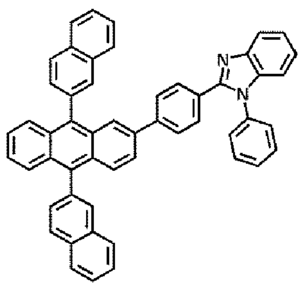

ET1

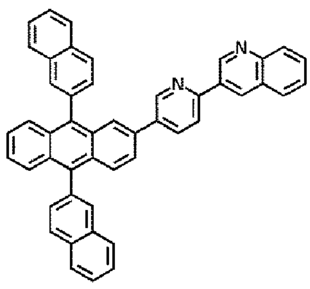

ET2

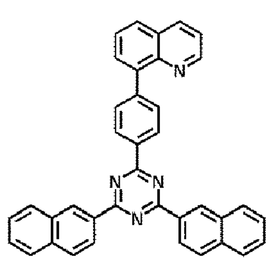

ET3

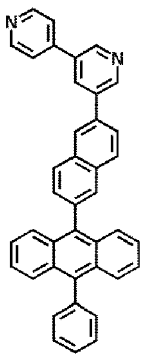

ET4

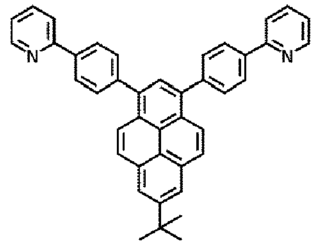

ET5

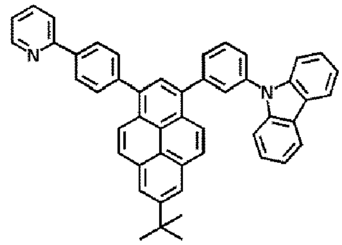

ET6

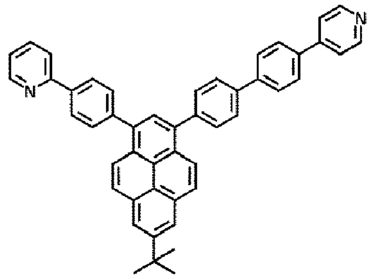

ET7

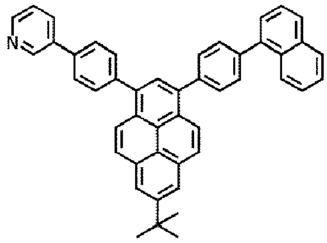

ET8

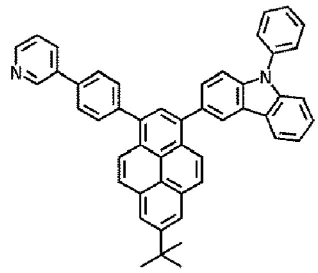

ET9

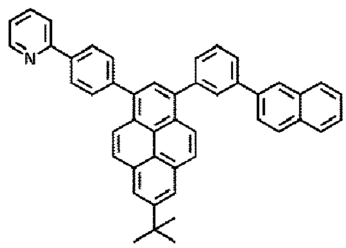

ET10

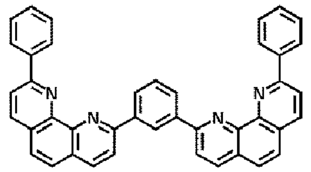

ET11

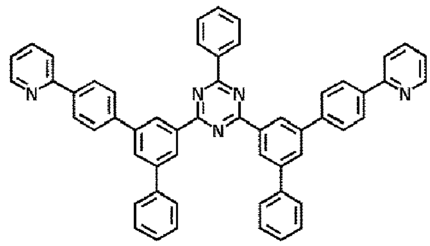

ET12

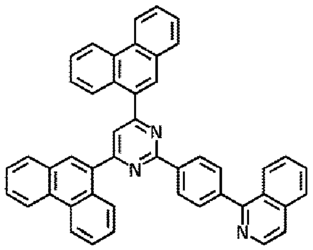

ET13

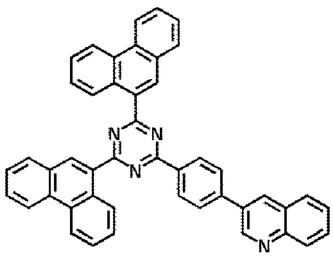

ET14

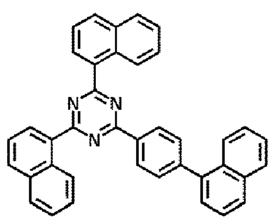

ET15

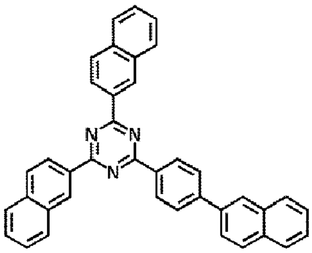

ET16

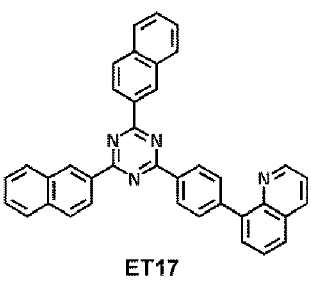

ET17

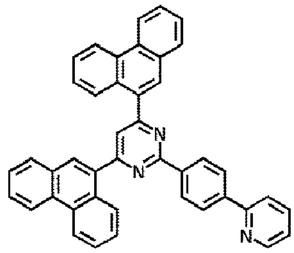

ET18

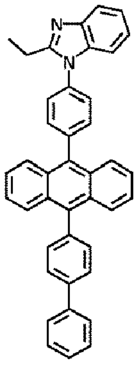

**ET19**

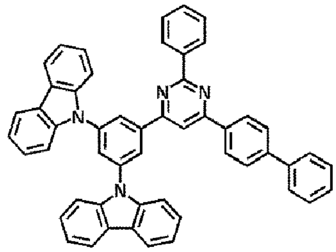

**ET20**

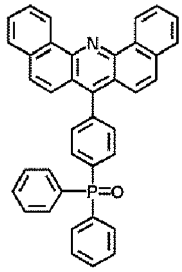

**ET21**

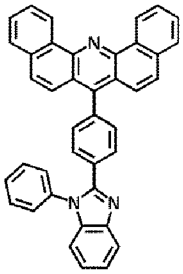

**ET22**

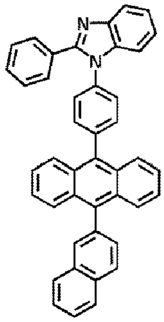

**ET23**

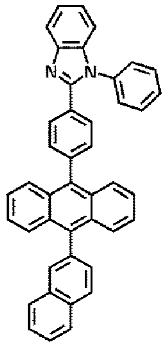

**ET24**

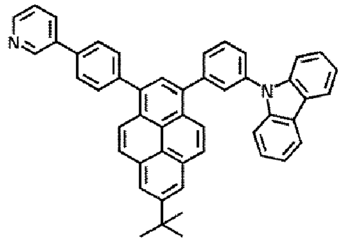

**ET25**

A thickness of the electron transport layer may be in the range of about 100 Å to about 1,000 Å, for example, about 150 Å to about 500 Å. When the thickness of the electron transport layer is within the range described above, the electron transport layer may have satisfactory electron-transporting characteristics without a substantial increase in driving voltage.

The electron transport layer may include a metal-containing material in addition to the material as described above.

The metal-containing material may include a Li complex. The Li complex may include, for example, Compound ET-D1 or ET-D2:

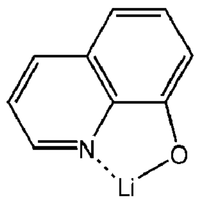

ET-D1

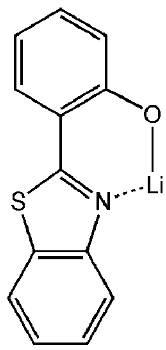

ET-D2

The electron transport region may include an electron injection layer that promotes the flow of electrons from the second electrode 19 thereinto.

The electron injection layer may include LiF, NaCl, CsF, $Li_2O$, BaO, or a combination thereof.

A thickness of the electron injection layer may be in a range of about 1 Å to about 100 Å, for example, about 3 Å to about 90 Å. When the thickness of the electron injection layer is within the range described above, the electron injection layer may have satisfactory electron injection characteristics without a substantial increase in driving voltage.

The second electrode 19 may be located on the organic layer 15. The second electrode 19 may be a cathode.

A material for forming the second electrode 19 may be a metal, an alloy, an electrically conductive compound, or a combination thereof, which have a relatively low work function. For example, lithium (Li), magnesium (Mg), aluminum (Al), aluminum-lithium (Al-Li), calcium (Ca), magnesium-indium (Mg-In), or magnesium-silver (Mg-Ag) may be used as the material for forming the second electrode 19. In one or more embodiments, to manufacture a top-emission type light-emitting device, a transmissive electrode formed using ITO or IZO may be used as the second electrode 19.

Hereinbefore, the organic light-emitting device has been described with reference to FIGURE, but embodiments of the present disclosure are not limited thereto.

According to another aspect, the organic light-emitting device may be included in an electronic apparatus. Thus, an electronic apparatus including the organic light-emitting device is provided. The electronic apparatus may include, for example, a display, an illumination, a sensor, and the like.

Another aspect provides a diagnostic composition including at least one organometallic compound represented by Formula 1.

The organometallic compound represented by Formula 1 provides high emission efficiency. Accordingly, a diagnostic composition including the organometallic compound may have high diagnostic efficiency.

The diagnostic composition may be used in various applications including a diagnosis kit, a diagnosis reagent, a biosensor, and a biomarker.

The term "$C_1$-$C_{60}$ alkyl group" as used herein refers to a linear or branched saturated aliphatic hydrocarbons monovalent group having 1 to 60 carbon atoms, and the term "$C_1$-$C_{60}$ alkylene group" as used here refers to a divalent group having the same structure as the $C_1$-$C_{60}$ alkyl group.

Examples of the $C_1$-$C_{60}$ alkyl group, the $C_1$-$C_{20}$ alkyl group, and/or the $C_1$-$C_{10}$ alkyl group are a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each unsubstituted or substituted with a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or a combination thereof. For example, Formula 9-33 is a branched $C_6$ alkyl group, for example, a tert-butyl group that is substituted with two methyl groups.

The term "$C_1$-$C_{60}$ alkoxy group" used herein refers to a monovalent group represented by -$OA_{101}$ (wherein $A_{101}$ is the $C_1$-$C_{60}$ alkyl group), and examples thereof are a methoxy group, an ethoxy group, a propoxy group, a butoxy group, and a pentoxy group.

The term "$C_2$-$C_{60}$ alkenyl group" as used herein refers to a hydrocarbon group formed by substituting at least one carbon-carbon double bond in the middle or at the terminus of the $C_2$-$C_{60}$ alkyl group, and examples thereof include an ethenyl group, a propenyl group, and a butenyl group. The term "$C_2$-$C_{60}$ alkenylene group" as used herein refers to a divalent group having the same structure as the $C_2$-$C_{60}$ alkenyl group.

The term "$C_2$-$C_{60}$ alkynyl group" as used herein refers to a hydrocarbon group formed by substituting at least one carbon-carbon triple bond in the middle or at the terminus of the $C_2$-$C_{60}$ alkyl group, and examples thereof include an ethynyl group and a propynyl group. The term "$C_2$-$C_{60}$ alkynylene group" as used herein refers to a divalent group having the same structure as the $C_2$-$C_{60}$ alkynyl group.

The term "$C_3$-$C_{10}$ cycloalkyl group" as used herein refers to a monovalent saturated hydrocarbon cyclic group having 3 to 10 carbon atoms, and the $C_3$-$C_{10}$ cycloalkylene group is a divalent group having the same structure as the $C_3$-$C_{10}$ cycloalkyl group.

Examples of the $C_3$-$C_{10}$ cycloalkyl group may include a cyclopropyl group, a cyclobutyl group, a cyclopentyl group, a cyclohexyl group, a cycloheptyl group, a cyclooctyl group, an adamantanyl group, a bicyclo[1.1.1]pentyl group, a bicyclo[2.1.1]hexyl group, a bicyclo[2.2.1]heptyl(norbornanyl) group, a bicyclo[2.2.2]octyl group, and the like.

The term "$C_1$-$C_{10}$ heterocycloalkyl group" as used herein refers to a saturated monocyclic group that includes at least one heteroatom selected from N, O, P, Si, S, B, Ge, and Se as a ring-forming atom and 1 to 10 carbon atoms, and the term "$C_1$-$C_{10}$ heterocycloalkylene group" as used herein refers to a divalent group having the same structure as the $C_1$-$C_{10}$ heterocycloalkyl group.

Examples of the $C_1$-$C_{10}$ heterocycloalkyl group include a silolanyl group, a silinanyl group, a tetrahydrofuranyl group, a tetrahydro-2H-pyranyl group, and a tetrahydrothiophenyl group.

The term "$C_3$-$C_{10}$ cycloalkenyl group" as used herein refers to a monovalent monocyclic group that has 3 to 10 carbon atoms and at least one carbon-carbon double bond in the ring thereof and no aromaticity, and non-limiting

examples thereof include a cyclopentenyl group, a cyclohexenyl group, and a cycloheptenyl group. The term "$C_3$-$C_{10}$ cycloalkenylene group" as used herein refers to a divalent group having the same structure as the $C_3$-$C_{10}$ cycloalkenyl group.

The term "$C_1$-$C_{10}$ heterocycloalkenyl group" as used herein refers to a monovalent monocyclic group that has at least one heteroatom selected from N, O, P, Si, S, B, Ge, and Se as a ring-forming atom, 1 to 10 carbon atoms, and at least one double bond in its ring. Examples of the $C_1$-$C_{10}$ heterocycloalkenyl group are a 2,3-dihydrofuranyl group and a 2,3-dihydrothiophenyl group. The term "$C_1$-$C_{10}$ heterocycloalkenylene group" as used herein refers to a divalent group having the same structure as the $C_1$-$C_{10}$ heterocycloalkenyl group.

The term "$C_6$-$C_{60}$ aryl group" as used herein refers to a monovalent group having a carbocyclic aromatic system having 6 to 60 carbon atoms, and the term "$C_6$-$C_{60}$ arylene group" as used herein refers to a divalent group having a carbocyclic aromatic system having 6 to 60 carbon atoms. Examples of the $C_6$-$C_{60}$ aryl group include a phenyl group, a naphthyl group, an anthracenyl group, a phenanthrenyl group, a pyrenyl group, and a chrysenyl group. When the $C_6$-$C_{60}$ aryl group and the $C_6$-$C_{60}$ arylene group each include two or more rings, the rings may be fused to each other.

The term "$C_7$-$C_{60}$ alkyl aryl group" used herein refers to a $C_6$-$C_{60}$ aryl group substituted with at least one $C_1$-$C_{60}$ alkyl group. The term "$C_7$-$C_{60}$ aryl alkyl group" as used herein refers to a $C_1$-$C_{60}$ alkyl group substituted with at least one $C_6$-$C_{60}$ aryl group.

The term "$C_1$-$C_{60}$ heteroaryl group" as used herein refers to a monovalent group having at least one heteroatom selected from N, O, P, Si, S, B, Ge, and Se as a ring-forming atom and a cyclic aromatic system having 1 to 60 carbon atoms, and the term "$C_1$-$C_{60}$ heteroarylene group" as used herein refers to a divalent group having at least one heteroatom selected from N, O, P, Si, S, B, Ge, and Se as a ring-forming atom and a carbocyclic aromatic system having 1 to 60 carbon atoms. Examples of the $C_1$-$C_{60}$ heteroaryl group include a pyridinyl group, a pyrimidinyl group, a pyrazinyl group, a pyridazinyl group, a triazinyl group, a quinolinyl group, and an isoquinolinyl group. When the $C_6$-$C_{60}$ heteroaryl group and the $C_6$-$C_{60}$ heteroarylene group each include two or more rings, the rings may be fused to each other.

The term "$C_2$-$C_{60}$ alkyl heteroaryl group" as used herein refers to a $C_1$-$C_{60}$ heteroaryl group substituted with at least one $C_1$-$C_{60}$ alkyl group. The term "$C_2$-$C_{60}$ heteroaryl alkyl group" as used herein refers to a $C_1$-$C_{60}$ alkyl group substituted with at least one $C_1$-$C_{60}$ heteroaryl group.

The term "$C_6$-$C_{60}$ aryloxy group" as used herein indicates $-OA_{102}$ (wherein $A_{102}$ indicates the $C_6$-$C_{60}$ aryl group), the $C_6$-$C_{60}$ arylthio group indicates $-SA_{103}$ (wherein $A_{103}$ indicates the $C_6$-$C_{60}$ aryl group), and the $C_1$-$C_{60}$ alkylthio group indicates $-SA_{104}$ (wherein $A_{104}$ indicates the $C_1$-$C_{60}$ alkyl group).

The term "$C_1$-$C_{60}$ heteroaryloxy group" as used herein indicates a group of formula $-OA_{102a}$ (wherein $A_{102a}$ indicates the $C_1$-$C_{60}$ heteroaryl group), and the $C_1$-$C_{60}$ heteroarylthio group indicates a group of formula $-SA_{103a}$ (wherein $A_{103a}$ indicates the C1-C60 heteroaryl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group include a fluorenyl group. The term "divalent non-aromatic condensed polycyclic group" as used herein refers to a divalent group having the same structure as a monovalent non-aromatic condensed polycyclic group.

The term "monovalent non-aromatic condensed heteropolycyclic group" as used herein refers to a monovalent group (for example, having 2 to 60 carbon atoms) having two or more rings condensed to each other, a heteroatom selected from N, O, P, Si, S, B, Ge, and Se, other than carbon atoms, as a ring-forming atom, and no aromaticity in its entire molecular structure. Examples of the monovalent non-aromatic condensed heteropolycyclic group include a carbazolyl group. The term "divalent non-aromatic condensed heteropolycyclic group" as used herein refers to a divalent group having the same structure as a monovalent non-aromatic condensed heteropolycyclic group.

The term "$C_5$-$C_{30}$ carbocyclic group" as used herein refers to a saturated or unsaturated cyclic group having, as a ring-forming atom, 5 to 30 carbon atoms only. The $C_5$-$C_{30}$ carbocyclic group may be a monocyclic group or a polycyclic group. Examples of the "$C_5$-$C_{30}$ carbocyclic group (unsubstituted or substituted with at least one $R_{10a}$)" are an adamantane group, a norbornene group, a bicyclo[1.1.1]pentane group, a bicyclo[2.1,1]hexane group, a bicyclo[2.2.1]heptane(norbornane) group, a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, and a fluorene group (each unsubstituted or substituted with at least one $R_{10a}$).

The term "$C_1$-$C_{30}$ heterocyclic group" as used herein refers to a saturated or unsaturated cyclic group having, as a ring-forming atom, at least one heteroatom selected from N, O, P, Si, Se, Ge, B, and S other than 1 to 30 carbon atoms. The $C_1$-$C_{30}$ heterocyclic group may be a monocyclic group or a polycyclic group. The "$C_1$-$C_{30}$ heterocyclic group (unsubstituted or substituted with at least one $R_{10a}$)" may be, for example, a thiophene group, a furan group, a pyrrole group, a silole group, a borole group, a phosphole group, a selenophene group, a germole group, a benzothiophene group, a benzofuran group, an indole group, a benzosilole group, a benzoborole group, a benzophosphole group, a

benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluoren-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group (each unsubstituted or substituted with at least one $R_{10a}$ as defined herein).

The terms "fluorinated $C_1$-$C_{60}$ alkyl group (or a fluorinated $C_1$-$C_{20}$ alkyl group or the like)", "fluorinated $C_3$-$C_{10}$ cycloalkyl group", "fluorinated $C_1$-$C_{10}$ heterocycloalkyl group," and "fluorinated phenyl group" as used herein respectively indicate a $C_1$-$C_{60}$ alkyl group (or a $C_1$-$C_{20}$ alkyl group or the like), a $C_3$-$C_{10}$ cycloalkyl group, a $C_1$-$C_{10}$ heterocycloalkyl group, and a phenyl group, each substituted with at least one fluoro group (-F). For example, the term "fluorinated $C_1$ alkyl group (that is, a fluorinated methyl group)" includes $-CF_3$, $-CF_2H$, and $-CFH_2$. The "fluorinated $C_1$-$C_{60}$ alkyl group (or, a fluorinated $C_1$-$C_{20}$ alkyl group, or the like)", "the fluorinated $C_3$-$C_{10}$ cycloalkyl group", "the fluorinated $C_1$-$C_{10}$ heterocycloalkyl group", or "the fluorinated a phenyl group" may be i) a fully fluorinated $C_1$-$C_{60}$ alkyl group (or, a fully fluorinated $C_1$-$C_{20}$ alkyl group, or the like), a fully fluorinated $C_3$-$C_{10}$ cycloalkyl group, a fully fluorinated $C_1$-$C_{10}$ heterocycloalkyl group, or a fully fluorinated phenyl group, wherein, in each group, all hydrogen included therein is substituted with a fluoro group, or ii) a partially fluorinated $C_1$-$C_{60}$ alkyl group (or, a partially fluorinated $C_1$-$C_{20}$ alkyl group, or the like), a partially fluorinated $C_3$-$C_{10}$ cycloalkyl group, a partially fluorinated $C_1$-$C_{10}$ heterocycloalkyl group, or partially fluorinated phenyl group, wherein, in each group, all hydrogen included therein is not substituted with a fluoro group.

The terms "deuterated $C_1$-$C_{60}$ alkyl group (or a deuterated $C_1$-$C_{20}$ alkyl group or the like)", "deuterated $C_3$-$C_{10}$ cycloalkyl group", "deuterated $C_1$-$C_{10}$ heterocycloalkyl group," and "deuterated phenyl group" as used herein respectively indicate a $C_1$-$C_{60}$ alkyl group (or a $C_1$-$C_{20}$ alkyl group or the like), a $C_3$-$C_{10}$ cycloalkyl group, a $C_1$-$C_{10}$ heterocycloalkyl group, and a phenyl group, each substituted with at least one deuterium. For example, the "deuterated $C_1$ alkyl group (that is, the deuterated methyl group)" may include $-CD_3$, $-CD_2H$, and $-CDH_2$, and examples of the "deuterated $C_3$-$C_{10}$ cycloalkyl group" are, for example, Formula 10-501 and the like. The "deuterated $C_1$-$C_{60}$ alkyl group (or, the deuterated $C_1$-$C_{20}$ alkyl group or the like)", "the deuterated $C_3$-$C_{10}$ cycloalkyl group", "the deuterated $C_1$-$C_{10}$ heterocycloalkyl group", or "the deuterated phenyl group" may be i) a fully deuterated $C_1$-$C_{60}$ alkyl group (or, a fully deuterated $C_1$-$C_{20}$ alkyl group or the like), a fully deuterated $C_3$-$C_{10}$ cycloalkyl group, a fully deuterated $C_1$-$C_{10}$ heterocycloalkyl group, or a fully deuterated phenyl group, in which, in each group, all hydrogen included therein are substituted with deuterium, or ii) a partially deuterated $C_1$-$C_{60}$ alkyl group (or, a partially deuterated $C_1$-$C_{20}$ alkyl group or the like), a partially deuterated $C_3$-$C_{10}$ cycloalkyl group, a partially deuterated $C_1$-$C_{10}$ heterocycloalkyl group, or a partially deuterated phenyl group, in which, in each group, all hydrogen included therein are not substituted with deuterium.

The term "($C_1$-$C_{20}$ alkyl) 'X' group" as used herein refers to an 'X' group that is substituted with at least one $C_1$-$C_{20}$ alkyl group. For example, the term "($C_1$-$C_{20}$ alkyl)$C_3$-$C_{19}$ cycloalkyl group" as used herein refers to a $C_3$-$C_{10}$ cycloalkyl group substituted with at least one $C_1$-$C_{20}$ alkyl group, and the term "($C_1$-$C_{20}$ alkyl)phenyl group" as used herein refers to a phenyl group substituted with at least one $C_1$-$C_{20}$ alkyl group. An example of a ($C_1$ alkyl) phenyl group is a toluyl group.

The terms "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, and an azadibenzothiophene 5,5-dioxide group" respectively refer to heterocyclic groups having the same backbones as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, and a dibenzothiophene 5,5-dioxide group," in which, in each group, at least one carbon selected from a ring-forming carbon is substituted with nitrogen.

At least one substituent of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the

substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_7$-$C_{60}$ aryl alkyl group, the substituted $C_6$-$C_{60}$ aryloxy group, the substituted $C_6$-$C_{60}$ arylthio group, the substituted $C_1$-$C_{60}$ heteroaryl group, the substituted $C_2$-$C_{60}$ alkyl heteroaryl group, the substituted $C_2$-$C_{60}$ heteroaryl alkyl group, the substituted $C_1$-$C_{60}$ heteroaryloxy group, the substituted $C_1$-$C_{60}$ heteroarylthio group, the substituted monovalent non-aromatic condensed polycyclic group, and the substituted monovalent non-aromatic condensed heteropolycyclic group may each independently be:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group;

a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group, substituted with deuterium, - F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-N(Q_{11})(Q_{12})$,$-Si(Q_{13})(Q_{14})(Q_{15})$, $-Ge(Q_{13})(Q_{14})(Q_{15})$, $-B(Q_{16})(Q_{17})$, $-P(=O)(Q_{16})(Q_{19})$,$-P(Q_{18})(Q_{19})$, or a combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each unsubstituted or substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$,$-Ge(Q_{23})(Q_{24})(Q_{25})$, $-B(Q_{26})(Q_{27})$, $-P(=O)(Q_{28})(Q_{29})$, $-P(Q_{28})(Q_{29})$, or a combination thereof;

$-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$,$-P(=O)(Q_{38})(Q_{39})$, or $-P(Q_{38})(Q_{39})$; or

a combination thereof,

wherein $Q_1$ to $Q_9$, $Q_{11}$ to $Q_{19}$, $Q_{21}$ to $Q_{29}$ and $Q_{31}$ to $Q_{39}$ as used herein may each independently be: hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a $C_1$-$C_{60}$ alkyl group unsubstituted or substituted with deuterium, a $C_1$-$C_{60}$ alkyl group, a $C_6$-$C_{60}$ aryl group, or a combination thereof; a $C_2$-$C_{60}$ alkenyl group; a $C_2$-$C_{60}$ alkynyl group; a $C_1$-$C_{60}$ alkoxy group; a $C_1$-$C_{60}$ alkylthio group; a $C_3$-$C_{10}$ cycloalkyl group; a $C_1$-$C_{10}$ heterocycloalkyl group; a $C_3$-$C_{10}$ cycloalkenyl group; a $C_1$-$C_{10}$ heterocycloalkenyl group; a $C_6$-$C_{60}$ aryl group unsubstituted or substituted with deuterium, a $C_1$-$C_{60}$ alkyl group, a $C_6$-$C_{60}$ aryl group, or a combination thereof; a $C_6$-$C_{60}$ aryloxy group; a $C_6$-$C_{60}$ arylthio group; a $C_1$-$C_{60}$ heteroaryl group; a $C_1$-$C_{60}$ heteroaryloxy group; a $C_1$-$C_{60}$ heteroarylthio group; a monovalent non-aromatic condensed polycyclic group; or a monovalent non-aromatic condensed heteropolycyclic group.

For example, $Q_1$ to $Q_9$, $Q_{11}$ to $Q_{19}$, $Q_{21}$ to $Q_{29}$ and $Q_{31}$ to $Q_{39}$ as used herein may each independently be:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, or$-CD_2CDH_2$; or

an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, a $C_1$-$C_{10}$ alkyl group, a phenyl group, or a combination thereof.

Hereinafter, compounds and organic light-emitting devices according to one or more exemplary embodiments are described in further detail with reference to the Synthesis Example and Examples. However, the organic light-emitting device is not limited thereto. The wording "B was used instead of A" used in describing Synthesis Examples means that an amount of A used was identical to an amount of B used, in terms of a molar equivalent.

EXAMPLES

Synthesis Example 1 (Compound 1)

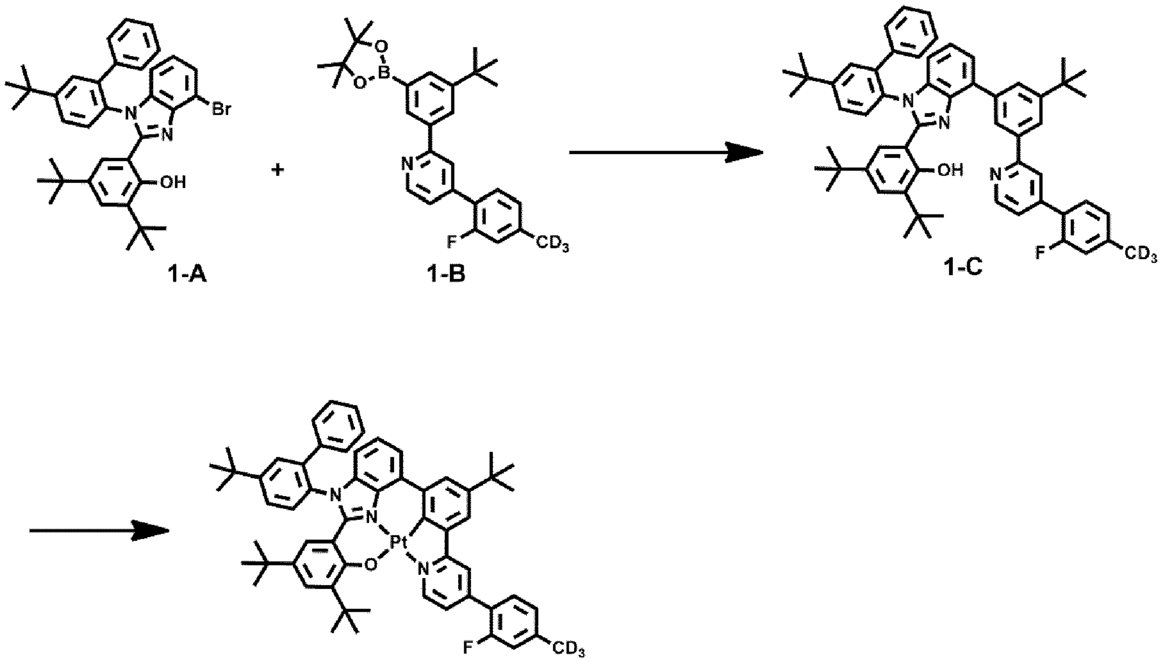

1-A 1-B 1-C

1

Synthesis of Compound 1-C (2,4-di-tert-butyl-6-(4-(3-(tert-butyl)-5-(4-(2-fluoro-4-(methyl-d3)phenyl)pyridin-2-yl)phenyl)-1-(5-(tert-butyl)-[1,1'-biphenyl]-2-yl)-1H-benzo[d]im idazol-2-yl)phenol)

1.5 grams (g) (0.002 moles (mol), 1.0 equivalent (equiv.)) of Compound 1-A (2-(4-bromo-1-(5-(tert-butyl)-[1,1'-biphenyl]-2-yl)-1H-benzo[d]imidazol-2-yl)-4,6-di-tert-butylphenol), 1.22 g (0.003 mol, 1.1 equiv.) of Compound 1-B (2-(3-(tert-butyl)-5-(4,4,5,5-tetramethyl-1,3,2-dioxaborolan-2-yl)phenyl)-4-(2-fluoro-4-(methyl-d3)phenyl)pyridine), 0.20 g (0.001 mol, 0.07 equiv.) of tetrakis(triphenylphosphine)palladium(0), and 1.0 g (0.007 mol, 3 equiv.) of potassium carbonate were mixed with 40 mL of solvent wherein tetrahydrofuran (THF) and deionized water (DI water) were mixed at a volume ratio of 3:1 and then, the resultant mixture was heated at reflux for 12 hours. The obtained crude product mixture was allowed to cool to room temperature, and then, the precipitate was removed therefrom to obtain a filtrate. The filtrate was washed with ethyl acetate (EA) and DI water, and column chromatography (column performed using a solvent gradient of 5-10 volume percent (vol%) of EA and 90-95 vol% of hexanes) was performed thereon to complete the production of 1.8 g (yield of 86%) of Ligand C. The obtained compound was identified by high resolution mass spectrometry (HRMS) (using matrix assisted laser desorption ionization (MALDI)) and high-performance liquid chromatography (HPLC) analysis.

HRMS (MALDI) calculated (calcd.) for $C_{59}H_{59}D_3FN_3O$: mass to charge ratio (m/z) 850.5065, Found: 850.5067

Synthesis of Compound 1

1.8 g (2.03 millimoles (mmol)) of Compound 1-C and 1.01 g (2.43 mmol, 1.2 equiv.) of $K_2PtCl_4$ were mixed with 40 mL of a solvent mixture containing 30 mL of acetic acid (AcOH) and 10 mL of DI water, and then the resultant mixture was heated at reflux for 16 hours. The obtained crude product mixture was allowed to cool to room temperature,

and then the precipitate was removed therefrom to obtain a filtrate. The filtrate was dissolved in methylene chloride (MC) and washed with DI water, and column chromatography (using a solvent gradient of 10-35 vol% of MC and 65-90 vol% of hexanes) was performed thereon to complete the production of 1.2 g (yield of 57%) of Compound 1. The obtained compound was identified by HRMS and HPLC analysis.

HRMS (MALDI) calcd. for $C_{59}H5_7D_3FN_3OPt$: m/z 1043.4556, Found: 1043.4555

Synthesis Example 2 (Compound 2)

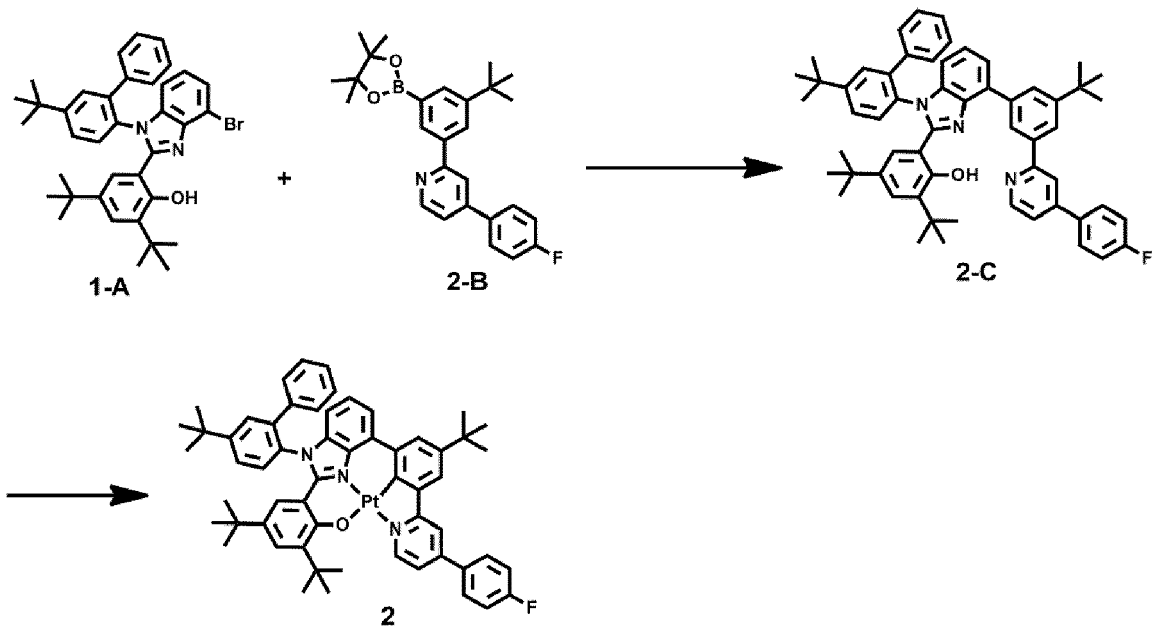

1-A 2-B 2-C 2

Synthesis of Compound 2-C (2,4-di-tert-butyl-6-(4-(3-(tert-butyl)-5-(4-(4-fluorophenyl)pyridin-2-yl)phenyl)-1-(5-(tert-butyl)-[1,1'-biphenyl]-2-yl)-1H-benzo[d]imidazol-2-yl)phenol)

1.7 g (a yield of 83%) of Compound 2-C was obtained in a similar manner as used to obtain Compound 1-C of Synthesis Example 1, except that Compound 2-B (2-(3-(tert-butyl)-5-(4,4,5,5-tetramethyl-1,3,2-dioxaborolan-2-yl)phenyl)-4-(4-fluorophenyl)pyridine) was used instead of Compound 1-B. The obtained compound was identified by HRMS and HPLC analysis.

HRMS(MALDI) calcd. for $C_{58}H_{60}FN_3O$: m/z 833.4720, Found: 833.4722

Synthesis of Compound 2

1.2 g (yield of 57%) of Compound 2 was obtained in a manner similar to that used to obtain Compound 1 of Synthesis Example 1, except that 1.7 g (1.92 mmol) of Compound 2-C was used instead of Compound 1-C. The obtained compound was identified by HRMS and HPLC analysis.

HRMS (MALDI) calcd for $C_{63}H_{63}FN_3OPt$: m/z 1026.4212, Found: 1026.4213

Synthesis Example 3 (Compound 3)

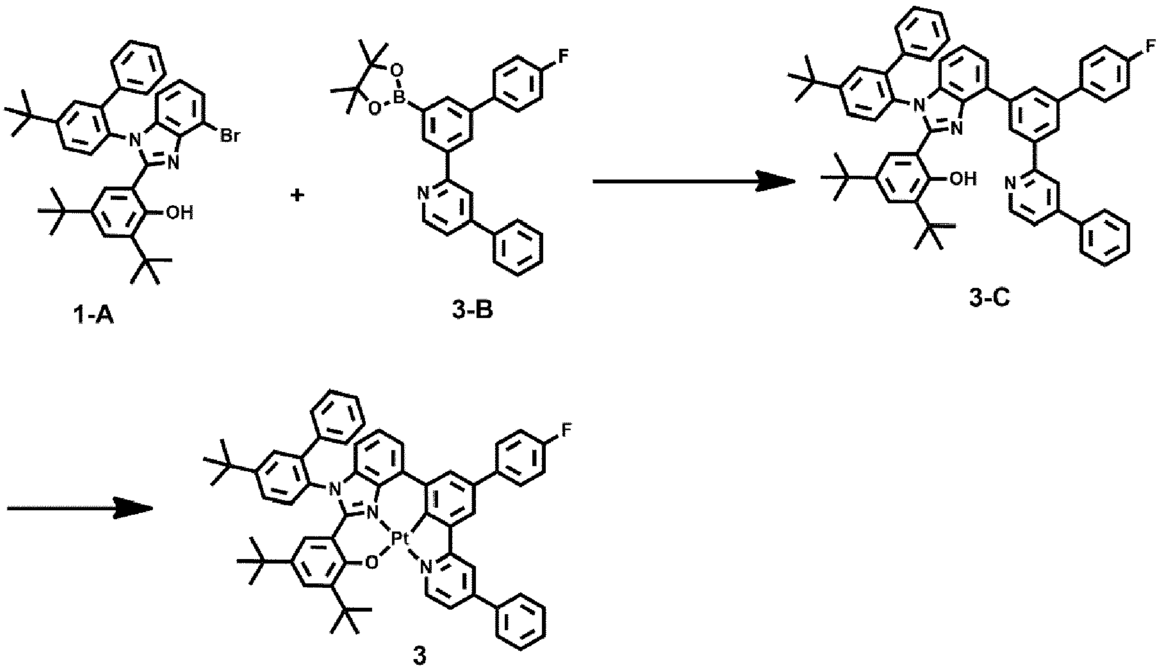

1-A 3-B 3-C

3

Synthesis of Compound 3-C (2,4-di-tert-butyl-6-(1-(5-(tert-butyl)-[1,1'-biphenyl]-2-yl)-4-(4'-fluoro-5-(4-phenylpyridin-2-yl)-[1,1'-biphenyl]-3-yl)-1H-benzo[d]imidazol-2-yl)phenol)

2.4 g (yield of 86 %) of Compound 3-C was obtained in a manner similar to that used to obtain Compound 1-C of Synthesis Example 1, except that Compound 3-B (2-(4'-fluoro-5-(4,4,5,5-tetramethyl-1,3,2-dioxaborolan-2-yl)-[1,1'-biphenyl]-3-yl)-4-phenylpyridine) was used instead of Compound 1-B. The obtained compound was identified by HRMS and HPLC analysis.

HRMS(MALDI) calcd. for $C_{60}H_{56}FN_3O$: m/z 853.4407, Found: 853.4408

Synthesis of Compound 3

1.8 g (yield of 61 %) of Compound 3 was obtained in a manner similar to that used to obtain Compound 1 of Synthesis Example 1, except that 2.4 g (2.81 mmol) of Compound 3-C was used instead of Compound 1-C. The obtained compound was identified by HRMS and HPLC analysis.

HRMS(MALDI) calcd. for $C_{60}H_{54}FN_3OPt$: m/z 1046.3899, Found: 1046.3896

Evaluation Example 1: Evaluation of thermal characteristics

Thermal analysis was performed under an $N_2$ atmosphere. The temperature zones were as follows: from room temperature to 800°C (10°C/min) for thermal gravimetric analysis (TGA) or from room temperature to 400°C (10°C/min) for differential scanning calorimetry (DSC). The pan types were as follows : a Pt pan was situated in a disposable Al pan for TGA or a disposable Al pan was used for DSC. Thermal analysis to obtain glass transition temperature ($T_g$, °C) was performed for Compounds 1 to 2 and A to C using TGA and DSC, and the results are shown in Table 2.

Table 2

| Compound No. | $T_g$(°C) |
|---|---|
| 1 | 269 |
| 2 | 267 |
| A | 289 |
| B | 339 |

(continued)

| Compound No. | $T_g$(°C) |
|---|---|
| C | 342 |

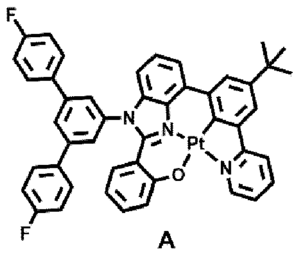
A

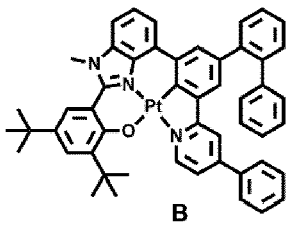
B

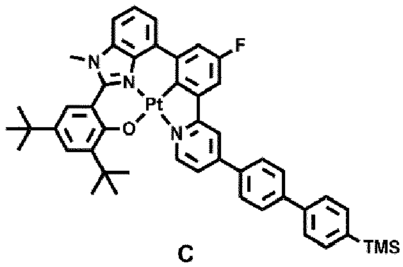
C

Table 2 shows that Compounds 1 and 2 have lower $T_g$ than the $T_g$ of Compounds A to C. Hence, Compounds 1 and 2 each have excellent thermal stability as compared to the thermal stability of Compounds A to C, and the amount of impurities generated after sublimation purification of Compounds 1 and 2 is smaller than the amount of impurities generated after sublimation purification of Compounds A to C and may have high purity.

Evaluation Example 2: Evaluation of photoluminescence quantum efficiency (PLQY)

A PMMA solution in $CH_2Cl_2$, CBP, and Compound 1 (5 parts by weight per 100 parts by weight of CBP) were mixed, and then the resultant mixture was coated on a quartz substrate by using a spin coater, and then the coated substrate was heated in an oven at a temperature of 80°C, and subsequently allowed to cool to room temperature to obtain a film.

The PLQY of the film derived from Compound 1 was evaluated by using a Hamamatsu Photonics absolute photoluminescent (PL) quantum yield measurement system equipped with a xenon light source, a monochromator, a photonic multichannel analyzer, and an integrating sphere, and data analysis as performed using PLQY measurement software (Hamamatsu Photonics, Ltd., Shizuoka, Japan). The process was repeated for Compounds 2 and 3. The PLQY results for the films derived from Compounds 1 to 3 are shown in Table 3.

Table 3

| Compound No. | PLQY |
|---|---|
| 1 | 0.985 |
| 2 | 0.996 |
| 3 | 0.929 |

Referring to Table 3, it was confirmed that films derived from Compounds 1 to 3 have excellent PLQY.

Evaluation Example 3: Decay time measurement

A quartz substrate was prepared by washing with chloroform and deionized water, and then a predetermined material as shown in Table 4 was vacuum-(co)deposited (under a static vacuum of $10^{-7}$ torr) to prepare Films 1 to 3, with each having a thickness of 50 nm.

Table 4

| | Components used in film production |
|---|---|
| Film 1 | CBP / Compound 1 (at a weight ratio of 9:1) |
| Film 2 | CBP / Compound 2 (at a weight ratio of 9:1) |
| Film 3 | CBP / Compound 3 (at a weight ratio of 9:1) |

Photoluminescence (PL) spectra of each of Films 1 to 3 was measured at room temperature by using a FluoTime 300 spectrometer (a TRPL measurement system manufactured by PicoQuant Inc.). Excitation light was provided using a PLS340 light source (excitation wavelength = 340 nm, spectral width = 20 nm), which is a pumping light source (PicoQuant Inc.). Then, the main peak of each spectrum was identified, and the number of photons emitted at the wavelength of the photon pulse (pulse width = 500 picoseconds) applied by PLS340 to each of Films 1 to 3 was measured multiple times based on time-correlated single photon counting (TCSPC) according to time, thereby obtaining a TRPL curve sufficient for fitting. The obtained result was fitted with two or more exponential decay functions to obtain $T_{decay}$ (Ex), that is, decay time of each of Films 1 to 3 (decay time). Results obtained therefrom are shown in Table 5. A function for fitting is as shown in Equation 1, and from among $T_{decay}$ values obtained from each exponential decay function used for fitting, the largest $T_{decay}$ was used as $T_{decay}$ (Ex). In this regard, the same measurement was performed during the same measurement time as that for obtaining TRPL curve in the dark state (in which pumping signals entering a film are blocked) to obtain a baseline spectrum or a background signal curve for use as a baseline spectrum for fitting.

Equation 1

$$f(t) = \sum_{i=1}^{n} A_i \, exp\left(-t/T_{decay,i}\right)$$

Table 5

| | Decay time(μs) |
|---|---|
| Film 1 (Compound 3) | 2.201 |
| Film 2 (Compound 2) | 2.332 |
| Film 3 (Compound 3) | 2.572 |

Referring to Table 5, it is confirmed that Compounds 1 to 3 have excellent decay time.

Example 1

An ITO glass substrate was cut to a size of 50 millimeters (mm) x 50 mm x 0.5 mm and then sonicated in each of acetone, isopropyl alcohol, and DI water, each for 15 minutes, and then exposed to ultraviolet light (UV light)-generated ozone for 30 minutes.

Then, m-MTDATA was deposited on an ITO electrode (anode) of the ITO glass substrate at a deposition rate of 1 angstrom per second (Å/sec) to form a hole injection layer having a thickness of 600 angstroms (Å), and then, NPB (a-NPD) was deposited on the hole injection layer at a deposition rate of 1 Å/sec to form a hole transport layer having a thickness of 250 Å.

Compound 1 (dopant) and CBP (host) were co-deposited on the hole transport layer at a deposition rate of 0.1 Å/sec and a deposition rate of 1 Å/sec, respectively, to form an emission layer having a thickness of 400 Å. The emission layer included Compound 1 in an amount of 10 wt% based on the total weight of the emission layer.

BAlq was deposited on the emission layer at a deposition rate of 1 Å/sec to form a hole blocking layer having a thickness of 50 Å, and $Alq_3$ was deposited on the hole blocking layer to form an electron transport layer having a thickness of 300 Å, and then, LiF was deposited on the electron transport layer to form an electron injection layer having a thickness of 10 Å, and then, Al was vacuum-deposited on the electron injection layer to form a second electrode (cathode) having a thickness of 1,200 Å, thereby completing the manufacturing of an organic light-emitting device having a structure of ITO/m-MTDATA (600 Å)/NPB (250 Å)/CBP + Compound 1 (10 wt%) (400 Å)/BAlq (50 Å)/$Alq_3$ (300 Å)/LiF (10 Å)/Al (1,200 Å).

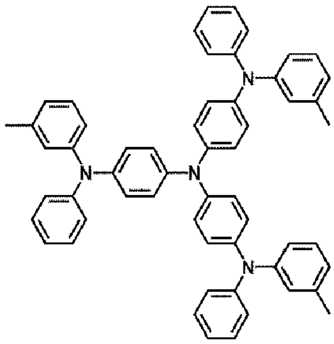

m-MTDATA

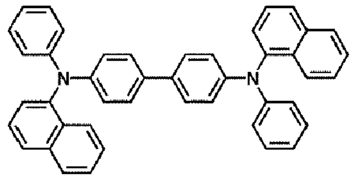

NPB

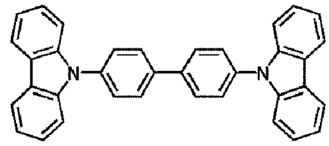

CBP

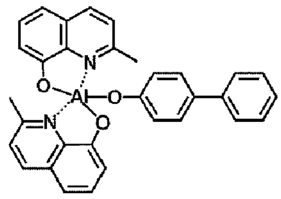

BAlq

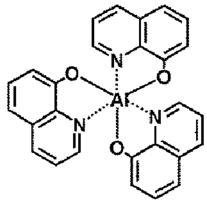

$Alq_3$

Examples 2 to 3 and Comparative Examples A to C

Organic light-emitting devices were manufactured in a manner similar to that used to prepare Example 1, except that compounds shown in Table 4 were each used instead of Compound 1 as a dopant in forming an emission layer.

Evaluation Example 4: Evaluation on Characteristics of Organic Light-Emitting Devices

The driving voltage (volts, V), the luminescence quantum efficiency (%), the roll-off ratio (%), and the lifespan ($LT_{95}$) of each of the organic light-emitting devices manufactured according to Examples 1 to 3 and Comparative Examples A to C were evaluated. Results thereof are shown in Table 6. This evaluation was performed using a current-voltage meter (Keithley 2400) and a luminescence meter (Minolta Cs-1,000A), and the lifespan ($LT_{95}$)(at 6,000 cd/$m^2$) was evaluated by evaluating, as a relative value (%), the amount of time that elapsed for the brightness to be reduced to 95% of the initial brightness of 100%. The roll-off ratio was calculated using Equation 2:

Equation 2

$$\text{Roll off ratio} = \{1 - (\text{efficiency (at 9,000 cd/m}^2) / \text{maximum emission efficiency})\} \times 100\ \%$$

Table 6

| | Compound No. as dopant in emission layer | Driving Voltage (V) | Luminescent quantum efficiency (%) | Roll-off ratio (at 9,000 cd/$m^2$) (%) | LT95 (Relative value, %) |
|---|---|---|---|---|---|
| Example 1 | 1 | 3.78 | 119 | 7 | 100 |
| Example 2 | 2 | 3.95 | 116 | 6 | 130 |
| Example 3 | 3 | 3.61 | 115 | 9 | 120 |
| Comparative Example A | A | 4.42 | 84 | 20 | 15 |
| Comparative Example B | B | 4.39 | 108 | 10 | 60 |

(continued)

| | Compound No. as dopant in emission layer | Driving Voltage (V) | Luminescent quantum efficiency (%) | Roll-off ratio (at 9,000 cd/m$^2$) (%) | LT95 (Relative value, %) |
|---|---|---|---|---|---|
| Comparative Example C | C | 3.83 | 110 | 10 | 65 |

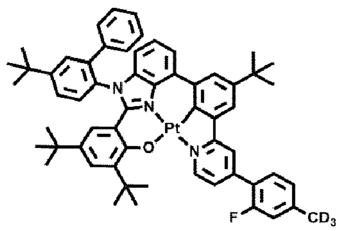

1

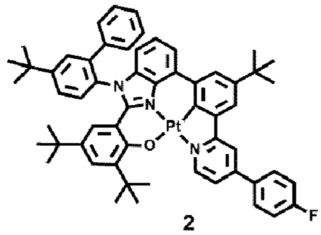

2

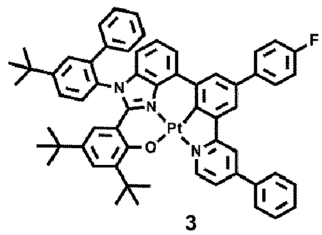

3

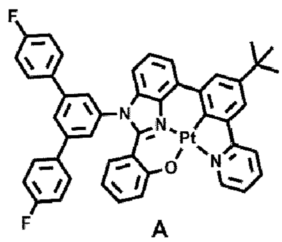

A

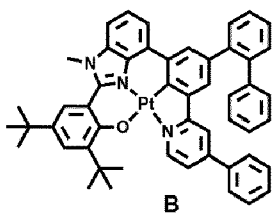

B

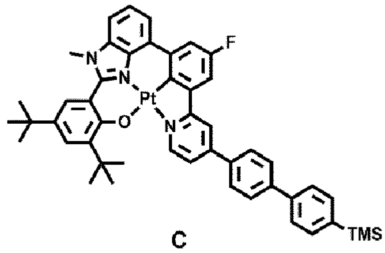

C

From Table 6, it was confirmed that the organic light-emitting devices of Examples 1 to 3 have excellent luminescence quantum efficiency, excellent roll-off ratio, and excellent lifespan characteristics compared to the luminescence quantum efficiency, roll-off ratio, and lifespan characteristics of the organic light-emitting devices of Comparative Examples A to C.

The organometallic compounds according to one or more embodiments have excellent electrical characteristics and/or thermal stability. Accordingly, an organic light-emitting device using the organometallic compounds can have improved characteristics in terms of driving voltage, external quantum efficiency (EQE), roll-off ratio, and lifespan characteristics. Therefore, the use of the organometallic compound according to the one or more embodiments as described herein may allow for the manufacture of a high-quality organic light-emitting device and an electron apparatus including the same.

It should be understood that one or more exemplary embodiments described herein should be considered in a descriptive sense only and not for purposes of limitation. Descriptions of features or aspects within each exemplary embodiment should typically be considered as available for other similar features or aspects in other exemplary embodiments. While one or more exemplary embodiments have been described with reference to the figures, it will be understood by those of ordinary skill in the art that various changes in form and details may be made therein without departing from the scope as defined by the following claims.

## Claims

**1.** An organometallic compound represented by Formula 1:

Formula 1

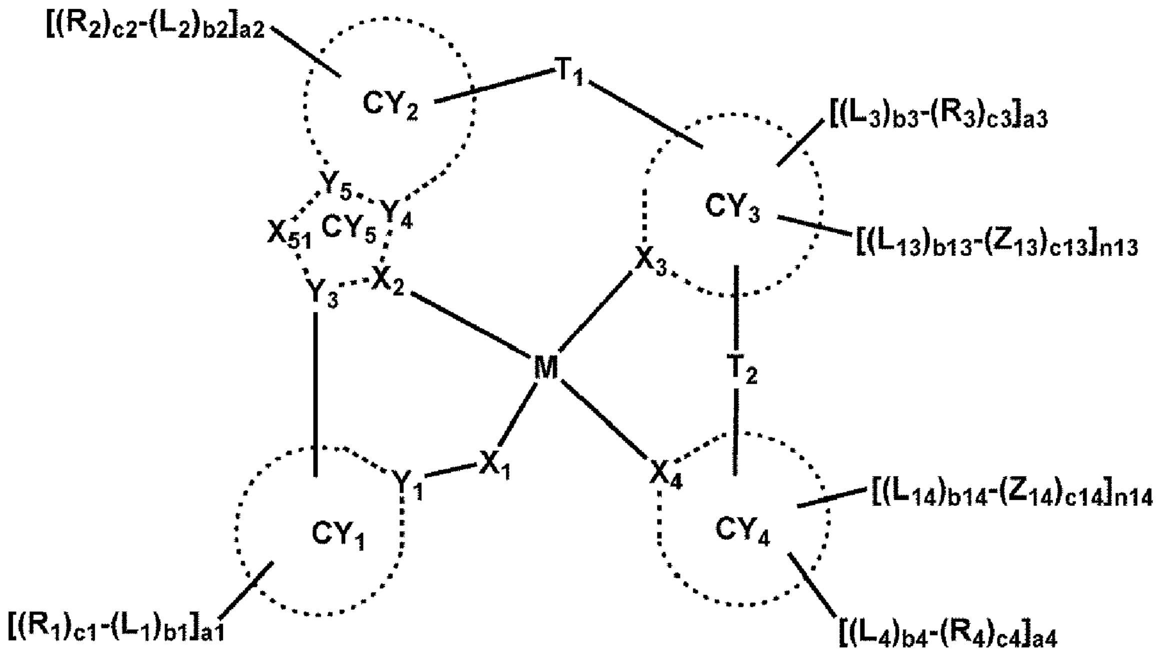

wherein, in Formula 1,

M is beryllium (Be), magnesium (Mg), aluminum (Al), calcium (Ca), titanium (Ti), manganese (Mn), cobalt (Co), copper (Cu), zinc (Zn), gallium (Ga), germanium (Ge), zirconium (Zr), ruthenium (Ru), rhodium (Rh), palladium (Pd), silver (Ag), rhenium (Re), platinum (Pt), or gold (Au),
$X_1$ is a single bond, O, S, N(R'), P(R'), B(R'), C(R')(R"), or Si(R')(R"), and when $X_1$ is a single bond, $Y_1$ is directly bonded to M,
$X_2$ to $X_4$ are each independently C or N,
a bond between $X_1$ or $Y_1$ and M is a covalent bond,
one of a bond between $X_2$ and M, a bond between $X_3$ and M, and a bond between $X_4$ and M is a covalent bond, and the others of a bond between $X_2$ and M, a bond between $X_3$ and M, and a bond between $X_4$ and M are coordinate bonds,
$Y_1$ and $Y_3$ to $Y_5$ are each independently C or N,
$X_2$ and $Y_3$, $X_2$ and $Y_4$, $Y_4$ and $Y_5$, $X_{51}$ and $Y_3$, and $X_{51}$ and $Y_5$ are each independently linked through a chemical bond,
ring $CY_1$ to ring $CY_4$ are each independently a $C_5$-$C_{30}$ carbocyclic group or a $C_1$-$C_{30}$ heterocyclic group, provided that each of ring $CY_1$, ring $CY_3$, and ring $CY_4$ are not a benzimidazole group,
ring $CY_5$ is a 5-membered ring condensed with ring $CY_2$,
a cyclometalated ring group formed by ring $CY_5$, ring $CY_2$, ring $CY_3$, and M is a 6-membered ring,
$X_{51}$ is O, S, N-[$(L_7)_{b7}$-$(R_7)_{c7}$], $C(R_7)(R_8)$, $Si(R_7)(R_8)$, $Ge(R_7)(R_8)$, C(=O), N, $C(R_7)$, $Si(R_7)$, or $Ge(R_7)$,
$R_7$ and $R_8$ are optionally linked via a single bond, a double bond, or a first linking group to form a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$,
$T_1$ and $T_2$ are each independently a single bond, a double bond, *-N($R_9$)-*', *-B($R_9$)-*', *-P($R_9$)-*', *-C($R_{9a}$)($R_{9b}$)-*', *-Si($R_{9a}$)($R_{9b}$)-*', *-Ge($R_{9a}$)($R_{9b}$)-*', *-S-*', *-Se-*', *-O-*', *-C(=O)-*', *-S(=O)-*', *-S(=O)$_2$-*', *-C($R_9$)=*', *=C($R_9$)-*', *-C($R_{9a}$)=C($R_{9b}$)-*', *-C(=S)-*', or *-C≡C-*', wherein * and *' each represent a bond to a neighboring atom,
wherein $R_{9a}$ and $R_{9b}$ are optionally linked via a single bond, a double bond, or a second linking group to form a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$, wherein the second linking group is as defined in connection with the first linking group, and
$Z_{13}$ and $Z_{14}$ are each independently a group represented by Formula 2,

n13 and n14 are each independently an integer from 0 to 20, and the sum of n13 and n14 is 1 or greater,
$L_1$ to $L_4$, $L_7$, $L_{13}$, and $L_{14}$ are each independently a single bond, a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$,
b1 to b4, b7, b13, and b14 are each independently an integer from 1 to 5, when b1 is 2 or greater, two or more of $L_1$(s) are identical to or different from each other, when b2 is 2 or greater, two or more of $L_2$(s) are identical to or different from each other, when b3 is 2 or greater, two or more of $L_3$(s) are identical to or different from each other, when b4 is 2 or greater, two or more of $L_4$(s) are identical to or different from each other, when b7 is 2 or greater, two or more of $L_7$(s) are identical to or different from each other, when b13 is 2 or greater, two or more of $L_{13}$(s) are identical to or different from each other, and when b14 is 2 or greater, two or more of $L_{14}$(s) are identical to or different from each other,
$R_1$ to $R_4$, $R_7$ to $R_9$, $R_{9a}$, $R_{9b}$, R', and R" are each independently hydrogen, deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, $-Ge(Q_3)(Q_4)(Q_5)$, $-B(Q_6)(Q_7)$, $-P(=O)(Q_3)(Q_9)$, or-$P(Q_3)(Q_9)$,
c1 to c4, c7, c13, and c14 are each independently an integer from 1 to 5,
a1 to a4 are each independently an integer from 0 to 20,
when c1 is 2 or greater, two or more of $R_1$(s) are identical to or different from each other, when c2 is 2 or greater, two or more of $R_2$(s) are identical to or different from each other, when c3 is 2 or greater, two or more of $R_3$(s) are identical to or different from each other, when c4 is 2 or greater, two or more of $R_4$(s) are identical to or different from each other, when c7 is 2 or greater, two or more of $R_7$(s) are identical to or different from each other, when c13 is 2 or greater, two or more of $Z_{13}$(s) are identical to or different from each other, and when c14 is 2 or greater, two or more of $Z_{14}$(s) are identical to or different from each other,
when a1 is 2 or greater, two or more of $*-[(L_1)_{b1}-(R_1)_{c1}]$ are identical to or different from each other, when a2 is 2 or greater, two or more of $*-[(L_2)_{b2}-(R_2)_{c2}]$ are identical to or different from each other, when a3 is 2 or greater, two or more of $*-[(L_3)_{b3}-(R_3)_{c3}]$ are identical to or different from each other, and when a4 is 2 or greater, two or more of $*-[(L_4)_{b4}-(R_4)_{c4}]$ are identical to or different from each other,
two or more of a plurality of $R_1$(s) are optionally linked to form a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$,
two or more of a plurality of $R_2$(s) are optionally linked to form a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$,
two or more of a plurality of $R_3$(s) are optionally linked to form a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$,
two or more of a plurality of $R_4$(s) are optionally linked to form a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$,
two or more groups of $R_1$ to $R_4$, $R_7$ to $R_9$, $R_{9a}$, $R_{9b}$, R', and R" are optionally linked to form a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$,
$R_{10a}$ is as defined in connection with $R_1$,

Formula 2

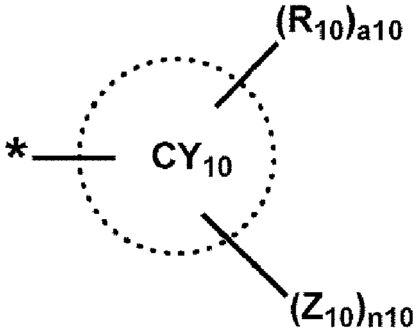

wherein, in Formula 2,

ring $CY_{10}$ is an unsaturated $C_5$-$C_{30}$ carbocyclic group or an unsaturated $C_1$-$C_{30}$ heterocyclic group,

$R_{10}$ is as defined in connection with $R_1$,

a10 is an integer from 0 to 20,

$Z_{10}$ is -F or a fluorinated group,

n10 is an integer from 1 to 20,

when a10 is 2 or greater, two or more of $R_{10}$(s) are identical to or different from each other,

when n10 is 2 or greater, two or more of $Z_{10}$(s) are identical to or different from each other, and

* indicates a binding site to a neighboring atom,

a substituent of the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_7$-$C_{60}$ aryl alkyl group, the substituted $C_6$-$C_{60}$ aryloxy group, the substituted $C_6$-$C_{60}$ arylthio group, the substituted $C_1$-$C_{60}$ heteroaryl group, the substituted $C_2$-$C_{60}$ alkyl heteroaryl group, the substituted $C_2$-$C_{60}$ heteroaryl alkyl group, the substituted $C_1$-$C_{60}$ heteroaryloxy group, the substituted $C_1$-$C_{60}$ heteroarylthio group, the substituted monovalent non-aromatic condensed polycyclic group, and the substituted monovalent non-aromatic condensed heteropolycyclic group is:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group;

a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group, each substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-N(Q_{11})(Q_{12})$, $-Si(Q_{13})(Q_{14})(Q_{15})$,$-Ge(Q_{13})(Q_{14})(Q_{15})$, $-B(Q_{16})(Q_{17})$, $-P(=O)(Q_{18})(Q_{19})$, $-P(Q_{18})(Q_{19})$, or a combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each unsubstituted or substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a

$C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, -N($Q_{21}$)($Q_{22}$), -Si($Q_{23}$)($Q_{24}$)($Q_{25}$), -Ge($Q_{23}$)($Q_{24}$)($Q_{25}$), -B($Q_{26}$)($Q_{27}$),-P(=O)($Q_{23}$)($Q_{29}$), -P($Q_{28}$)($Q_{29}$), or a combination thereof;
- N($Q_{31}$)($Q_{32}$), -Si($Q_{33}$)($Q_{34}$)($Q_{35}$), -Ge($Q_{33}$)($Q_{34}$)($Q_{35}$), -B($Q_{36}$)($Q_{37}$),-P(=O)($Q_{33}$)($Q_{39}$), or -P($Q_{38}$)($Q_{39}$), or

a combination thereof,
wherein $Q_1$ to $Q_9$, $Q_{11}$ to $Q_{19}$, $Q_{21}$ to $Q_{29}$, and $Q_{31}$ to $Q_{39}$ are each independently: hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a $C_1$-$C_{60}$ alkyl group unsubstituted or substituted with deuterium, a $C_1$-$C_{60}$ alkyl group, a $C_6$-$C_{60}$ aryl group, or a combination thereof; a $C_2$-$C_{60}$ alkenyl group; a $C_2$-$C_{60}$ alkynyl group; a $C_1$-$C_{60}$ alkoxy group; a $C_1$-$C_{60}$ alkylthio group; a $C_3$-$C_{10}$ cycloalkyl group; a $C_1$-$C_{10}$ heterocycloalkyl group; a $C_3$-$C_{10}$ cycloalkenyl group; a $C_1$-$C_{10}$ heterocycloalkenyl group; a $C_6$-$C_{60}$ aryl group unsubstituted or substituted with deuterium, a $C_1$-$C_{60}$ alkyl group, a $C_6$-$C_{60}$ aryl group, or a combination thereof; a $C_6$-$C_{60}$ aryloxy group; a $C_6$-$C_{60}$ arylthio group; a $C_1$-$C_{60}$ heteroaryl group; a $C_1$-$C_{60}$ heteroaryloxy group; a $C_1$-$C_{60}$ heteroarylthio group; a monovalent non-aromatic condensed polycyclic group; or a monovalent non-aromatic condensed heteropolycyclic group.

**2.** The organometallic compound of claim 1, wherein

i) $X_2$ and $X_4$ are each N, $X_3$ is C, a bond between $X_2$ and M and a bond between $X_4$ and M are each a coordinate bond, and a bond between $X_3$ and M is a covalent bond,
ii) $X_2$ and $X_3$ are each N, $X_4$ is C, a bond between $X_2$ and M and a bond between $X_3$ and M are each a coordinate bond, and a bond between $X_4$ and M is a covalent bond, or
iii) $X_3$ and $X_4$ are each N, $X_2$ is C, a bond between $X_3$ and M and a bond between $X_4$ and M are each a coordinate bond, and a bond between $X_2$ and M is a covalent bond.

**3.** The organometallic compound of claims 1 or 2, wherein ring $CY_1$ to ring $CY_4$ are each independently:

i) a first ring,
ii) a second ring,
iii) a condensed ring in which two or more of the first rings are condensed with each other,
iv) a condensed ring in which two or more of the second rings are condensed with each other, or
v) a condensed ring in which one or more of the first rings and one or more of the second rings are condensed with each other,
wherein the first ring is a cyclopentane group, a cyclopentadiene group, a furan group, a thiophene group, a pyrrole group, a silole group, an oxazole group, an isoxazole group, an oxadiazole group, an isoxadiazole group, an oxatriazole group, an isoxatriazole group, a thiazole group, an isothiazole group, a thiadiazole group, an isothiadiazole group, a thiatriazole group, an isothiatriazole group, a pyrazole group, an imidazole group, a triazole group, a tetrazole group, an azasilole group, a diazasilole group, or a triazasilole group, and
the second ring is an adamantane group, a norbornane group, a norbornene group, a cyclohexane group, a cyclohexene group, a benzene group, a pyridine group, a pyrimidine group, a pyrazine group, a pyridazine group, or a triazine group, and
each of ring $CY_1$ to ring $CY_4$ is not a benzimidazole group.

**4.** The organometallic compound of any of claims 1-3, wherein ring $CY_{10}$ in Formula 2 is a benzene group, a naphthalene group, a fluorene group, a phenanthrene group, an anthracene group, a fluoranthene group, a triphenylene group, a pyrene group, a chrysene group, a pyrrole group, a thiophene group, a furan group, an imidazole group, a pyrazole group, a thiazole group, an isothiazole group, an oxazole group, an isoxazole group, a pyridine group, a pyrazine group, a pyrimidine group, a pyridazine group, an isoindole group, an indole group, an indazole group, a purine group, a quinoline group, an isoquinoline group, a benzoquinoline group, a quinoxaline group, a quinazoline group, a cinnoline group, a carbazole group, a phenanthroline group, a benzimidazole group, a benzofuran group, a benzothiophene group, a benzisothiazole group, a benzoxazole group, a benzoisoxazole group, a triazole group, a tetrazole group, an oxadiazole group, a triazine group, a dibenzofuran group, a dibenzothiophene group, a benzocarbazole group, a dibenzocarbazole group, an imidazopyridine group, an imidazopyrimidine group, an azacarbazole group, an azadibenzofuran group, or an azadibenzothiophene group.

**5.** The organometallic compound of any of claims 1-4, wherein $Z_{10}$ in Formula 2 is:
-F; or
a fluorinated $C_1$-$C_{20}$ alkyl group, a fluorinated phenyl group, or a fluorinated biphenyl group, each unsubstituted or substituted with deuterium, a $C_1$-$C_{20}$ alkyl group, a deuterated $C_1$-$C_{20}$ alkyl group, a phenyl group, a deuterated phenyl group, a ($C_1$-$C_{20}$ alkyl) phenyl group, a biphenyl group, a deuterated biphenyl group, a ($C_1$-$C_{20}$ alkyl) biphenyl group, or a combination thereof.

**6.** The organometallic compound of any of claims 1-5, wherein n10 in Formula 2 is an integer from 1 to 5; and/or

wherein the group represented by Formula 2 is a group represented by one of Formula 2-1 to 2-42:

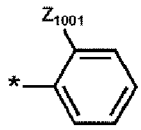
2-1

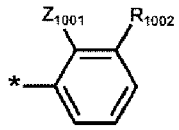
2-2

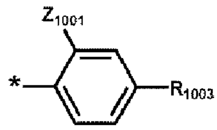
2-3

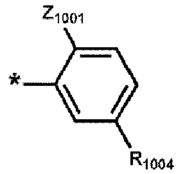
2-4

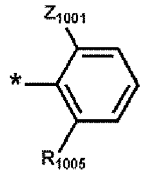
2-5

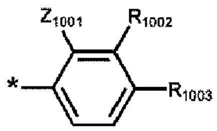
2-6

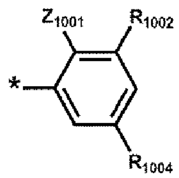
2-7

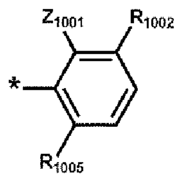
2-8

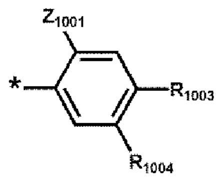
2-9

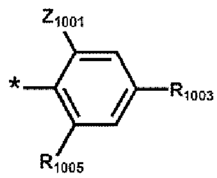
2-10

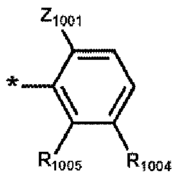
2-11

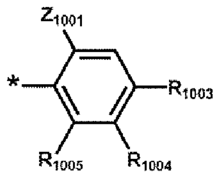
2-12

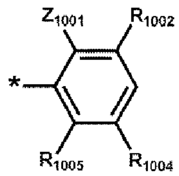
2-13

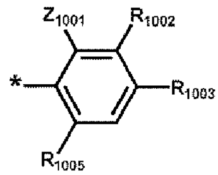
2-14

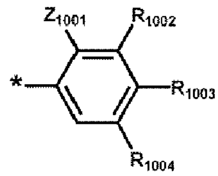
2-15

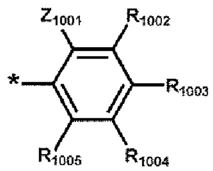
2-16

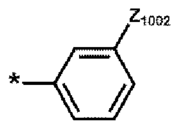
2-17

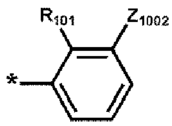
2-18

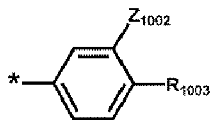
2-19

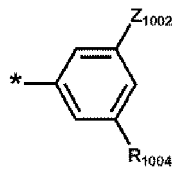
2-20

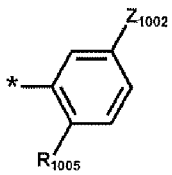
2-21

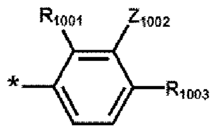
2-22

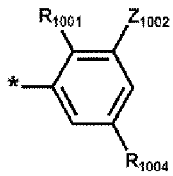
2-23

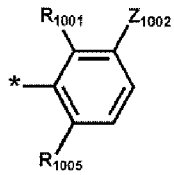
2-24

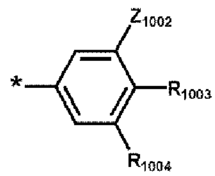
2-25

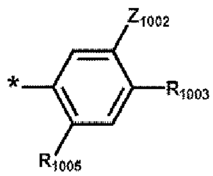
2-26

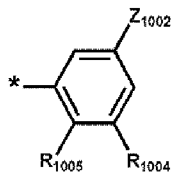
2-27

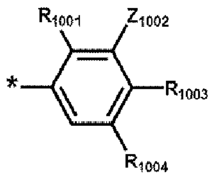
2-28

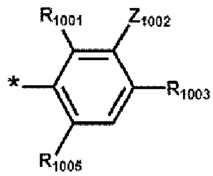
2-29

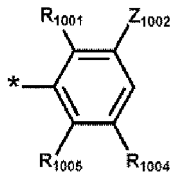
2-30

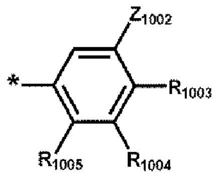
2-31

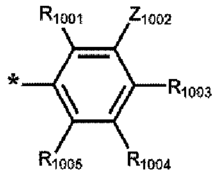
2-32

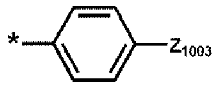
2-33

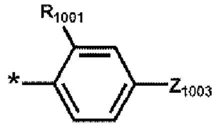
2-34

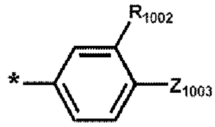
2-35

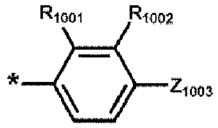
2-36

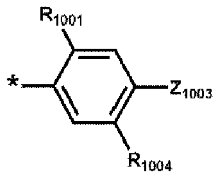
2-37

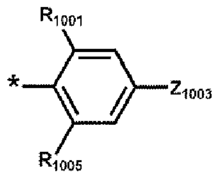
2-38

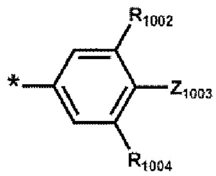
2-39

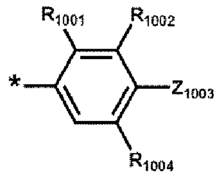
2-40

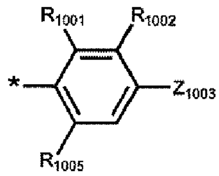
2-41

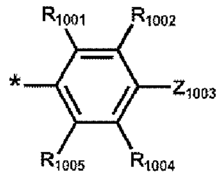
2-42

wherein, in Formula 2-1 to 2-42,
$R_{1001}$ to $R_{1005}$ are each as defined in connection with $R_{10}$ in claim 1, provided that each of $R_{1001}$ to $R_{1005}$ is not hydrogen,
$Z_{1001}$ to $Z_{1003}$ are each as defined in connection with $Z_{10}$ in claim 1, and
* indicates a binding site to a neighboring atom.

**7.** The organometallic compound of any of claims 1-6, wherein the organometallic compound satisfies at least one of Condition 3 or Condition 4:

Condition 3
n13 in Formula 1 is 1 or 2
Condition 4
n14 in Formula 1 is 1 or 2.

**8.** The organometallic compound of any of claims 1-7, wherein the group represented by

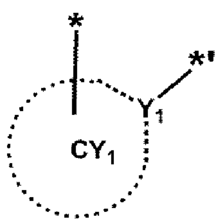

in Formula 1 is a group represented by one of Formulae CY1-1 to CY1-40:

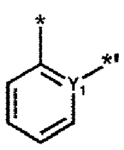
CY1-1

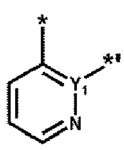
CY1-2

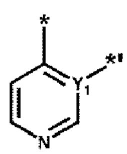
CY1-3

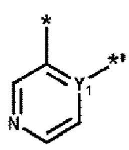
CY1-4

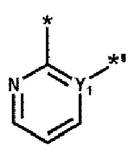
CY1-5

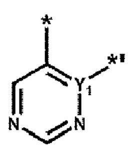
CY1-6

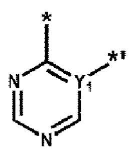
CY1-7

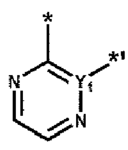
CY1-8

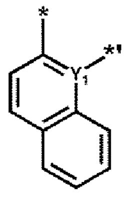
CY1-9

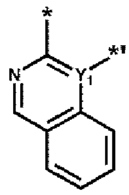
CY1-10

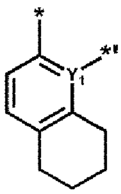
CY1-11

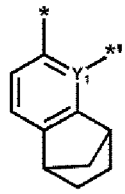
CY1-12

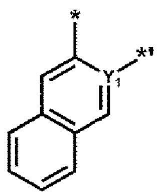
CY1-13

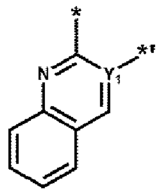
CY1-14

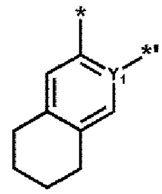
CY1-15

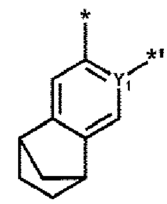
CY1-16

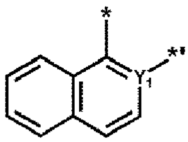
CY1-17

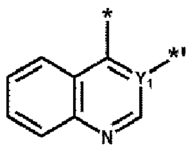
CY1-18

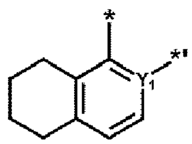
CY1-19

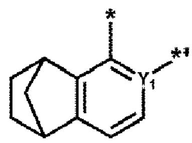
CY1-20

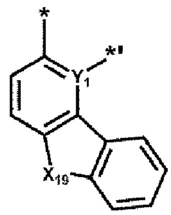
CY1-21

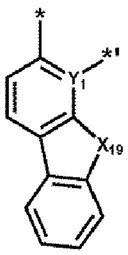
CY1-22

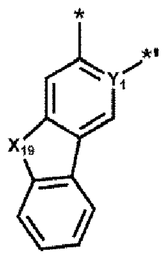
CY1-23

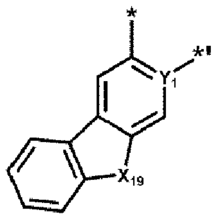
CY1-24

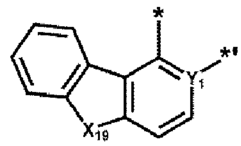
CY1-25

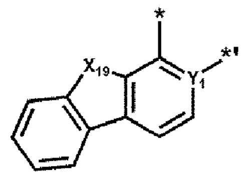
CY1-26

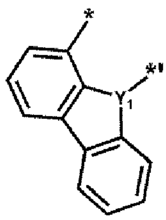
CY1-27

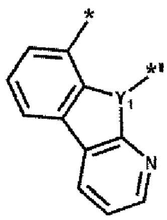
CY1-28

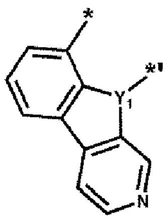
CY1-29

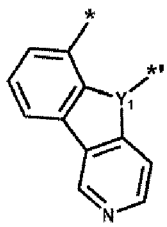
CY1-30

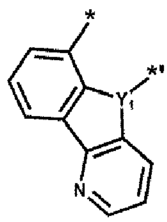
CY1-31

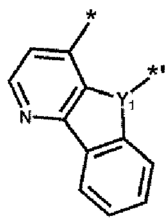
CY1-32

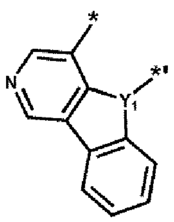
CY1-33

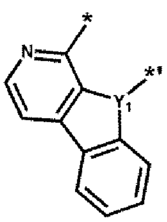
CY1-34

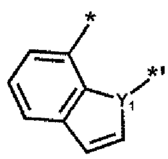
CY1-35

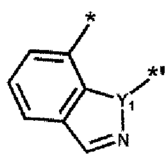
CY1-36

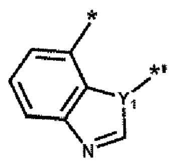
CY1-37

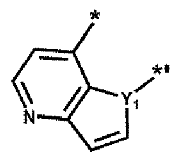
CY1-38

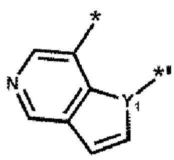
CY1-39

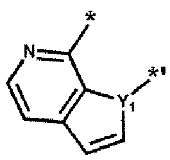
CY1-40

wherein, in Formulae CY1-1 to CY1-40,

$Y_1$ is as defined in claim 1,
$X_{19}$ is $C(R_{19a})(R_{19b})$, $N[(L_{19})_{b19}$-$(R_{19})_{c19}]$, O, S, or $Si(R_{19a})(R_{19b})$,
$L_{19}$ is as defined in connection with $L_1$ in claim 1,
b19 and c19 are each as defined in connection with b1 and c1 in claim 1, respectively,
$R_{19}$, $R_{19a}$, and $R_{19b}$ are each as defined in connection with $R_1$ in claim 1,
*' indicates a binding site to $X_1$ or M in Formula 1, and
* indicates a binding site to ring $CY_5$ in Formula 1; and/or
wherein the group represented by

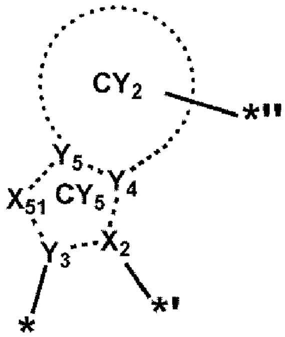

in Formula 1 is a group represented by one of Formulae CY2-1 to CY2-20:

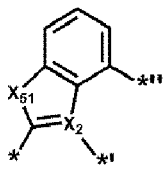
CY2-1

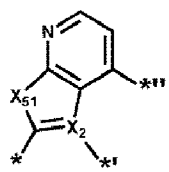
CY2-2

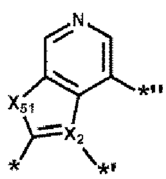
CY2-3

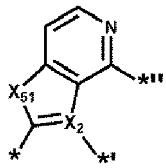
CY2-4

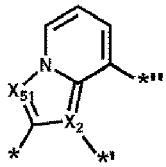
CY2-5

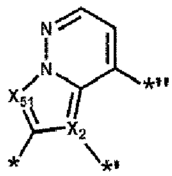
CY2-6

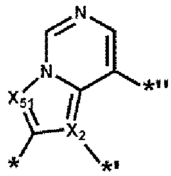
CY2-7

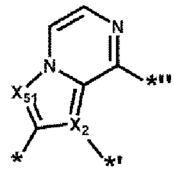
CY2-8

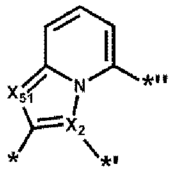
CY2-9

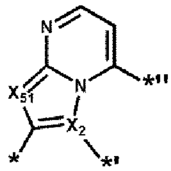
CY2-10

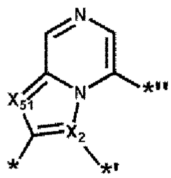
CY2-11

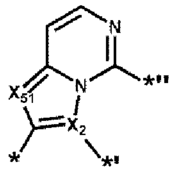
CY2-12

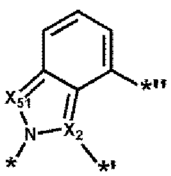
CY2-13

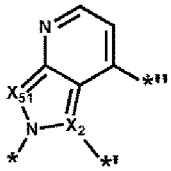
CY2-14

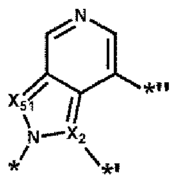
CY2-15

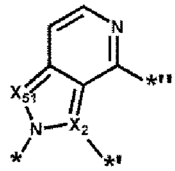
CY2-16

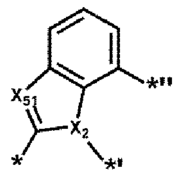
CY2-17

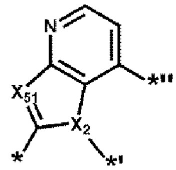
CY2-18

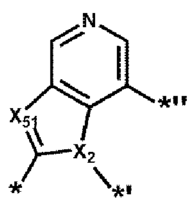
CY2-19

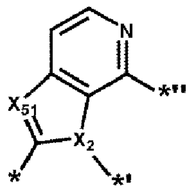
CY2-20

wherein, in Formulae CY2-1 to CY2-20,
$X_2$ and $X_{51}$ are each as defined in claim 1,

* indicates a binding site to ring $CY_1$ in Formula 1,
*' indicates a binding site to M in Formula 1, and
*" indicates a binding site to $T_1$ in Formula 1.

**9.** The organometallic compound of any of claims 1-8, wherein the group represented by

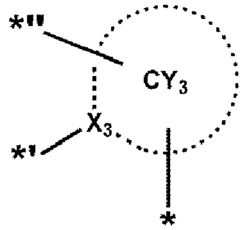

in Formula 1 is a group represented by one of Formulae CY3-1 to CY3-14,

the group represented by

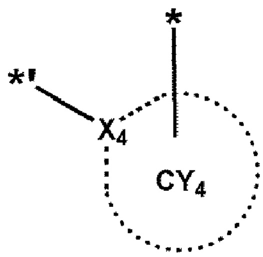

in Formula 1 is a group represented by one of Formulae CY4-1 to CY4-26:

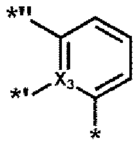
CY3-1

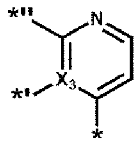
CY3-2

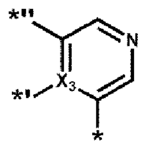
CY3-3

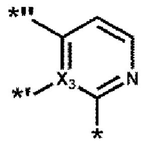
CY3-4

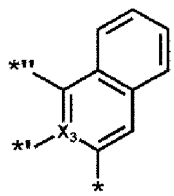
CY3-5

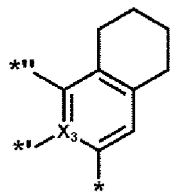
CY3-6

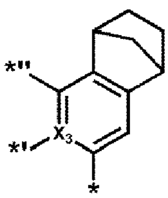
CY3-7

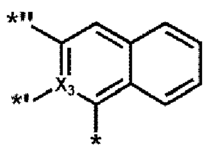
CY3-8

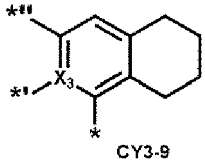
CY3-9

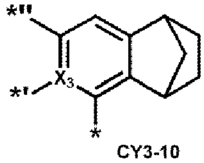
CY3-10

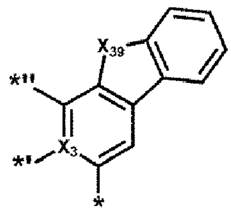
CY3-11

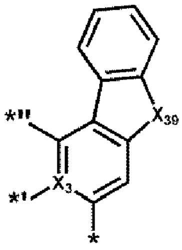
CY3-12

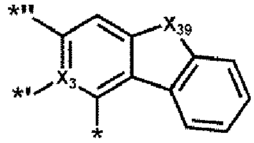
CY3-13

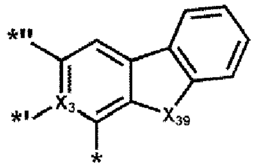
CY3-14

wherein, in Formulae CY3-1 to 3-14,
$X_3$ is as defined in claim 1,
$X_{39}$ is $C(R_{39a})(R_{39b})$, $N[(L_{39})_{b39}-(R_{39})_{c39}]$, O, S, or $Si(R_{39a})(R_{39b})$,
$L_{39}$ is as defined in connection with $L_3$ in claim 1,
b39 and c39 are each as defined in connection with b3 and c3 in claim 1, respectively,
$R_{39}$, $R_{39a}$, and $R_{39b}$ are each as defined in connection with $R_3$ in claim 1,
* indicates a binding site to $T_2$ in Formula 1,
*' indicates a binding site to M in Formula 1, and
*" indicates a binding site to $T_1$ in Formula 1,

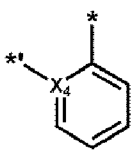
CY4-1

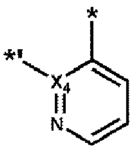
CY4-2

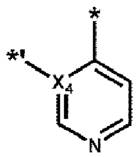
CY4-3

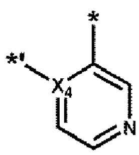
CY4-4

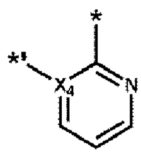
CY4-5

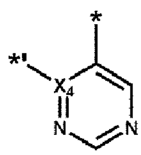
CY4-6

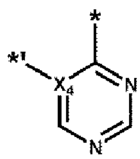
CY4-7

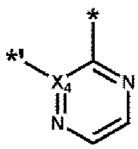
CY4-8

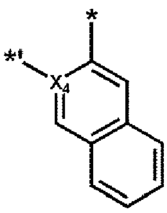
CY4-9

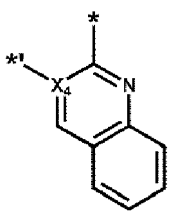
CY4-10

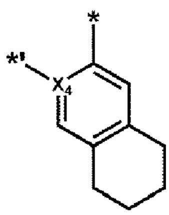
CY4-11

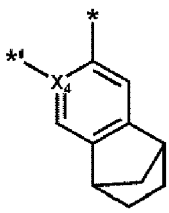
CY4-12

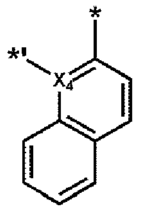
CY4-13

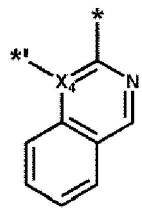
CY4-14

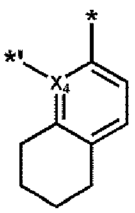
CY4-15

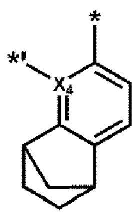
CY4-16

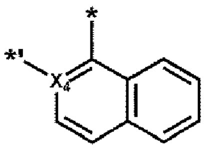
CY4-17

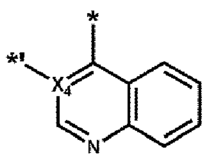
CY4-18

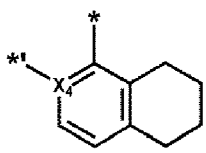
CY4-19

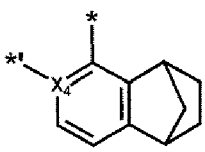
CY4-20

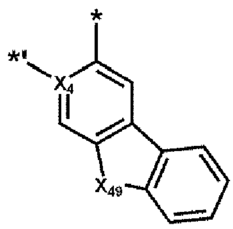
CY4-21

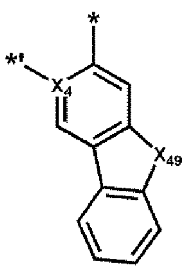
CY4-22

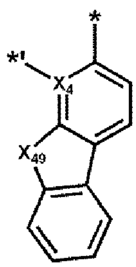
CY4-23

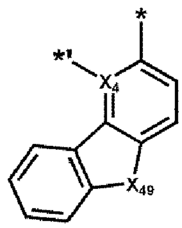
CY4-24

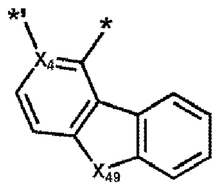

CY4-25

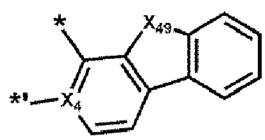

CY4-26

wherein, in Formulae CY4-1 to 4-26,
$X_4$ is as defined in claim 1,
$X_{49}$is $C(R_{49a})(R_{49b})$, $N[(L_{49})_{b49}-(R_{49})_{c49}]$, O, S, or $Si(R_{49a})(R_{49b})$,
$L_{49}$ is as defined in connection with $L_4$ in claim 1,
b49 and c49 are each as defined in connection with b4 and c4 in claim 1, respectively,
$R_{49}$, $R_{49a}$, and $R_{49b}$ are each as defined in connection with $R_4$ in claim 1,
* indicates a binding site to $T_2$ in Formula 1, and
*' indicates a binding site to M in Formula 1.

**10.** The organometallic compound of any of claims 1-9, wherein the group represented by

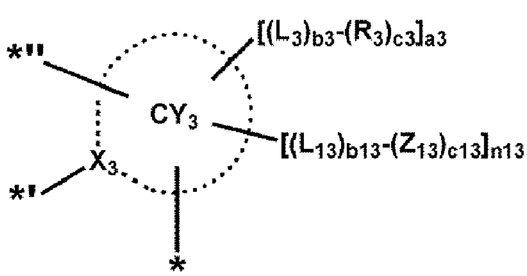

in Formula 1 is a group represented by one of Formulae CY3(1) to CY3(12) or CY3(1)F to CY3(12)F;

the group represented by

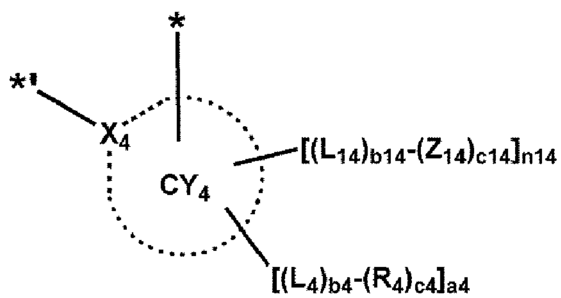

in Formula 1 is a group represented by one of Formulae CY4(1) to CY4(16) or CY4(1)F to CY4(32)F; and at least one of Condition 3-1 to Condition 4-1 is satisfied:

Condition 3-1
the group represented by

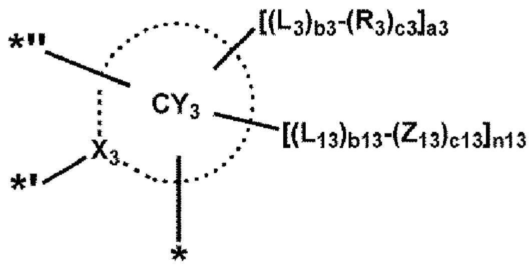

in Formula 1 is a group represented by one of Formulae CY3(1)F to CY3(12)F

Condition 4-1

the group represented by

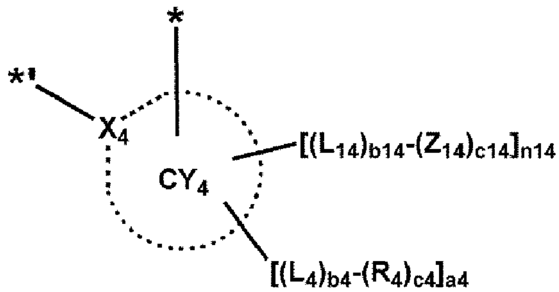

in Formula 1 is a group represented by one of Formulae CY4(1)F to CY4(32)F:

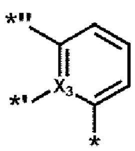
CY3(1)

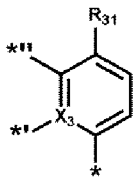
CY3(2)

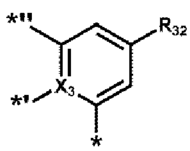
CY3(3)

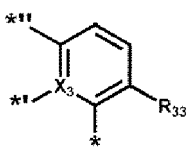
CY3(4)

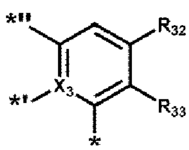
CY3(5)

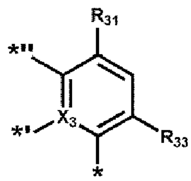
CY3(6)

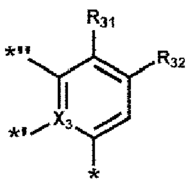
CY3(7)

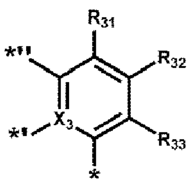
CY3(8)

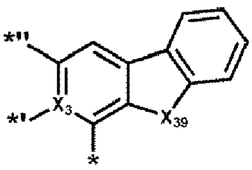
CY3(9)

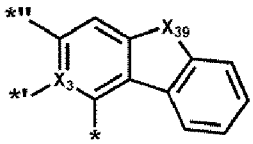
CY3(10)

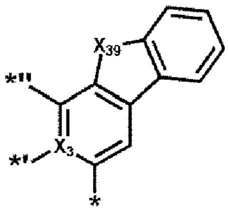
CY3(11)

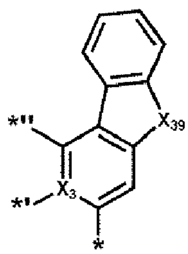
CY3(12)

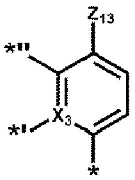 CY3(1)F 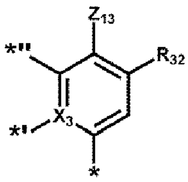 CY3(2)F 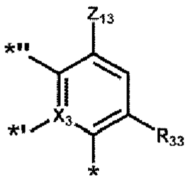 CY3(3)F 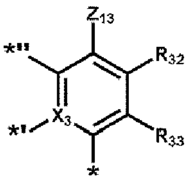 CY3(4)F 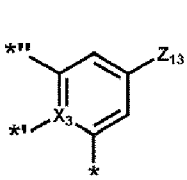 CY3(5)F 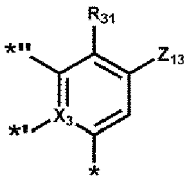 CY3(6)F

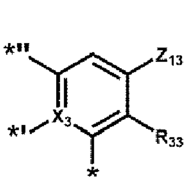 CY3(7)F 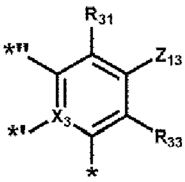 CY3(8)F 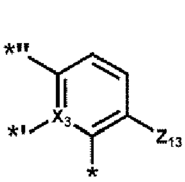 CY3(9)F 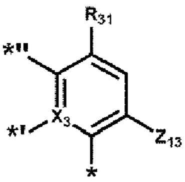 CY3(10)F 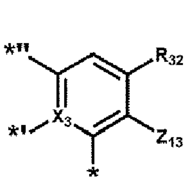 CY3(11)F 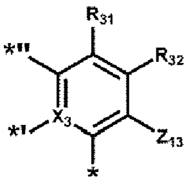 CY3(12)F

wherein, in Formulae CY3(1) to CY3(12) and CY3(1)F to CY3(12)F,

$X_3$ and $Z_{13}$ are each as defined in claim 1,

$R_{31}$ to $R_{33}$ are each as defined in connection with $R_3$ in claim 1, and provided that each of $R_{31}$ to $R_{33}$ is not hydrogen,

$X_{39}$ is $C(R_{39a})(R_{39b})$, $N[(L_{39})_{b39}-(R_{39})_{c39}]$, O, S, or $Si(R_{39a})(R_{39b})$,

$L_{39}$ is as defined in connection with $L_3$ in claim 1,

b39 and c39 are each as defined in connection with b3 and c3 in claim 1, respectively,

$R_{39}$, $R_{39a}$, and $R_{39b}$ are each as defined in connection with $R_3$ in claim 1,

* indicates a binding site to $T_2$ in Formula 1,

*' indicates a binding site to M in Formula 1, and

*" indicates a binding site to $T_1$ in Formula 1,

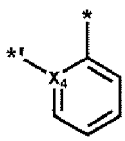 CY4(1) 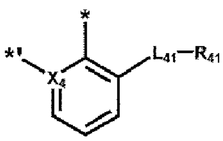 CY4(2) 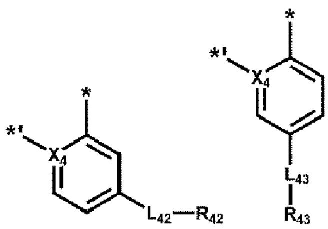 CY4(3) CY4(4) 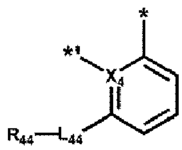 CY4(5) 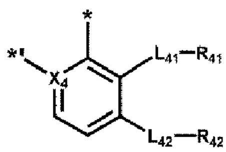 CY4(6)

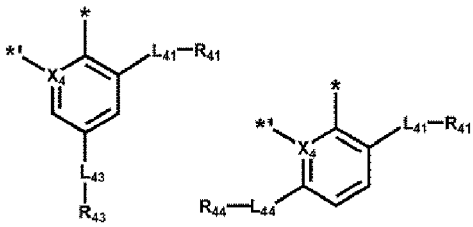 CY4(7) CY4(8) 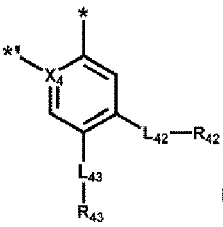 CY4(9) 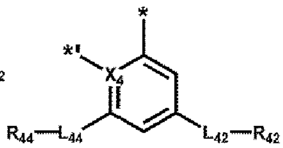 CY4(10) 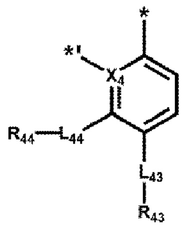 CY4(11)

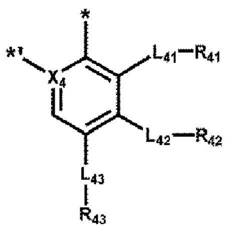 CY4(12) 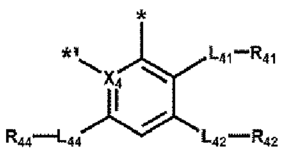 CY4(13) 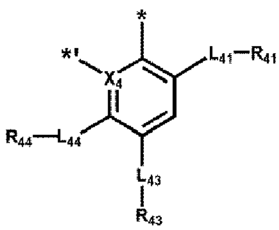 CY4(14) 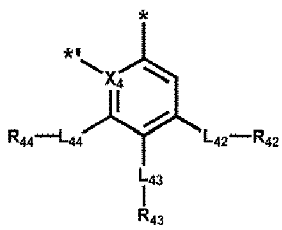 CY4(15)

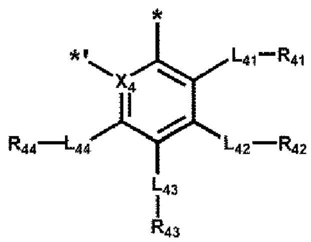

CY4(16)

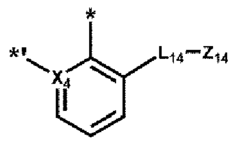

CY4(1)F

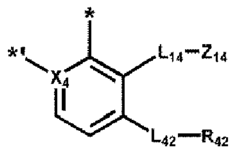

CY4(2)F

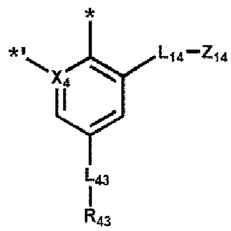

CY4(3)F

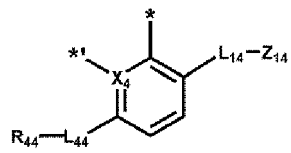

CY4(4)F

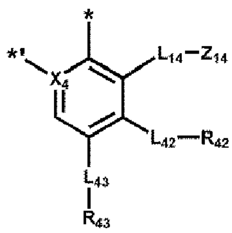

CY4(5)F

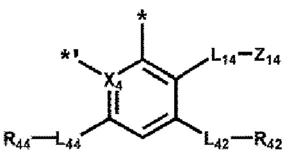

CY4(6)F

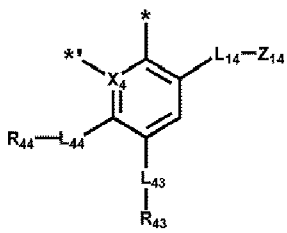

CY4(7)F

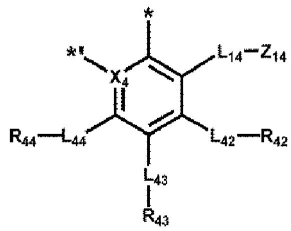

CY4(8)F

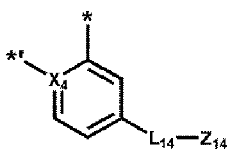

CY4(9)F

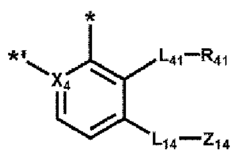

CY4(10)F

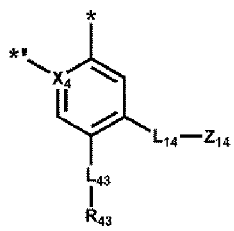

CY4(11)F

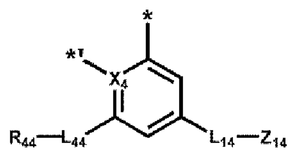

CY4(12)F

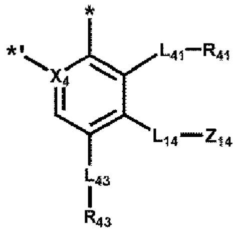

CY4(13)F

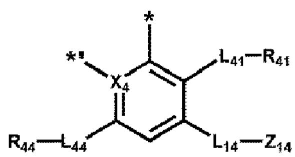

CY4(14)F

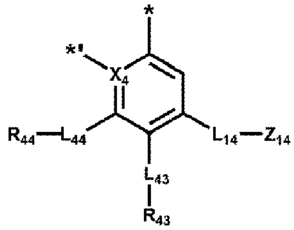

CY4(15)F

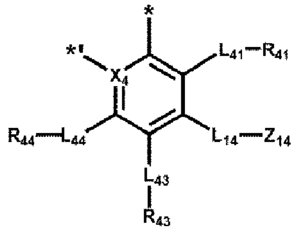

CY4(16)F

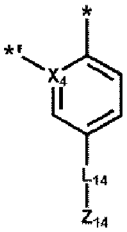
CY4(17)F

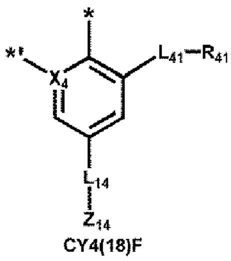
CY4(18)F

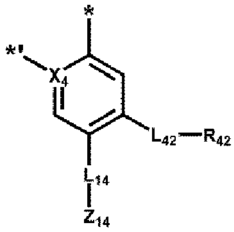
CY4(19)F

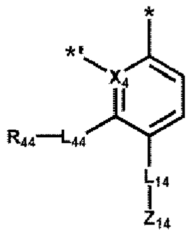
CY4(20)F

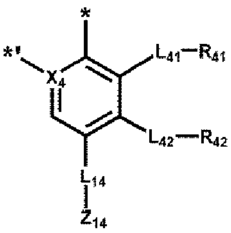
CY4(21)F

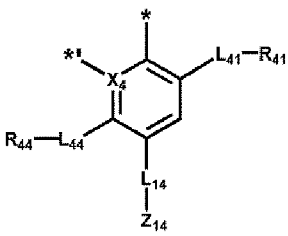
CY4(22)F

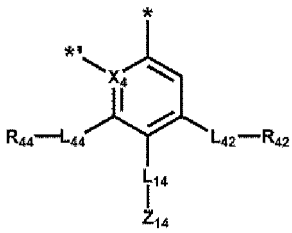
CY4(23)F

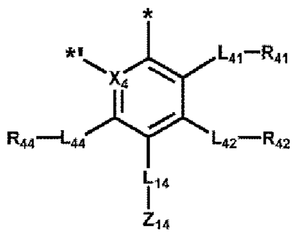
CY4(24)F

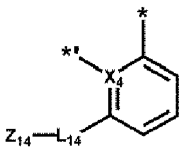
CY4(25)F

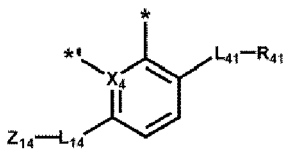
CY4(26)F

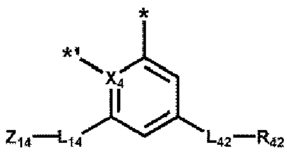
CY4(27)F

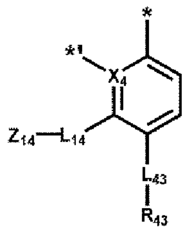
CY4(28)F

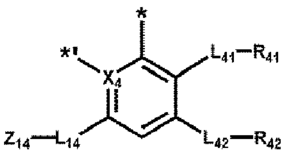
CY4(29)F

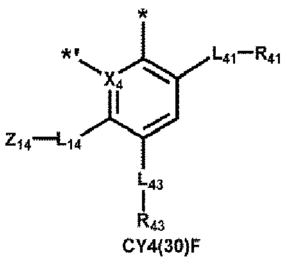
CY4(30)F

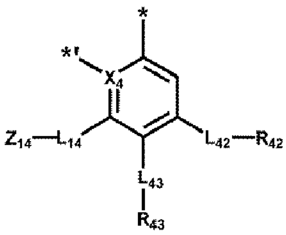
CY4(31)F

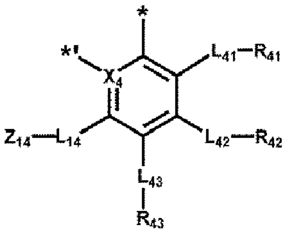
CY4(32)F

wherein, in Formulae CY4(1) to CY4(16) and CY4(1)F to CY4(32)F,
$X_4$, $L_{14}$, and $Z_{14}$ are each as defined in claim 1,
$L_{41}$ to $L_{44}$ are each as defined in connection with $L_4$ in claim 1,
$R_{41}$ to $R_{44}$ are each as defined in connection with $R_4$ in claim 1, and provided that each of $R_{41}$ to $R_{44}$ is not hydrogen,
* indicates a binding site to $T_2$ in Formula 1, and
*' indicates a binding site to M in Formula 1.

**11.** The organometallic compound of any of claims 1-10, wherein the organometallic compound is represented by Formula 1A:

Formula 1A

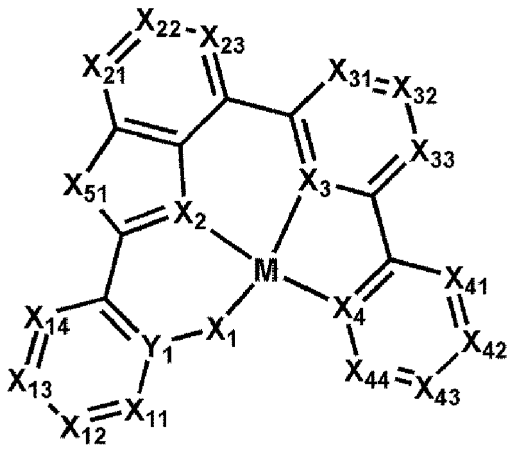

wherein, in Formula 1A,

M, $X_1$ to $X_4$, $Y_1$, and $X_{51}$ are each as defined in claim 1,

$X_{11}$ is $C(R_{11})$ or N; $X_{12}$ is $C(R_{12})$ or N; $X_{13}$ is $C(R_{13})$ or N; $X_{14}$ is $C(R_{14})$ or N; and $R_{11}$ to $R_{14}$ are each as defined in connection with $R_1$ in claim 1,

$X_{21}$ is $C(R_{21})$ or N; $X_{22}$ is $C(R_{22})$ or N; $X_{23}$ is $C(R_{23})$ or N; and $R_{21}$ to $R_{23}$ are each as defined in connection with $R_2$ in claim 1,

$X_{31}$ is $C(R_{31})$, $C(Z_{13})$ or N; $X_{32}$ is $C(R_{32})$, $C(Z_{13})$, or N; $X_{33}$ is $C(R_{33})$, $C(Z_{13})$ or N; $R_{31}$ to $R_{33}$ are each the same as described in connection with $R_3$ in claim 1; and $Z_{13}$ is as defined in claim 1,

$X_{41}$ is $C\text{-}[(L_{41})\text{-}(R_{41})]$, $C\text{-}[(L_{14})\text{-}(Z_{14})]$, or N, $X_{42}$ is $C\text{-}[(L_{42})\text{-}(R_{42})]$, $C\text{-}[(L_{14})\text{-}(Z_{14})]$, or N, $X_{43}$ is $C\text{-}[(L_{43})\text{-}(R_{43})]$, $C\text{-}[(L_{14})\text{-}(Z_{14})]$, or N, $X_{44}$ is $C\text{-}[(L_{44})\text{-}(R_{44})]$, $C\text{-}[(L_{14})\text{-}(Z_{14})]$, or N; $L_{41}$ to $L_{44}$ are each as defined in connection with $L_4$ in claim 1; $R_{41}$ to $R_{44}$ are each as defined in connection with $R_4$ in claim 1; $L_{14}$ and $Z_{14}$ are each as defined in claim 1,

two or more of $R_{11}$ to $R_{14}$ are optionally linked to form a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$,

two or more of $R_{21}$ to $R_{23}$ are optionally linked to form a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$,

two or more of $R_{31}$ to $R_{33}$ are optionally linked to form a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$,

two or more of $R_{41}$ to $R_{44}$ are optionally linked to form a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$,

$R_{10a}$ is as defined in connection with $R_1$ in claim 1, and

at least one of Condition (1) to Condition (7) is satisfied:

Condition (1)
$X_{31}$ is $C(Z_{13})$
Condition (2)
$X_{32}$ is $C(Z_{13})$
Condition (3)
$X_{33}$ is $C(Z_{13})$
Condition (4)
$X_{41}$ is $C\text{-}[(L_{14})\text{-}(Z_{14})]$
Condition (5)
$X_{42}$ is $C\text{-}[(L_{14})\text{-}(Z_{14})]$
Condition (6)
$X_{43}$ is $C\text{-}[(L_{14})\text{-}(Z_{14})]$
Condition (7)
$X_{44}$ is $C\text{-}[(L_{14})\text{-}(Z_{14})]$.

**12.** The organometallic compound of claim 11, wherein the organometallic compound satisfies at least one of Condition (1) to Condition (3); and/or

wherein the organometallic compound satisfies at least one of Condition (4) to Condition (7).

**13.** An organic light-emitting device, comprising:

a first electrode;
a second electrode; and
an organic layer located between the first electrode and the second electrode;
wherein the organic layer comprises an emission layer, and
wherein the organic layer comprises at least one organometallic compound of any of claims 1-12;
preferably wherein
the first electrode is an anode,
the second electrode is a cathode,
the organic layer further comprises a hole transport region located between the first electrode and the emission layer and an electron transport region located between the emission layer and the second electrode,
the hole transport region comprises a hole injection layer, a hole transport layer, an electron blocking layer, a buffer layer, or a combination thereof, and
the electron transport region comprises a hole blocking layer, an electron transport layer, an electron injection layer, or a combination thereof.

**14.** The organic light-emitting device of claim 13, wherein the emission layer comprises the at least one organometallic compound;

preferably wherein
the emission layer further comprises a host, and
an amount of the host in the emission layer is greater than an amount of the at least one organometallic compound in the emission layer.

**15.** An electronic apparatus, comprising the organic light-emitting device of claims 13 or 14.

# FIGURE

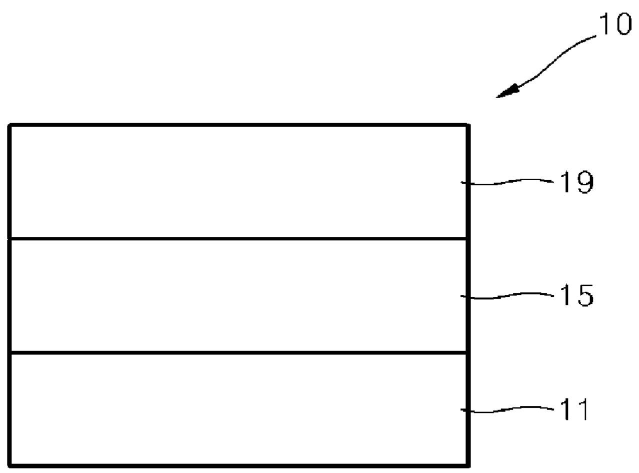

Europäisches Patentamt
European Patent Office
Office européen des brevets

# EUROPEAN SEARCH REPORT

Application Number
EP 22 15 0507

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2018/254418 A1 (YOON SEONGJUN [KR] ET AL) 6 September 2018 (2018-09-06)<br>* compounds 1-217 to 1-225 *<br>* abstract *<br>----- | 1-15 | INV.<br>C07F15/00<br>C09K11/00<br>H01L51/50 |
| X | EP 3 508 491 A1 (SAMSUNG ELECTRONICS CO LTD [KR]) 10 July 2019 (2019-07-10)<br>* claims 12-15 *<br>* compounds 105,107 *<br>----- | 1-15 | |

TECHNICAL FIELDS SEARCHED (IPC)

C07F
H05B
C09K
H01L

The present search report has been drawn up for all claims

1

| Place of search | Date of completion of the search | Examiner |
|---|---|---|
| The Hague | 17 May 2022 | Eberhard, Michael |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

# ANNEX TO THE EUROPEAN SEARCH REPORT ON EUROPEAN PATENT APPLICATION NO. EP 22 15 0507

This annex lists the patent family members relating to the patent documents cited in the above-mentioned European search report. The members are as contained in the European Patent Office EDP file on
The European Patent Office is in no way liable for these particulars which are merely given for the purpose of information.

17-05-2022

| Patent document cited in search report | Publication date | Patent family member(s) | Publication date |
|---|---|---|---|
| US 2018254418 A1 | 06-09-2018 | KR 20180100898 A | 12-09-2018 |
| | | US 2018254418 A1 | 06-09-2018 |
| EP 3508491 A1 | 10-07-2019 | CN 110003281 A | 12-07-2019 |
| | | EP 3508491 A1 | 10-07-2019 |
| | | US 2019211042 A1 | 11-07-2019 |

EPO FORM P0459

For more details about this annex : see Official Journal of the European Patent Office, No. 12/82